# EUROPEAN PATENT SPECIFICATION

(11) **EP 4 124 643 B1**
(45) Date of publication and mention of the grant of the patent: **16.04.2025**
(21) Application number: 22187183.3
(22) Date of filing: 27.07.2022
(51) Int. Cl.: C09K 11/06, C07F 15/00

(54) **ORGANOMETALLIC COMPOUND AND ORGANIC LIGHT-EMITTING DIODE INCLUDING THE SAME**
ORGANOMETALLISCHE VERBINDUNG UND ORGANISCHE LICHTEMITTIERENDE DIODE DAMIT
COMPOSÉ ORGANOMÉTALLIQUE ET DIODE ÉLECTROLUMINESCENTE ORGANIQUE L'INCLUANT

(30) Priority: 29.07.2021 KR 20210099888
(43) Date of publication of application: 01.02.2023
(73) Proprietor: LG Display Co., Ltd., SEOUL, 07336 (KR); Rohm And Haas Electronic Materials Korea Ltd., Cheonan-si, Chungcheongnam-do 31093 (KR)
(72) Inventor: CHOUNG, Kusun, 18449 Gyeonggi-do (KR); PARK, Hansol, 18449 Gyeonggi-do (KR); JEONG, Yoojeong, 18449 Gyeonggi-do (KR); PARK, Kyoung-Jin, 18449 Gyeonggi-do (KR); KIM, Hyun, 18449 Gyeonggi-do (KR); HONG, Jin Ri, 18449 Gyeonggi-do (KR); LEE, Yeon Gun, 18449 Gyeonggi-do (KR)
(74) Representative: Ter Meer Steinmeister & Partner

(56) References cited:
- US-A1- 2009 018 330
- US-A1- 2020 136 064
- US-A1- 2021 040 129

## Description

### BACKGROUND

### Technical Field

The present disclosure relates to an organometallic compound, and more particularly, to an organometallic compound having phosphorescent properties and an organic light-emitting diode including the same.

### Discussion of the Related Art

As a display device is applied to various fields, interest with the display device is increasing. One of the display devices is an organic light-emitting display device including an organic light-emitting diode (OLED) which is rapidly developing.

In the organic light-emitting diode, when electric charges are injected into a light-emitting layer formed between a positive electrode and a negative electrode, an electron and a hole are recombined with each other in the light-emitting layer to form an exciton and thus energy of the exciton is converted to light. Thus, the organic light-emitting diode emits the light. Compared to conventional display devices, the organic light-emitting diode may operate at a low voltage, consume relatively little power, render excellent colors, and may be used in a variety of ways because a flexible substrate may be applied thereto. Further, a size of the organic light-emitting diode may be freely adjustable.

US 2021/040129 A1 is directed to organometallic compounds and formulations and their various uses including as emitters in devices such as organic light emitting diodes. US 2009/018330 A1 refers to a process for preparing cyclometallated transition metal-carbene complexes comprising at least one carbene ligand.

### SUMMARY

The organic light-emitting diode (OLED) has superior viewing angle and contrast ratio compared to a liquid crystal display (LCD), and is lightweight and is ultra-thin because the OLED does not require a backlight. The organic light-emitting diode includes a plurality of organic layers between a negative electrode (electron injection electrode; cathode) and a positive electrode (hole injection electrode; anode). The plurality of organic layers may include a hole injection layer, a hole transport layer, a hole transport auxiliary layer, an electron blocking layer, and a light-emitting layer, an electron transport layer, etc.

In this organic light-emitting diode structure, when a voltage is applied across the two electrodes, electrons and holes are injected from the negative and positive electrodes, respectively, into the light-emitting layer and thus excitons are generated in the light-emitting layer and then fall to a ground state to emit light.

Organic materials used in the organic light-emitting diode may be largely classified into light-emitting materials and charge-transporting materials. The light-emitting material is an important factor determining luminous efficiency of the organic light-emitting diode. The luminescent material must have high quantum efficiency, excellent electron and hole mobility, and must exist uniformly and stably in the light-emitting layer. The light-emitting materials may be classified into light-emitting materials emitting light of blue, red, and green colors based on colors of the light. A color-generating material may include a host and dopants to increase the color purity and luminous efficiency through energy transfer.

In recent years, there is a trend to use phosphorescent materials rather than fluorescent materials for the light-emitting layer. When the fluorescent material is used, singlets as about 25% of excitons generated in the light-emitting layer are used to emit light, while most of triplets as 75% of the excitons generated in the light-emitting layer are dissipated as heat. However, when the phosphorescent material is used, singlets and triplets are used to emit light.

In the related art, an organometallic compound is used as the phosphorescent material used in the organic light-emitting diode. Research and development of the phosphorescent material to solve low efficiency and lifetime problems are continuously required.

Accordingly, embodiments of the present disclosure are directed to an organometallic compound and an organic light-emitting diode including the same that substantially obviate one or more of the problems due to limitations and disadvantages of the related art.

Accordingly, an aspect of the present invention is to provide an organometallic compound capable of lowering operation voltage, and improving efficiency, and lifespan, and an organic light-emitting diode including an organic light-emitting layer containing the same.

Additional features and aspects will be set forth in the description that follows, and in part will be apparent from the description, or may be learned by practice of the inventive concepts provided herein. Other features and aspects of the inventive concepts may be realized and attained by the structure particularly pointed out in the written description, or derivable therefrom, and the claims hereof as well as the appended drawings.

To achieve these and other aspects of the inventive concepts, as embodied and broadly described herein, the present disclosure provides an organometallic compound having a novel structure represented by a following Chemical Formula 1, and an organic light-emitting diode in which a light-emitting layer contains the same as dopants thereof:

[Chemical Formula 1] Ir(L_{A})ₘ(L_{B})ₙ

where in the Chemical Formula 1, L_{A} represents a main ligand, and is one selected from a group consisting of following Chemical Formula 2-1, Chemical Formula 2-2, and Chemical Formula 2-3,
L_{B} denotes an ancillary ligand represented by a following Chemical Formula 3,
each of m and n denotes a number of the ligands bound to Ir (iridium), and m is 1, 2 or 3, and n is 0, 1 or 2, and a sum of m and n is 3, 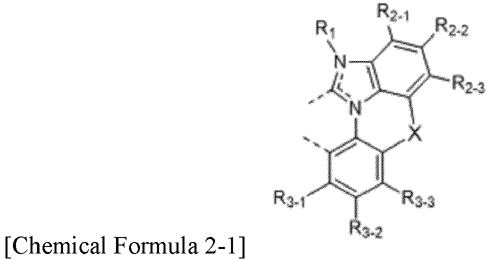 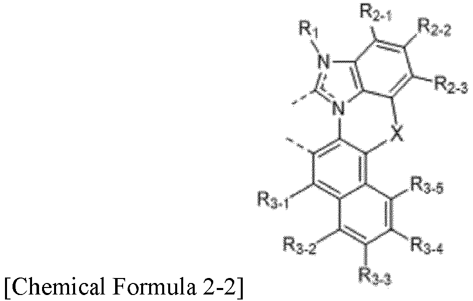 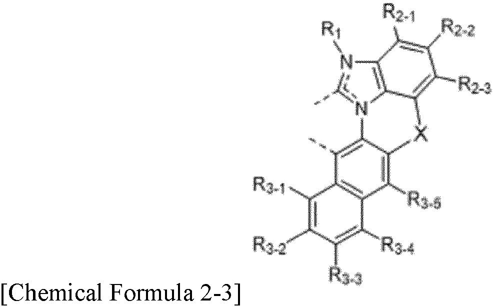 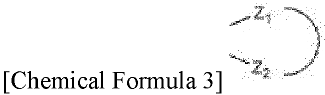
wherein in each of the Chemical Formulas 2-1 to 2-3, X independently represents one selected from a group consisting of oxygen, sulfur, C(R)₂ and NR,
each of R, R₁, R₂₋₁, R₂₋₂, R₂₋₃, R₃₋₁, R₃₋₂, R₃₋₃, R₃₋₄ and R₃₋₅ independently represents one selected from a group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, and phosphino,
in each of the Chemical Formulas 2-1 to 2-3, two functional groups adjacent to each other among R₂₋₁, R₂₋₂ and R₂₋₃ may be combined with each other to form a ring structure, and two functional groups adjacent to each other among R₃₋₁, R₃₋₂, R₃₋₃, R₃₋₄ and R₃₋₅ may be combined with each other to form a ring structure,
wherein the ancillary ligand represented by the Chemical Formula 3 is a bidentate ligand, and the bidentate ligand is represented by a following Chemical Formula 4 or a following Chemical Formula 5: 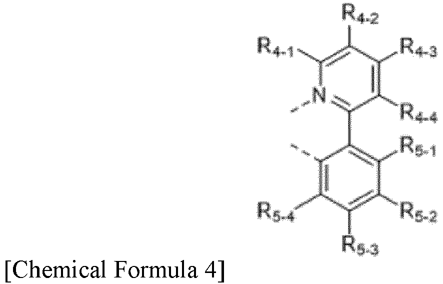 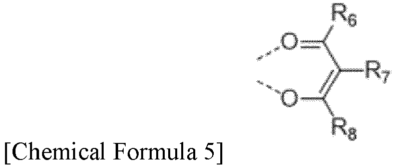
wherein in the Chemical Formula 4, each of R₄₋₁, R₄₋₂, R₄₋₃, R₄₋₄, R₅₋₁, R₅₋₂, R₅₋₃ and R₅₋₄ independently represents one selected from a group consisting of hydrogen, deuterium, a C1 to C5 linear alkyl group, and C1 to C5 branched alkyl group, wherein the C1 to C5 linear alkyl group or the C1 to C5 branched alkyl group may be substituted with at least one selected from deuterium and a halogen element,
two functional groups adjacent to each other among R₄₋₁, R₄₋₂, R₄₋₃ and R₄₋₄ may be combined with each other to form a ring structure, and two functional groups adjacent to each other among R₅₋₁, R₅₋₂, R₅₋₃ and R₅₋₄ may be combined with each other to form a ring structure,
wherein in the Chemical Formula 5, each of R₆, R₇ and R₈ independently represents one selected from a group consisting of hydrogen, deuterium, C1 to C5 linear alkyl group and C1 to C5 branched alkyl group, wherein the C1 to C5 linear alkyl group or the C1 to C5 branched alkyl group may be substituted with at least one selected from deuterium and a halogen element,
two functional groups adjacent to each other among R₆, R₇ and R₈ may combine with each other to form a ring structure, wherein the compound represented by the Chemical Formula 1 includes one selected from a group consisting of compounds 1 to 370 defined below.

The organometallic compound according to the present disclosure may be used as the dopant of the light-emitting layer of the organic light-emitting diode, such that the operation voltage of the organic light-emitting diode may be lowered and the efficiency and lifespan characteristics of the organic light-emitting diode may be improved.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain various principles.
FIG. 1 is a cross-sectional view schematically showing an organic light-emitting diode in which a light-emitting layer contains an organometallic compound according to an illustrative embodiment of the present disclosure.
FIG. 2 is a cross-sectional view schematically illustrating an organic light-emitting diode having a tandem structure having two light-emitting stacks and containing an organometallic compound represented by the Chemical Formula 1 according to an illustrative embodiment of the present disclosure.
FIG. 3 is a cross-sectional view schematically illustrating an organic light-emitting diode having a tandem structure having three light-emitting stacks and containing an organometallic compound represented by the Chemical Formula 1 according to an illustrative embodiment of the present disclosure.
FIG. 4 is a cross-sectional view schematically illustrating an organic light-emitting display device including an organic light-emitting diode according to an illustrative embodiment of the present disclosure.

### DETAILED DESCRIPTION

Advantages and features of the present disclosure, and a method of achieving the advantages and features will become apparent with reference to embodiments described later in detail together with the accompanying drawings. However, the present disclosure is not limited to the embodiments as disclosed below, but may be implemented in various different forms. Thus, these embodiments are set forth only to make the present disclosure complete, and to completely inform the scope of the present disclosure to those of ordinary skill in the technical field to which the present disclosure belongs, and the present disclosure is only defined by the scope of the claims.

A shape, a size, a ratio, an angle, a number, etc. disclosed in the drawings for describing the embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is no separate explicit description thereof.

It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

The features of the various embodiments of the present disclosure may be partially or entirely combined with each other, and may be technically associated with each other or operate with each other. The embodiments may be implemented independently of each other and may be implemented together in an association relationship.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

An organometallic compound according to some embodiments of the present disclosure may be represented by a following Chemical Formula 1. When the organometallic compound is used as a dopant of a light emission layer of an organic light-emitting diode, luminous efficiency and lifetime of the diode may be improved:

[Chemical Formula 1] Ir(L_{A})ₘ(L_{B})ₙ

where in the Chemical Formula 1, L_{A} represents a main ligand, and is one selected from a group consisting of following Chemical Formula 2-1, Chemical Formula 2-2, and Chemical Formula 2-3,
L_{B} denotes an ancillary ligand represented by a following Chemical Formula 3,
each of m and n denotes a number of the ligands bound to Ir (iridium), and m is 1, 2 or 3, and n is 0, 1 or 2, and a sum of m and n is 3, 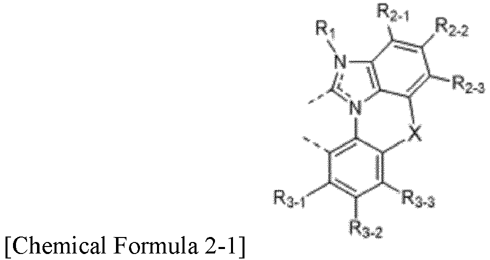 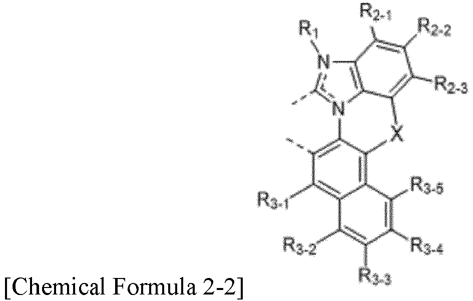 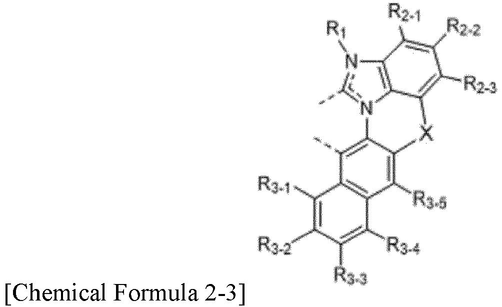 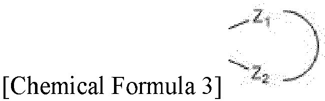
wherein in each of the Chemical Formulas 2-1 to 2-3, X independently represents one selected from a group consisting of oxygen, sulfur, C(R)₂ and NR,
each of R, R₁, R₂₋₁, R₂₋₂, R₂₋₃, R₃₋₁, R₃₋₂, R₃₋₃, R₃₋₄ and R₃₋₅ independently represents one selected from a group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, and phosphino,
in each of the Chemical Formulas 2-1 to 2-3, two functional groups adjacent to each other among R₂₋₁, R₂₋₂ and R₂₋₃ may be combined with each other to form a ring structure, and two functional groups adjacent to each other among R₃₋₁, R₃₋₂, R₃₋₃, R₃₋₄ and R₃₋₅ may be combined with each other to form a ring structure,
wherein the ancillary ligand represented by the Chemical Formula 3 is a bidentate ligand, and the bidentate ligand is represented by a following Chemical Formula 4 or a following Chemical Formula 5: 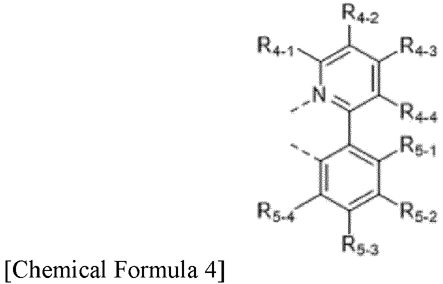 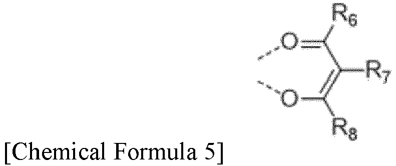
wherein in the Chemical Formula 4, each of R₄₋₁, R₄₋₂, R₄₋₃, R₄₋₄, R₅₋₁, R₅₋₂, R₅₋₃ and R₅₋₄ independently represents one selected from a group consisting of hydrogen, deuterium, a C1 to C5 linear alkyl group, and C1 to C5 branched alkyl group, wherein the C1 to C5 linear alkyl group or the C1 to C5 branched alkyl group may be substituted with at least one selected from deuterium and a halogen element,
two functional groups adjacent to each other among R₄₋₁, R₄₋₂, R₄₋₃ and R₄₋₄ may be combined with each other to form a ring structure, and two functional groups adjacent to each other among R₅₋₁, R₅₋₂, R₅₋₃ and R₅₋₄ may be combined with each other to form a ring structure,
wherein in the Chemical Formula 5, each of R₆, R₇ and R₈ independently represents one selected from a group consisting of hydrogen, deuterium, C1 to C5 linear alkyl group and C1 to C5 branched alkyl group, wherein the C1 to C5 linear alkyl group or the C1 to C5 branched alkyl group may be substituted with at least one selected from deuterium and a halogen element,
two functional groups adjacent to each other among R₆, R₇ and R₈ may combine with each other to form a ring structure.

As described above, the ancillary ligand bound to iridium (Ir) as a central coordination metal may be the bidentate ligand. The bidentate ligand may contain an electron donor, thereby increasing an amount of MLCT (metal to ligand charge transfer), thereby allowing the organic light-emitting diode to exhibit improved luminous properties such as high luminous efficiency and high external quantum efficiency.

The compound represented by the Chemical Formula 1 of the present disclosure includes one selected from a group consisting of following compounds 1 to 370:

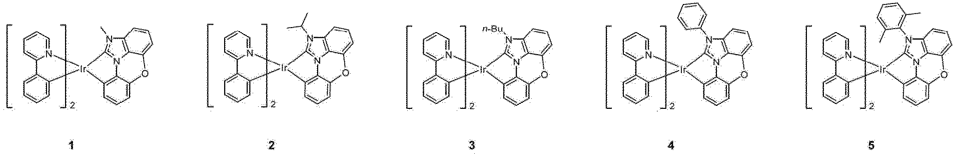

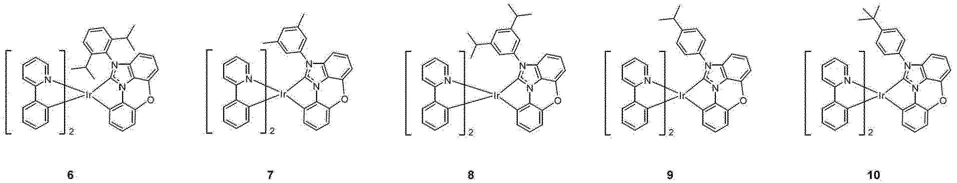

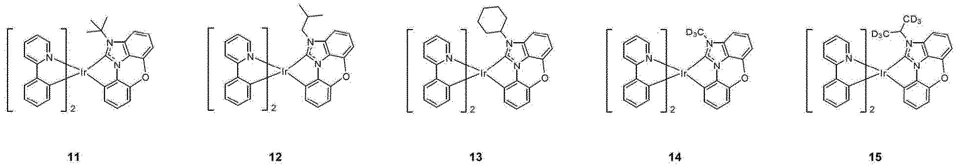

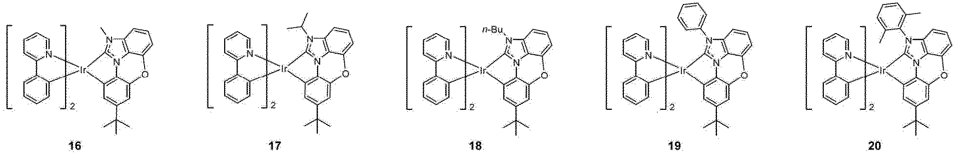

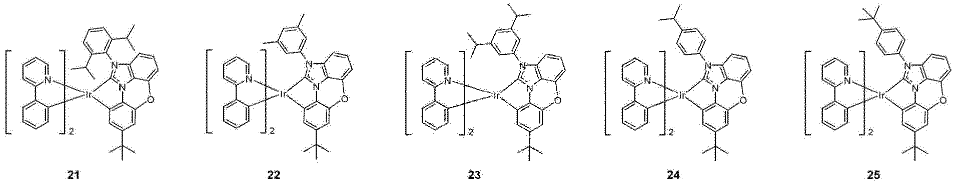

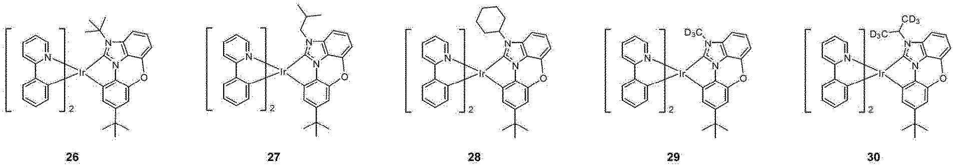

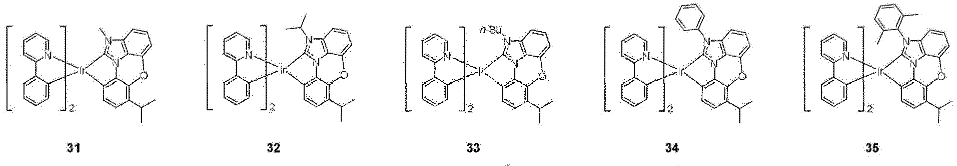

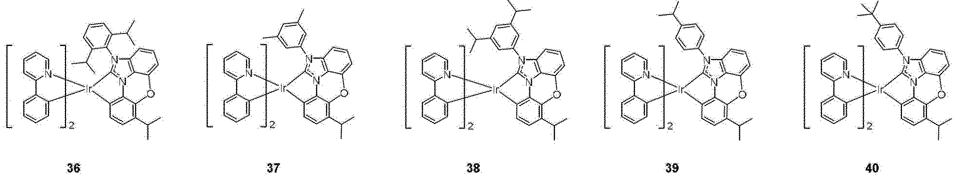

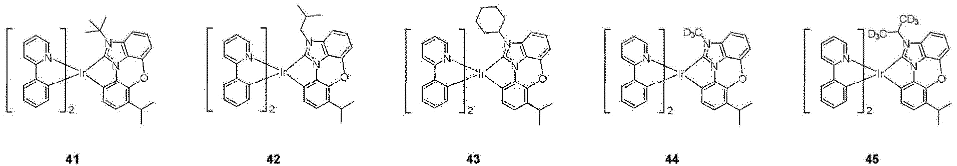

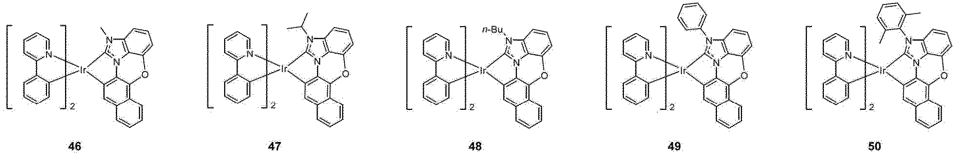

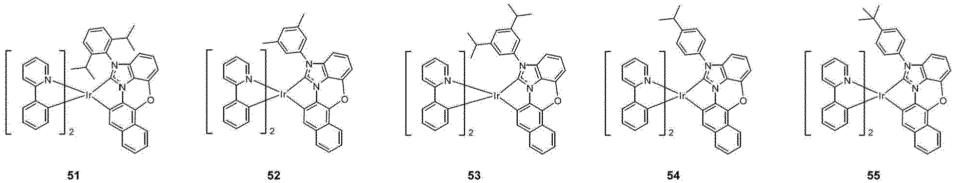

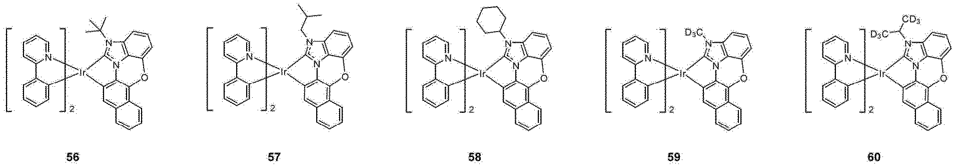

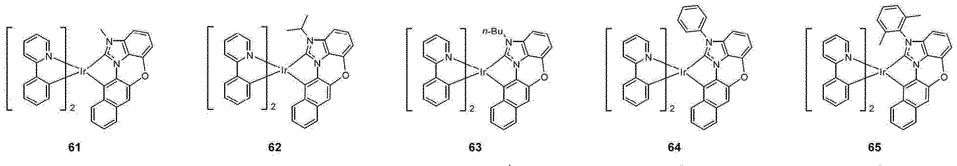

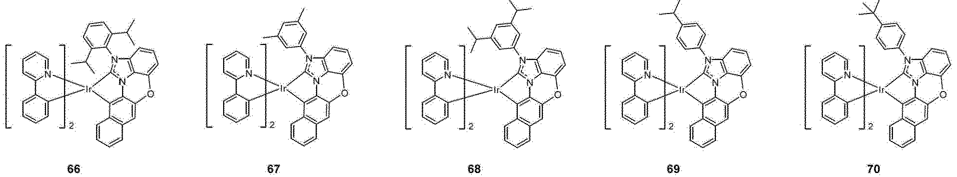

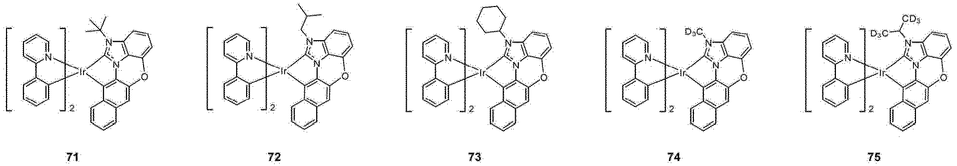

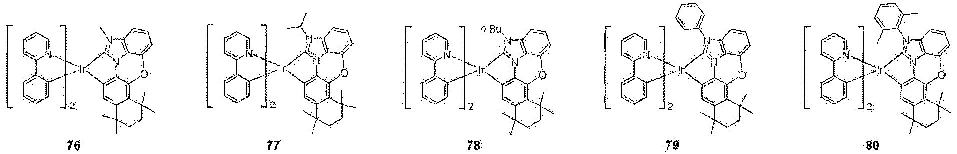

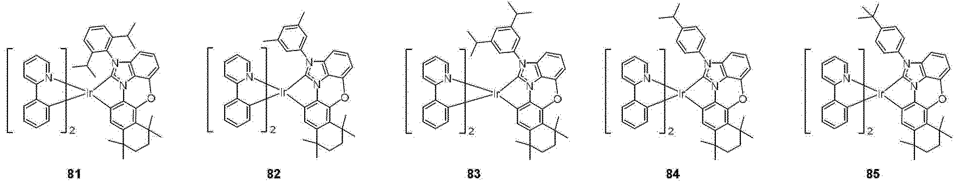

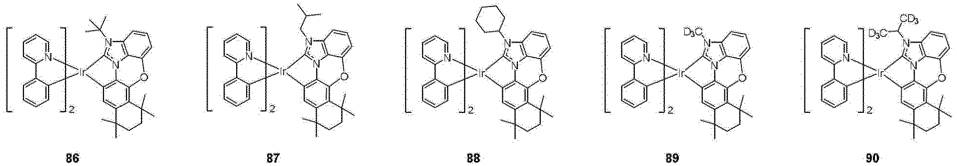

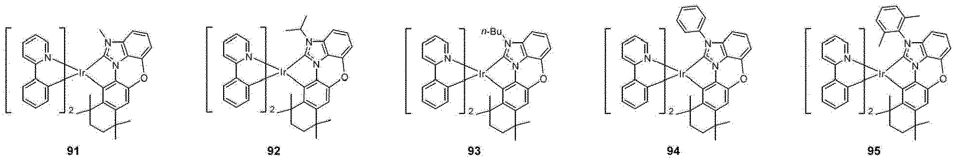

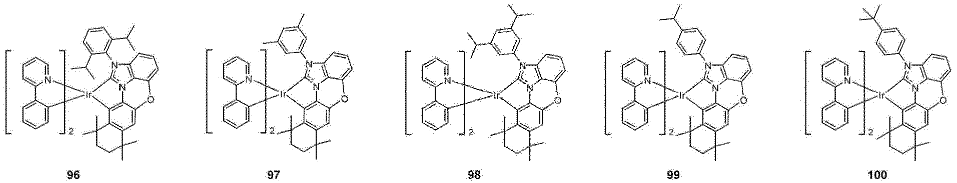

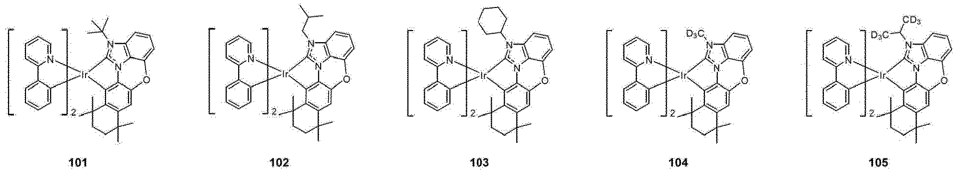

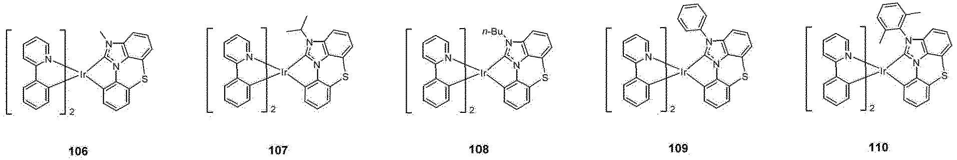

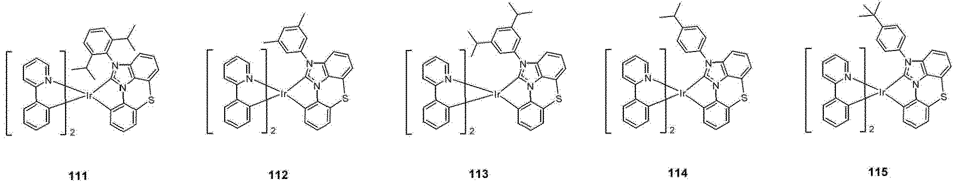

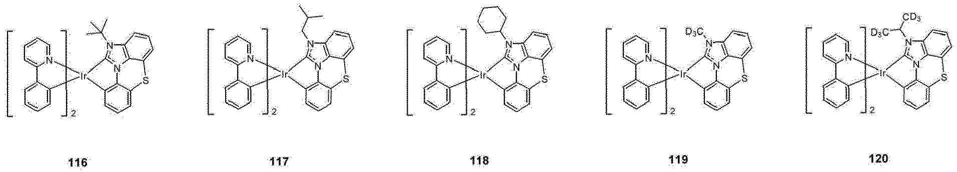

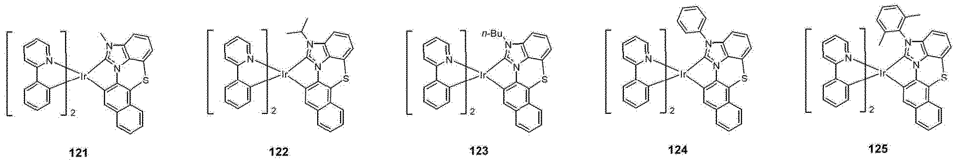

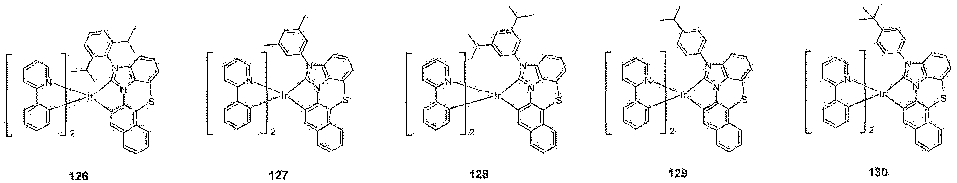

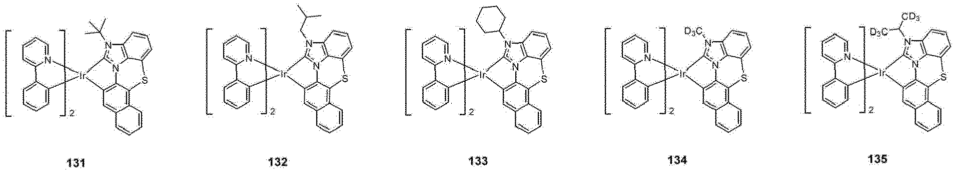

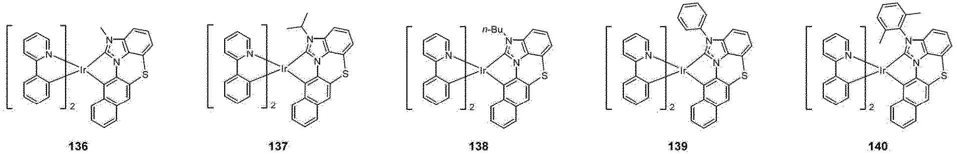

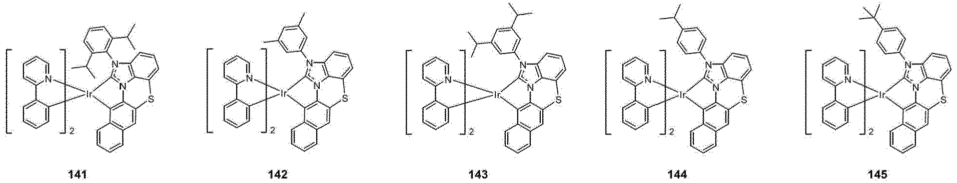

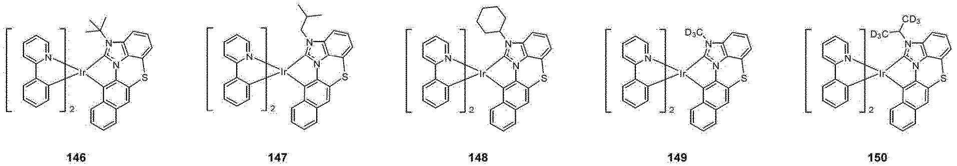

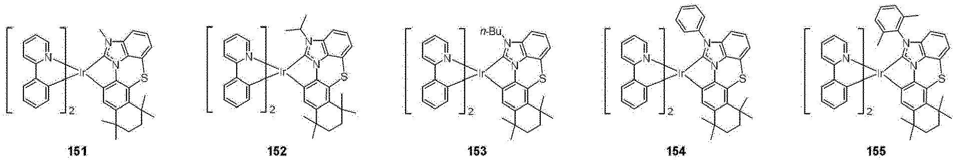

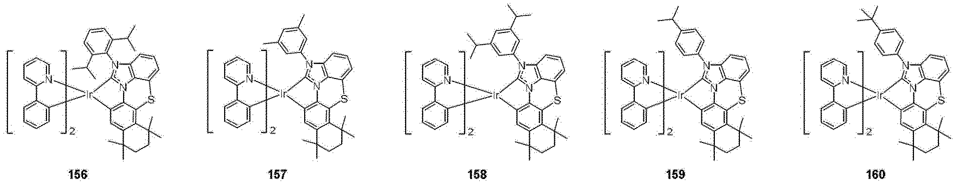

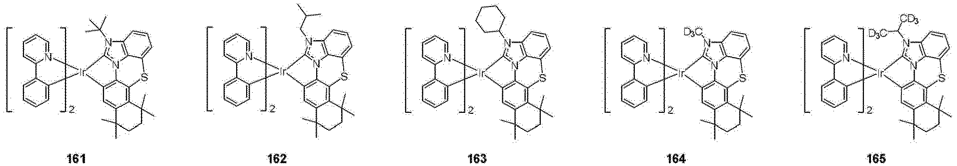

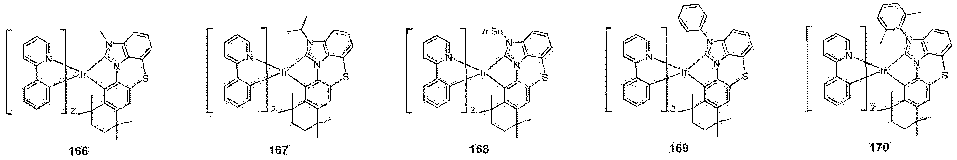

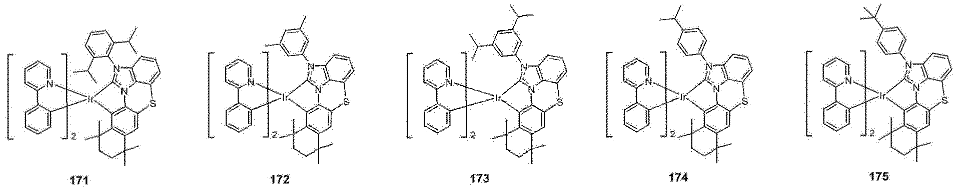

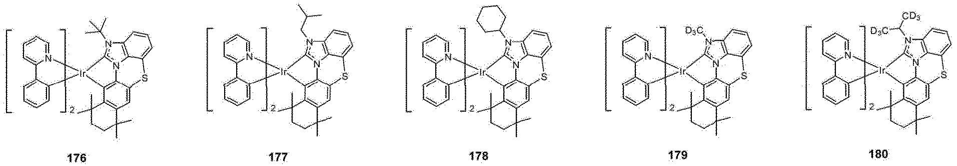

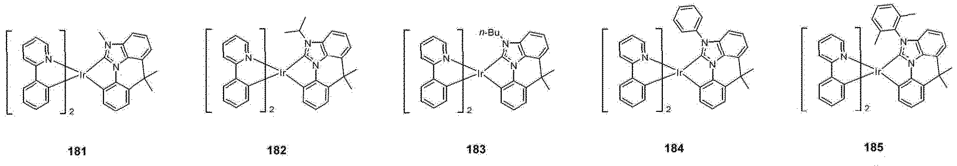

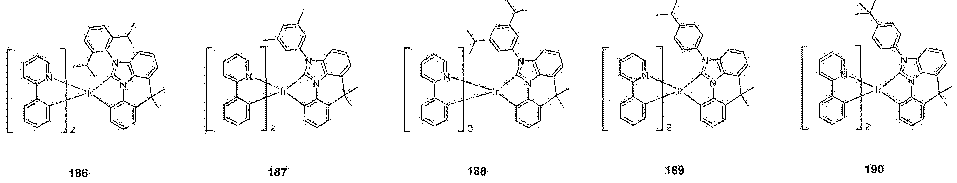

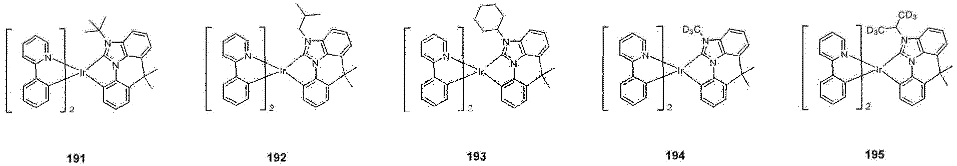

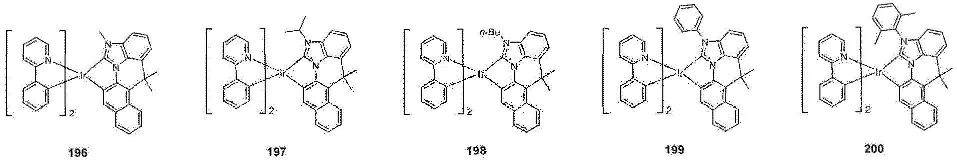

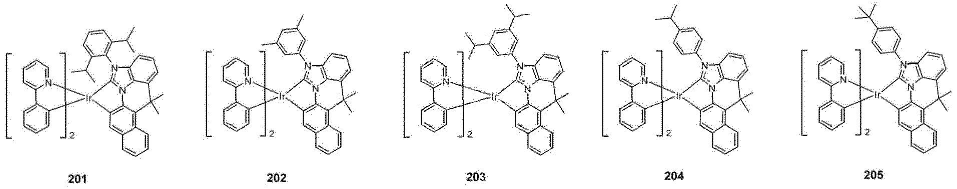

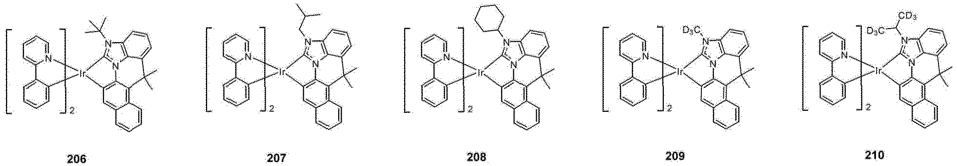

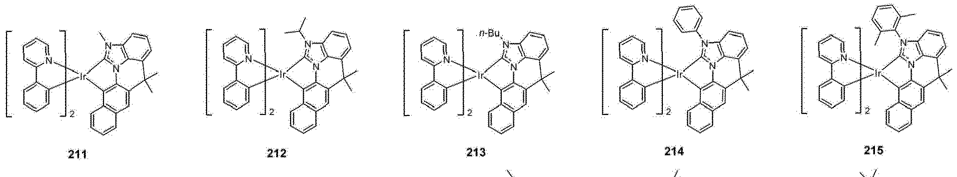

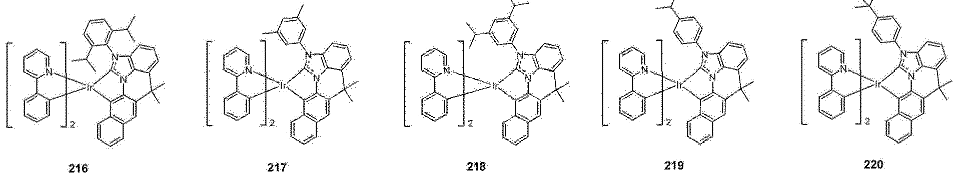

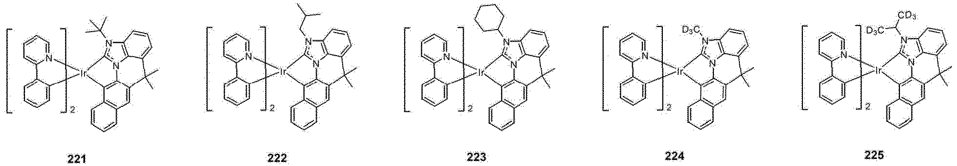

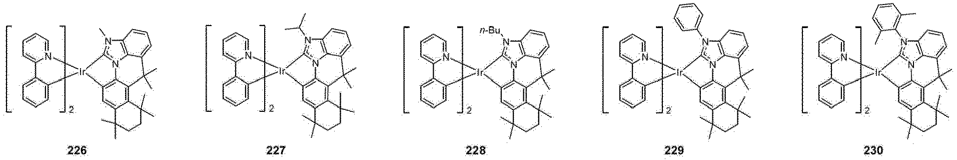

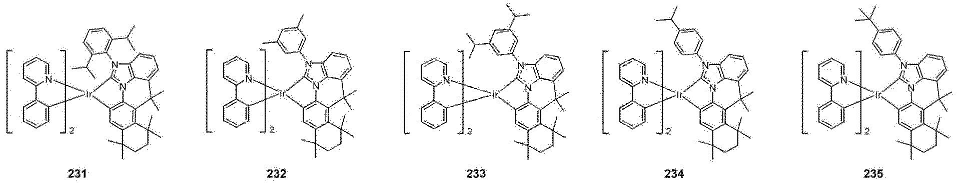

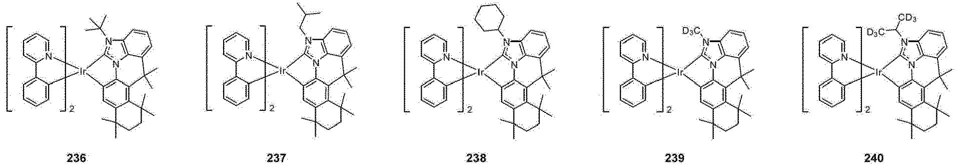

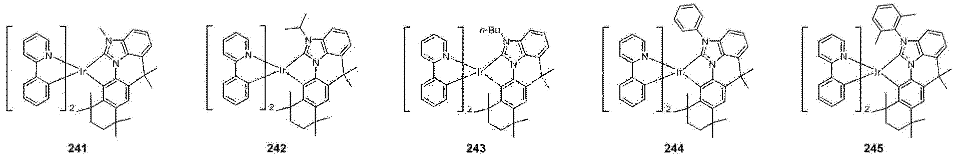

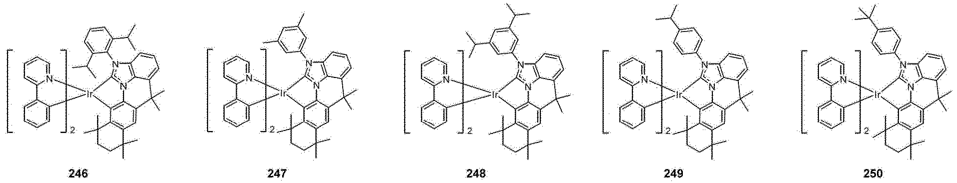

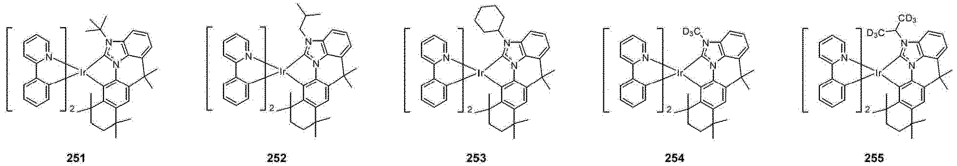

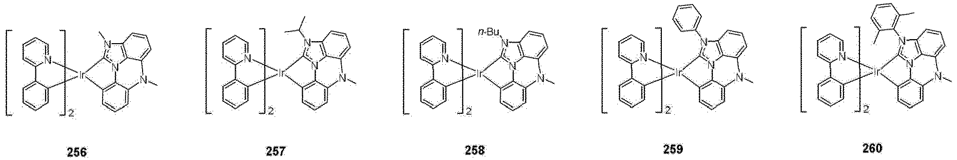

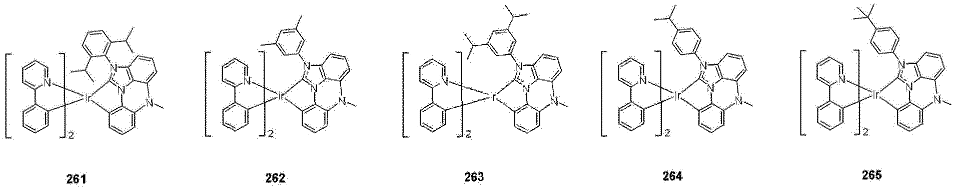

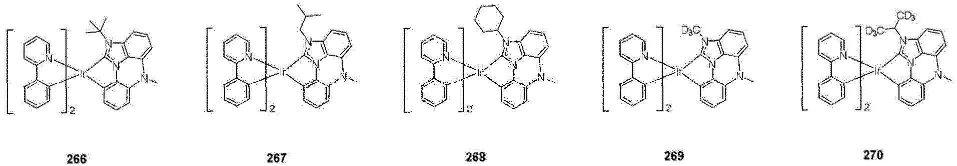

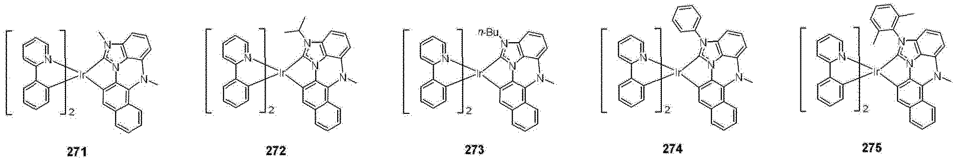

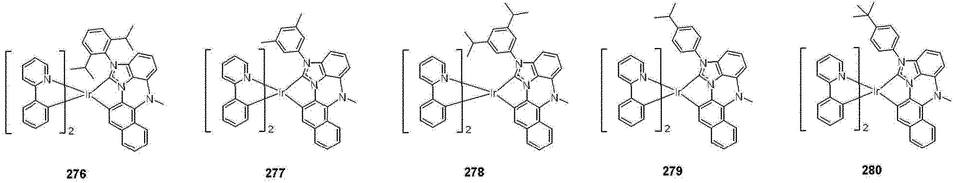

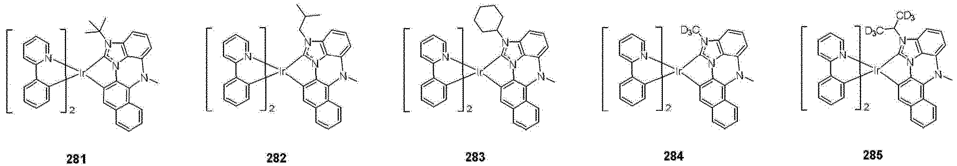

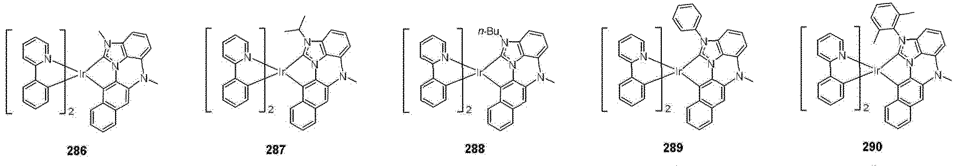

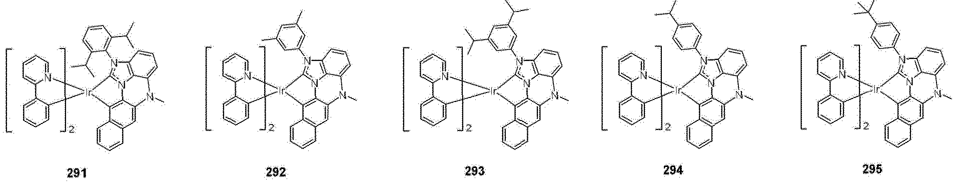

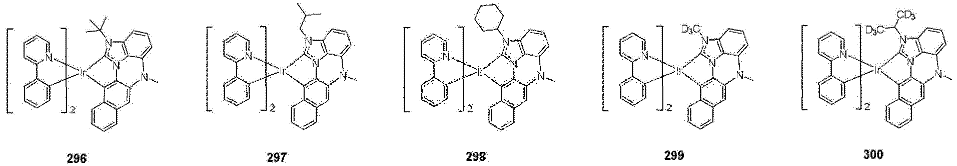

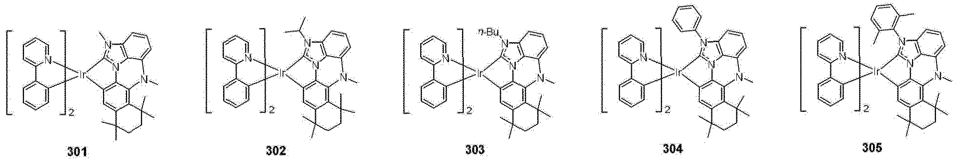

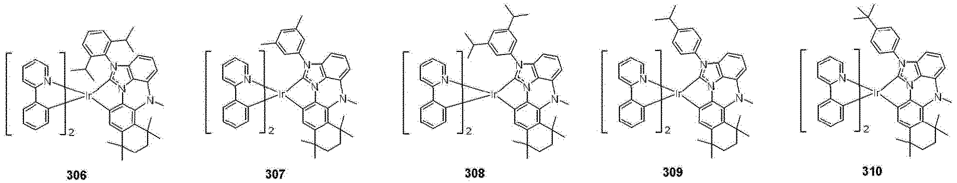

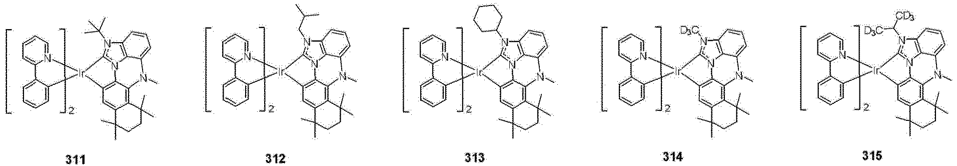

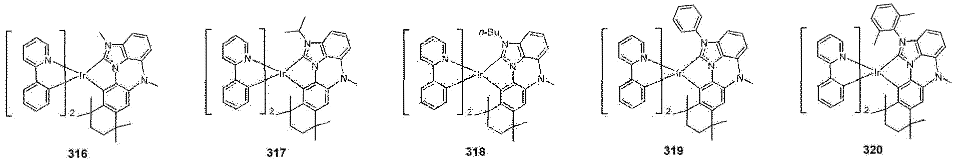

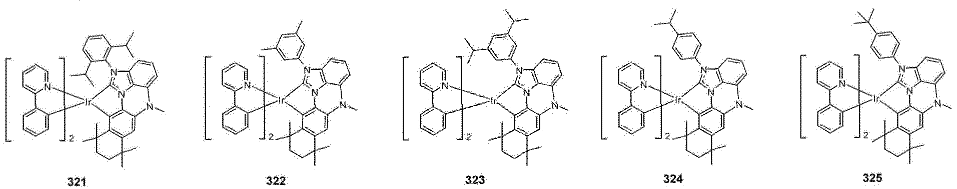

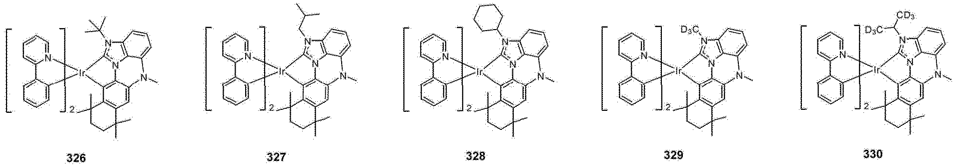

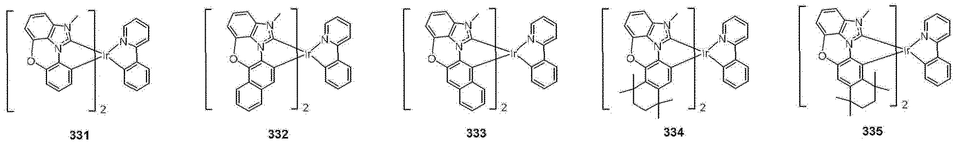

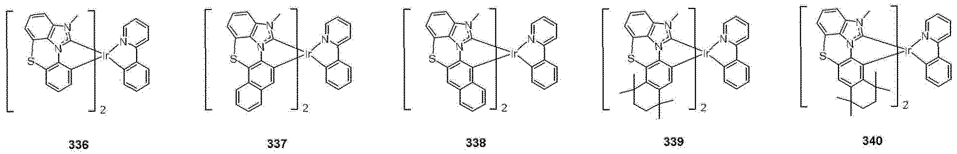

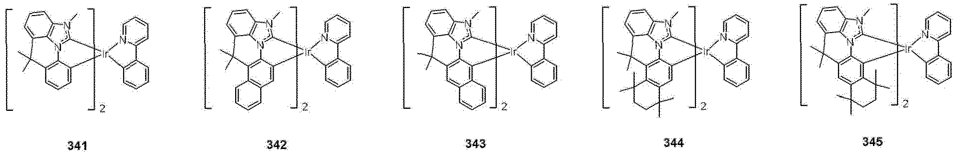

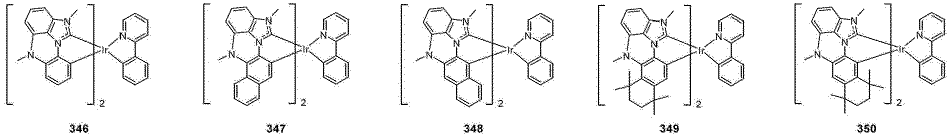

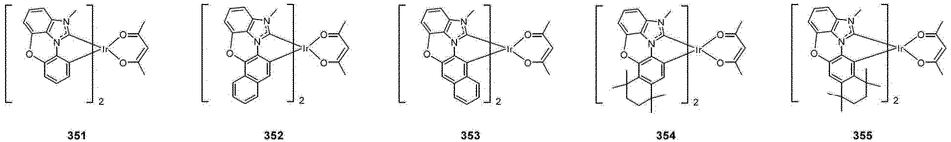

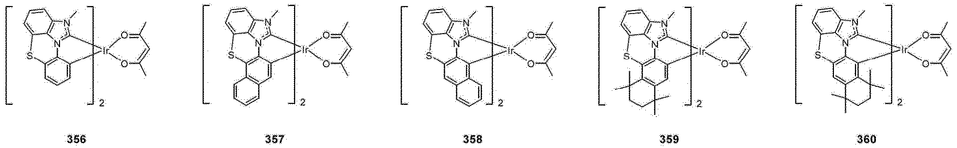

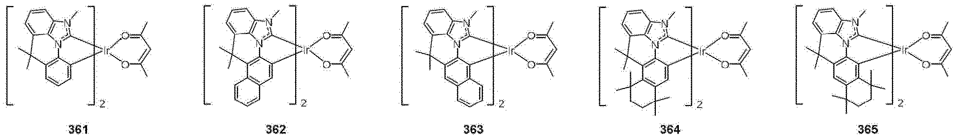

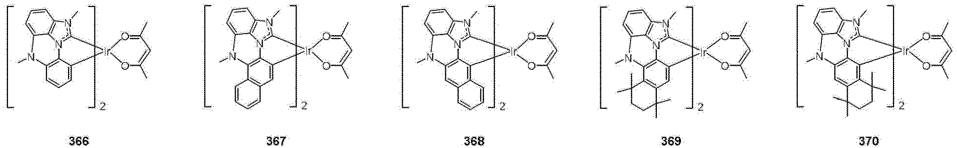

In one embodiment of the invention, the compound represented by the Chemical Formula 1 of the present disclosure is represented by one of the compounds 1, 2, 3, 46, 47, 48, 61, 62, 63, 331, 332, 333, 351, 352, 353.

According to one implementation of the present disclosure, the organometallic compound represented by the Chemical Formula 1 of the present disclosure may be used as a red phosphorescent material or a green phosphorescent material, preferably, as the green phosphorescent material

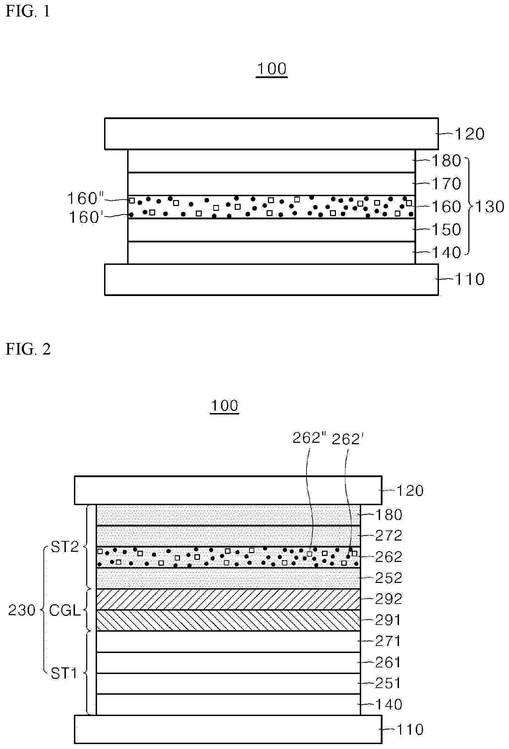

Referring to FIG. 1 according to one implementation of the present disclosure, an organic light-emitting diode 100 may be provided which includes a first electrode 110; a second electrode 120 facing the first electrode 110; and an organic layer 130 disposed between the first electrode 110 and the second electrode 120. The organic layer 130 may include a light-emitting layer 160, and the light-emitting layer 160 may include a host material 160' and dopants 160". The dopants 160" may be made of the organometallic compound represented by the Chemical Formula 1. In addition, in the organic light-emitting diode 100, the organic layer 130 disposed between the first electrode 110 and the second electrode 120 may be formed by sequentially stacking a hole injection layer 140 (HIL), a hole transport layer 150, (HTL), a light emission layer 160 (EML), an electron transport layer 170 (ETL) and an electron injection layer 180 (EIL) on the first electrode 110. The second electrode 120 may be formed on the electron injection layer 180, and a protective layer (not shown) may be formed thereon.

Further, although not shown in FIG. 1, a hole transport auxiliary layer may be further added between the hole transport layer 150 and the light-emitting layer 160. The hole transport auxiliary layer may contain a compound having good hole transport properties, and may reduce a difference between HOMO energy levels of the hole transport layer 150 and the light-emitting layer 160 so as to adjust the hole injection properties. Thus, accumulation of holes at an interface between the hole transport auxiliary layer and the light-emitting layer 160 may be reduced, thereby reducing a quenching phenomenon in which excitons disappear at the interface due to polarons. Accordingly, deterioration of the element may be reduced and the element may be stabilized, thereby improving efficiency and lifespan thereof.

The first electrode 110 may act as a positive electrode, and may be made of ITO, IZO, tin-oxide, or zinc-oxide as a conductive material having a relatively large work function value. However, the present disclosure is not limited thereto.

The second electrode 120 may act as a negative electrode, and may include Al, Mg, Ca, or Ag as a conductive material having a relatively small work function value, or an alloy or combination thereof. However, the present disclosure is not limited thereto.

The hole injection layer 140 may be positioned between the first electrode 110 and the hole transport layer 150. The hole injection layer 140 may have a function of improving interface characteristics between the first electrode 110 and the hole transport layer 150, and may be selected from a material having appropriate conductivity. The hole injection layer 140 may include one or more compounds selected from a group consisting of MTDATA, CuPc, TCTA, HATCN, TDAPB, PEDOT/PSS, and N1,N1'-([1,1'-biphenyl]-4,4'-diyl)bis(N1,N4,N4)-triphenylbenzene-1,4-diamine). Preferably, the hole injection layer 140 may include N1,N1'-([1,1'-biphenyl]-4,4'-diyl)bis(N1,N4,N4-triphenylbenzene-1,4-diamine). However, the present disclosure is limited thereto.

The hole transport layer 150 may be positioned adjacent to the light-emitting layer and between the first electrode 110 and the light-emitting layer 160. A material of the hole transport layer 150 may include a compound selected from a group consisting of TPD, NPB, CBP, N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl)-4-amine, etc. Preferably, the material of the hole transport layer 150 may include NPB. However, the present disclosure is not limited thereto.

According to the present disclosure, the light-emitting layer 160 may include the host material 160' and the organometallic compound represented by the Chemical Formula 1 as dopants 160" doped into the host in order to improve luminous efficiency of the host and the organic light-emitting diode. The light-emitting layer 160 may be formed by adding about 1 to 30% by weight of the organometallic compound, that is, the dopants 160" of the Chemical Formula 1 of the present disclosure to the host material 160', and may emit light of a green or red color. More preferably, the organometallic compound of the Chemical Formula 1 of the present disclosure may act as a green phosphorescent material.

In the light-emitting layer 160 of the present disclosure, the organometallic compound represented by the Chemical Formula 1 may be used as the dopant 160", and a compound containing a carbazole group may be used as the host material 160'. For example, the host material containing the carbazole group may be one or more compounds selected from compounds of structures as shown in a following Table 1. However, the present disclosure is not limited thereto.

**Table 1**

| **Structure of host material** | **Compound name of host material** |
|---|---|
| 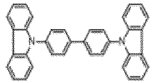 | CBP (4,4-Bis(9-carbazolyl)-1,1') |
| 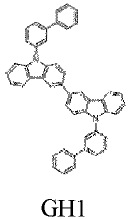 | 9,9'-di([1,1'-biphenyl]-3-yl)-9H,9'H-3,3'-bicarbazole |
| 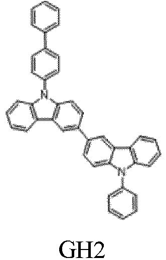 | 9-([1,1'-biphenyl]-4-yl)-9'-phenyl-9H,9'H-3,3'-bicarbazole |
| 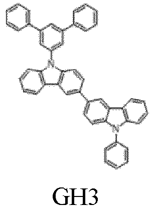 | 9-([1,1': 3',1"-terphenyl]-5'-yl)-9'-phenyl-9H,9'H-3,3'-bicarbazole |
| 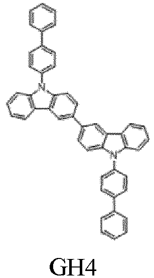 | 9,9'-di([1,1'-biphenyl]-4-yl)-9H,9'H-3,3'-bicarbazole |
| 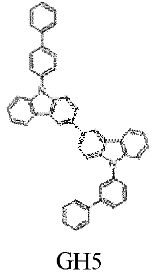 | 9-([1,1'-biphenyl]-3-yl)-9'-([1,1'-biphenyl]-4-yl)-9H,9'H-3,3'-bicarbazole |

Further, the electron transport layer 170 and the electron injection layer 180 may be sequentially stacked between the light-emitting layer 160 and the second electrode 120. A material of the electron transport layer 170 requires high electron mobility such that electrons may be stably supplied to the light-emitting layer under smooth electron transport.

For example, the material of the electron transport layer 170 may include a compound selected from a group consisting of Alq₃ (tris(8-hydroxyquinolino)aluminum), Liq (8-hydroxyquinolinolatolithium), PBD (2-(4-biphenylyl)-5-(4-tert-butylphenyl)-1,3,4oxadiazole), TAZ (3-(4-biphenyl)4-phenyl-5-tert-butylphenyl-1,2,4-triazole), spiro-PBD, BAlq (bis(2-methyl-8-quinolinolate)-4-(phenylphenolato)aluminium), SAlq, TPBi (2,2',2-(1,3,5-benzinetriyl)-tris(1-phenyl-1-H-benzimidazole), oxadiazole, triazole, phenanthroline, benzoxazole, benzthiazole, and 2-(4-(9,10-di(naphthalen-2-yl)anthracen-2-yl)phenyl)-1-phenyl-1H-benzo[d]imidazole. Preferably, the material of the electron transport layer 170 may include 2-(4-(9,10-di(naphthalen-2-yl)anthracen-2-yl)phenyl)-1-phenyl-1H-benzo[d]imidazole. However, the present disclosure is not limited thereto.

The electron injection layer 180 serves to facilitate electron injection, and a material of the electron injection layer may include a compound selected from a group consisting of Alq3 (tris(8-hydroxyquinolino)aluminum), PBD, TAZ, spiro-PBD, BAlq, SAlq, etc. However, the present disclosure is not limited thereto. Alternatively, the electron injection layer 180 may be made of a metal compound. The metal compound may include, for example, one or more selected from a group consisting of Liq, LiF, NaF, KF, RbF, CsF, FrF, BeF₂, MgF₂, CaF₂, SrF₂, BaF₂ and RaF₂. However, the present disclosure is not limited thereto.

The organic light-emitting diode according to the present disclosure may be embodied as a white light-emitting diode having a tandem structure. The tandem organic light-emitting diode according to an illustrative embodiment of the present disclosure may be formed in a structure in which adjacent ones of two or more light-emitting stacks are connected to each other via a charge generation layer (CGL). The organic light-emitting diode may include at least two light-emitting stacks disposed on a substrate, wherein each of the at least two light-emitting stacks includes first and second electrodes facing each other, and the light-emitting layer disposed between the first and second electrodes to emit light in a specific wavelength band. In this case, the light-emitting layer included in at least one of the plurality of light-emitting stacks may contain the organometallic compound represented by the Chemical Formula I according to the present disclosure as the dopants. Adjacent ones of the plurality of light-emitting stacks in the tandem structure may be connected to each other via the charge generation layer CGL including an N-type charge generation layer and a P-type charge generation layer.

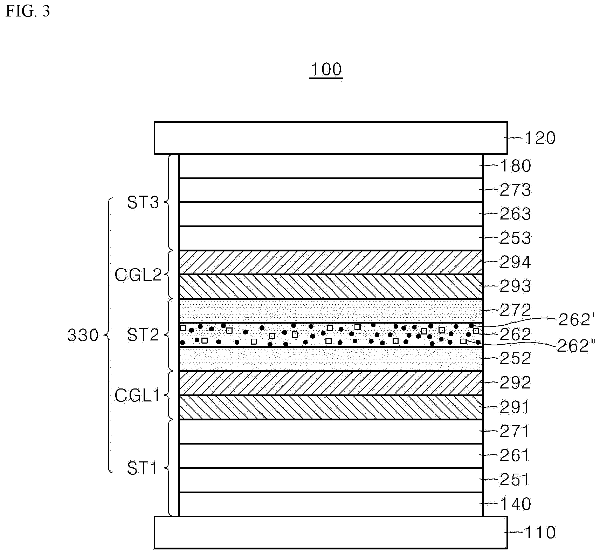

FIG. 2 and FIG. 3 are cross-sectional views schematically showing an organic light-emitting diode in a tandem structure having two light-emitting stacks and an organic light-emitting diode in a tandem structure having three light-emitting stacks, respectively, according to some implementations of the present disclosure.

As shown in FIG. 2, an organic light-emitting diode 100 according to the present disclosure include a first electrode 110 and a second electrode 120 facing each other, and an organic layer 230 positioned between the first electrode 110 and the second electrode 120. The organic layer 230 may be positioned between the first electrode 110 and the second electrode 120 and may include a first light-emitting stack ST1 including a first light-emitting layer 261, a second light-emitting stack ST2 positioned between the first light-emitting stack ST1 and the second electrode 120 and including a second light-emitting layer 262, and the charge generation layer CGL positioned between the first and second light-emitting stacks ST1 and ST2. The charge generation layer CGL may include an N-type charge generation layer 291 and a P-type charge generation layer 292. At least one of the first light-emitting layer 261 and the second light-emitting layer 262 may contain the organometallic compound represented by the Chemical Formula I according to the present disclosure as the dopants. For example, as shown in FIG. 2, the second light-emitting layer 262 of the second light-emitting stack ST2 may contain a host material 262', and dopants 262" made of the organometallic compound represented by the Chemical Formula I doped therein.

As shown in FIG. 3, the organic light-emitting diode 100 according to the present disclosure include the first electrode 110 and the second electrode 120 facing each other, and an organic layer 330 positioned between the first electrode 110 and the second electrode 120. The organic layer 330 may be positioned between the first electrode 110 and the second electrode 120 and may include the first light-emitting stack ST1 including the first light-emitting layer 261, the second light-emitting stack ST2 including the second light-emitting layer 262, a third light-emitting stack ST3 including a third light-emitting layer 263, a first charge generation layer CGL1 positioned between the first and second light-emitting stacks ST1 and ST2, and a second charge generation layer CGL2 positioned between the second and third light-emitting stacks ST2 and ST3. The first charge generation layer CGL1 may include a N-type charge generation layers 291 and a P-type charge generation layer 292. The second charge generation layer CGL2 may include a N-type charge generation layers 293 and a P-type charge generation layer 294. At least one of the first light-emitting layer 261, the second light-emitting layer 262, and the third light-emitting layer 263 may contain the organometallic compound represented by the Chemical Formula I according to the present disclosure as the dopants. For example, as shown in FIG. 3, the second light-emitting layer 262 of the second light-emitting stack ST2 may contain the host material 262', and the dopants 262" made of the organometallic compound represented by the Chemical Formula I doped therein.

Furthermore, an organic light-emitting diode according to an embodiment of the present disclosure may include a tandem structure in which four or more light-emitting stacks and three or more charge generating layers are disposed between the first electrode and the second electrode.

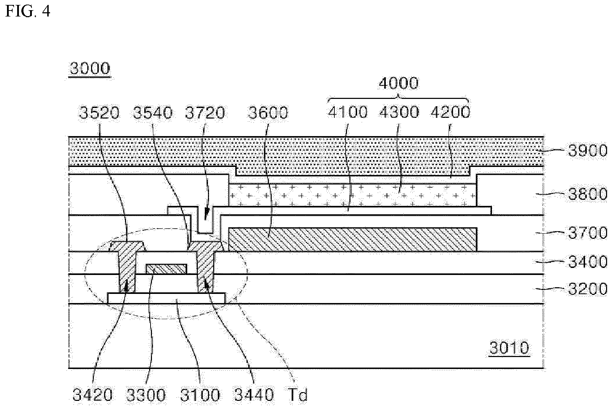

The organic light-emitting diode according to the present disclosure may be used as a light-emitting element of each of an organic light-emitting display device and a lighting device. In one implementation, FIG. 4 is a cross-sectional view schematically illustrating an organic light-emitting display device including the organic light-emitting diode according to some embodiments of the present disclosure as a light-emitting element thereof.

As shown in FIG. 4, an organic light-emitting display device 3000 includes a substrate 3010, an organic light-emitting diode 4000, and an encapsulation film 3900 covering the organic light-emitting diode 4000. A driving thin-film transistor Td as a driving element, and the organic light-emitting diode 4000 connected to the driving thin-film transistor Td are positioned on the substrate 3010.

Although not shown explicitly in FIG. 4, a gate line and a data line that intersect each other to define a pixel area, a power line extending parallel to and spaced from one of the gate line and the data line, a switching thin film transistor connected to the gate line and the data line, and a storage capacitor connected to one electrode of the thin film transistor and the power line are further formed on the substrate 3010.

The driving thin-film transistor Td is connected to the switching thin film transistor, and includes a semiconductor layer 3100, a gate electrode 3300, a source electrode 3520, and a drain electrode 3540.

The semiconductor layer 3100 may be formed on the substrate 3010 and may be made of an oxide semiconductor material or polycrystalline silicon. When the semiconductor layer 3100 is made of an oxide semiconductor material, a light-shielding pattern (not shown) may be formed under the semiconductor layer 3100. The light-shielding pattern prevents light from being incident into the semiconductor layer 3100 to prevent the semiconductor layer 3010 from being deteriorated due to the light. Alternatively, the semiconductor layer 3100 may be made of polycrystalline silicon. In this case, both edges of the semiconductor layer 3100 may be doped with impurities.

The gate insulating layer 3200 made of an insulating material is formed over an entirety of a surface of the substrate 3010 and on the semiconductor layer 3100. The gate insulating layer 3200 may be made of an inorganic insulating material such as silicon oxide or silicon nitride.

The gate electrode 3300 made of a conductive material such as a metal is formed on the gate insulating layer 3200 and corresponds to a center of the semiconductor layer 3100. The gate electrode 3300 is connected to the switching thin film transistor.

The interlayer insulating layer 3400 made of an insulating material is formed over the entirety of the surface of the substrate 3010 and on the gate electrode 3300. The interlayer insulating layer 3400 may be made of an inorganic insulating material such as silicon oxide or silicon nitride, or an organic insulating material such as benzocyclobutene or photo-acryl.

The interlayer insulating layer 3400 has first and second semiconductor layer contact holes 3420 and 3440 defined therein respectively exposing both opposing sides of the semiconductor layer 3100. The first and second semiconductor layer contact holes 3420 and 3440 are respectively positioned on both opposing sides of the gate electrode 3300 and are spaced apart from the gate electrode 3300.

The source electrode 3520 and the drain electrode 3540 made of a conductive material such as metal are formed on the interlayer insulating layer 3400. The source electrode 3520 and the drain electrode 3540 are positioned around the gate electrode 3300, and are spaced apart from each other, and respectively contact both opposing sides of the semiconductor layer 3100 via the first and second semiconductor layer contact holes 3420 and 3440, respectively. The source electrode 3520 is connected to a power line (not shown).

The semiconductor layer 3100, the gate electrode 3300, the source electrode 3520, and the drain electrode 3540 constitute the driving thin-film transistor Td. The driving thin-film transistor Td has a coplanar structure in which the gate electrode 3300, the source electrode 3520, and the drain electrode 3540 are positioned on top of the semiconductor layer 3100.

Alternatively, the driving thin-film transistor Td may have an inverted staggered structure in which the gate electrode is disposed under the semiconductor layer while the source electrode and the drain electrode are disposed above the semiconductor layer. In this case, the semiconductor layer may be made of amorphous silicon. In one example, the switching thin-film transistor (not shown) may have substantially the same structure as that of the driving thin-film transistor (Td).

In one example, the organic light-emitting display device 3000 may include a color filter 3600 absorbing the light generated from the electroluminescent element (light-emitting diode) 4000. For example, the color filter 3600 may absorb red (R), green (G), blue (B), and white (W) light. In this case, red, green, and blue color filter patterns that absorb light may be formed separately in different pixel areas. Each of these color filter patterns may be disposed to overlap each organic layer 4300 of the organic light-emitting diode 4000 to emit light of a wavelength band corresponding to each color filter. Adopting the color filter 3600 may allow the organic light-emitting display device 3000 to realize full-color.

For example, when the organic light-emitting display device 3000 is of a bottom emission type, the color filter 3600 absorbing light may be positioned on a portion of the interlayer insulating layer 3400 corresponding to the organic light-emitting diode 4000. In an optional embodiment, when the organic light-emitting display device 3000 is of a top emission type, the color filter may be positioned on top of the organic light-emitting diode 4000, that is, on top of a second electrode 4200. For example, the color filter 3600 may be formed to have a thickness of 2 to 5 µm.

In one example, a protective layer 3700 having a drain contact hole 3720 defined therein exposing the drain electrode 3540 of the driving thin-film transistor Td is formed to cover the driving thin-film transistor Td.

On the protective layer 3700, each first electrode 4100 connected to the drain electrode 3540 of the driving thin-film transistor Td via the drain contact hole 3720 is formed individually in each pixel area.

The first electrode 4100 may act as a positive electrode (anode), and may be made of a conductive material having a relatively large work function value. For example, the first electrode 4100 may be made of a transparent conductive material such as ITO, IZO or ZnO.

In one example, when the organic light-emitting display device 3000 is of a top-emission type, a reflective electrode or a reflective layer may be further formed under the first electrode 4100. For example, the reflective electrode or the reflective layer may be made of one of aluminum (Al), silver (Ag), nickel (Ni), and an aluminum-palladium-copper (APC) alloy.

A bank layer 3800 covering an edge of the first electrode 4100 is formed on the protective layer 3700. The bank layer 3800 exposes a center of the first electrode 4100 corresponding to the pixel area.

An organic layer 4300 is formed on the first electrode 4100. If necessary, the organic light-emitting diode 4000 may have a tandem structure. Regarding the tandem structure, reference may be made to FIG. 2 to FIG. 4 which show some embodiments of the present disclosure, and the above descriptions thereof.

The second electrode 4200 is formed on the substrate 3010 on which the organic layer 4300 has been formed. The second electrode 4200 is disposed over the entirety of the surface of the display area and is made of a conductive material having a relatively small work function value and may be used as a negative electrode (a cathode). For example, the second electrode 4200 may be made of one of aluminum (Al), magnesium (Mg), and an aluminum-magnesium alloy (Al-Mg).

The first electrode 4100, the organic layer 4300, and the second electrode 4200 constitute the organic light-emitting diode 4000.

An encapsulation film 3900 is formed on the second electrode 4200 to prevent external moisture from penetrating into the organic light-emitting diode 4000. Although not shown explicitly in FIG. 4, the encapsulation film 3900 may have a triple-layer structure in which a first inorganic layer, an organic layer, and an inorganic layer are sequentially stacked. However, the present disclosure is not limited thereto.

Hereinafter, Synthesis Example and Present Example of the present disclosure will be described. However, following Present Example is only one example of the present disclosure. The present disclosure is not limited thereto.

### Synthesis Example - Preparation of ligand intermediate product

### < Preparation of ligand A-1>

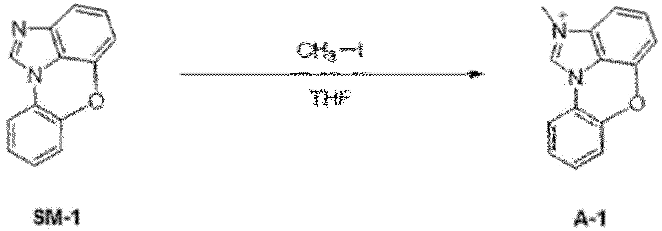

In a 500mL round bottom flask and under a nitrogen atmosphere, SM-1 (10.40 g, 0.05 mol) was dissolved in 250 mL of THF, and then iodomethane (42.58 g, 0.30 mol) was sequentially added to a reaction solution and then the reaction solution was stirred at 40° C. for 24 hours. When the reaction thereof was completed, the reaction solution was filtered and concentrated under reduced pressure to obtain the compound A-1 (18.13 g, 92%).

### <Preparation of ligand B-1>

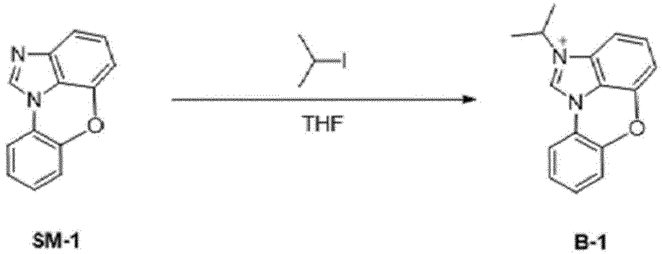

In a 500mL round bottom flask and under a nitrogen atmosphere, SM-1 (10.40 g, 0.05 mol) was dissolved in 250 mL of THF, and then 2-iodopropane (42.58 g, 0.30 mol) was sequentially added to a reaction solution and then the reaction solution was stirred at 40° C. for 24 hours. When the reaction thereof was completed, the reaction solution was filtered and concentrated under reduced pressure to obtain the compound B-1 (19.00 g, 90%).

### <Preparation of ligand C-1>

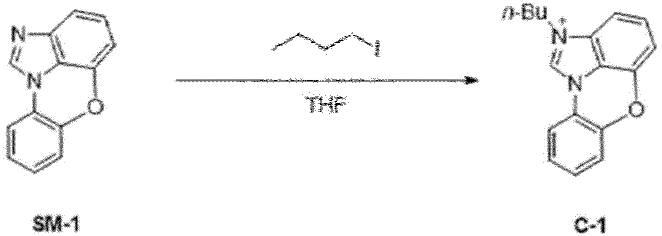

In a 500mL round bottom flask and under a nitrogen atmosphere, SM-1 (10.40 g, 0.05 mol) was dissolved in 250 mL of THF, and then 1-iodobutane (42.58 g, 0.30 mol) was sequentially added to a reaction solution and then the reaction solution was stirred at 40° C. for 24 hours. When the reaction thereof was completed, the reaction solution was filtered and concentrated under reduced pressure to obtain the compound C-1 (18.53 g, 85%).

### <Preparation of ligand D-1>

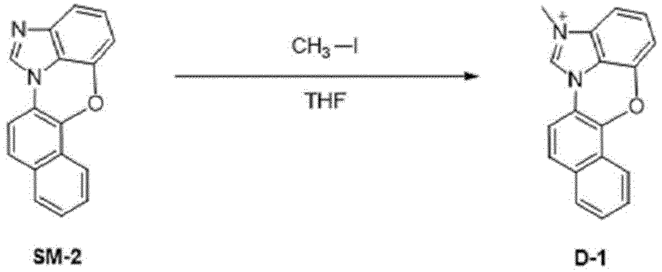

In a 500 mL round bottom flask and under a nitrogen atmosphere, SM-2 (12.90 g, 0.05 mol) was dissolved in 250 mL of THF, and then iodomethane (51.00 g, 0.30 mol) was sequentially added to a reaction solution and then the reaction solution was stirred at 40 °C for 24 hours. When the reaction thereof was completed, the reaction solution was filtered and concentrated under reduced pressure to obtain the compound D-1 (19.10 g, 86%).

### < Preparation of Ligand E-1 >

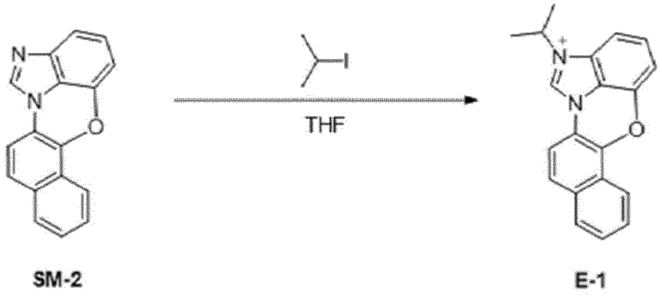

In a 500 mL round bottom flask and under a nitrogen atmosphere, SM-2 (12.90 g, 0.05 mol) was dissolved in 250 mL of THF, and then 2-iodopropane (51.00 g, 0.30 mol) was sequentially added to a reaction solution and then the reaction solution was stirred at 40 °C for 24 hours. When the reaction thereof was completed, the reaction solution was filtered and concentrated under reduced pressure to obtain the compound E-1 (21.00 g, 89%).

### < Preparation of Ligand F-1 >

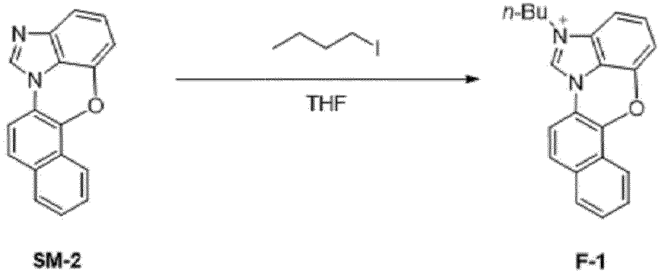

In a 500 mL round bottom flask and under a nitrogen atmosphere, SM-2 (12.90 g, 0.05 mol) was dissolved in 250 mL of THF, and then 1-iodobutane (51.00 g, 0.30 mol) was sequentially added to a reaction solution and then the reaction solution was stirred at 40 °C for 24 hours. When the reaction thereof was completed, the reaction solution was filtered and concentrated under reduced pressure to obtain the compound F-1 (22.85 g, 94%).

### <Preparation of ligand G-1>

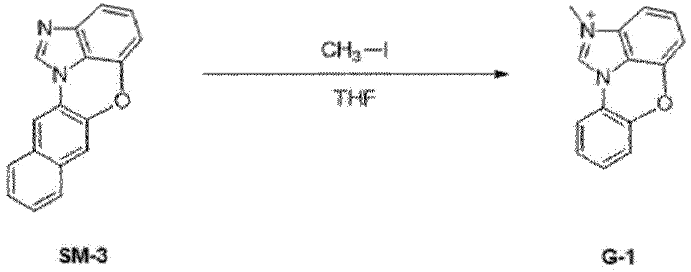

In a 500 mL round bottom flask and under a nitrogen atmosphere, SM-3 (12.90 g, 0.05 mol) was dissolved in 250 mL of THF, and then iodomethane (51.00 g, 0.30 mol) was sequentially added to a reaction solution and then the reaction solution was stirred at 40 °C for 24 hours. When the reaction thereof was completed, the reaction solution was filtered and concentrated under reduced pressure to obtain the compound G-1 (20.43 g, 92%).

### <Preparation of ligand H-1>

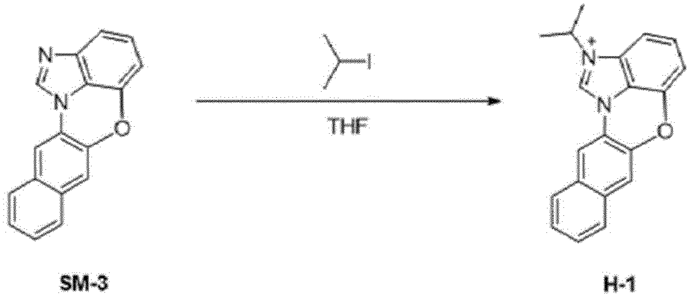

In a 500 mL round bottom flask and under a nitrogen atmosphere, SM-3 (12.90 g, 0.05 mol) was dissolved in 250 mL of THF, and then 2-iodopropane (51.00 g, 0.30 mol) was sequentially added to a reaction solution and then the reaction solution was stirred at 40 °C for 24 hours. When the reaction thereof was completed, the reaction solution was filtered and concentrated under reduced pressure to obtain the compound H-1 (21.00 g, 89%).

### < Preparation of Ligand I-1 >

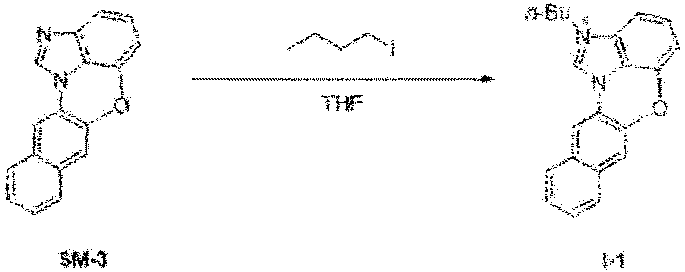

In a 500 mL round bottom flask and under a nitrogen atmosphere, SM-3 (12.90 g, 0.05 mol) was dissolved in 250 mL of THF, and then 1-iodobutane (51.00 g, 0.30 mol) was sequentially added to a reaction solution and then the reaction solution was stirred at 40 °C for 24 hours. When the reaction thereof was completed, the reaction solution was filtered and concentrated under reduced pressure to obtain the compound I-1 (21.15 g, 87%).

### Synthesis Example- Preparation of ligand

### <Preparation of ligand A>

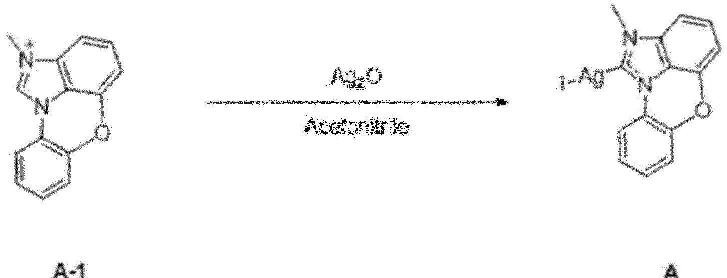

In a 500 mL round bottom flask and under a nitrogen atmosphere, the reactant A-1 (19.70 g, 0.05 mol) and silver oxide (5.80 g, 0.025 mol) were dissolved in 250 mL of acetonitrile and then a reaction solution was stirred at room temperature for 24 hours. When the reaction thereof was completed, the reaction solution was concentrated under reduced pressure to obtain the compound A (20.74 g, 91%), and further purification for a next reaction was not performed.

### <Preparation of ligand B>

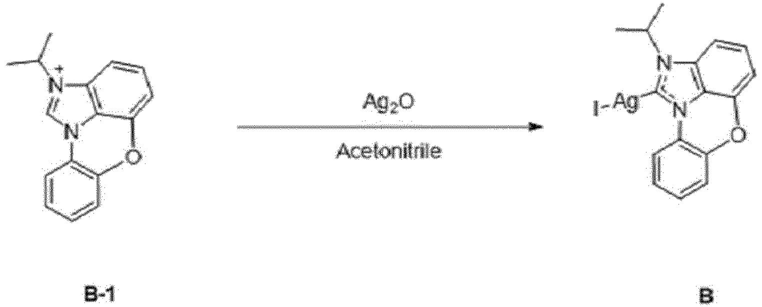

In a 500 mL round bottom flask and under a nitrogen atmosphere, the reactant B-1 (21.10 g, 0.05 mol) and silver oxide (5.80 g, 0.025 mol) were dissolved in 250 mL of acetonitrile and then a reaction solution was stirred at room temperature for 24 hours. Upon completion of the reaction thereof, the reaction solution was concentrated under reduced pressure to obtain the compound B (21.78 g, 90%), and further purification for a next reaction was not performed.

### <Preparation of ligand C>

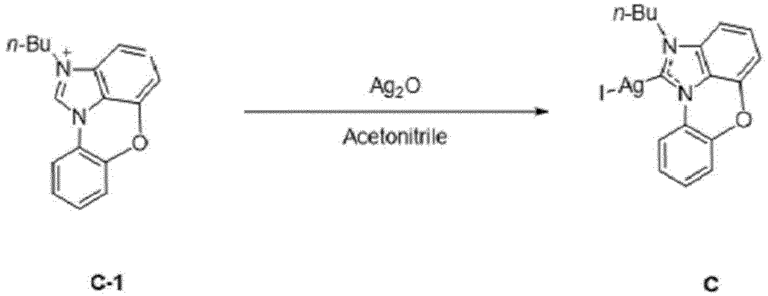

In a 500 mL round bottom flask and under a nitrogen atmosphere, the reactant C-1 (21.81 g, 0.05 mol) and silver oxide (5.80 g, 0.025 mol) were dissolved in 250 mL of acetonitrile and then a reaction solution was stirred at room temperature for 24 hours. When the reaction thereof was completed, the reaction solution was concentrated under reduced pressure to obtain the compound C (23.15 g, 93%), and further purification for a next reaction was not performed.

### <Preparation of ligand D>

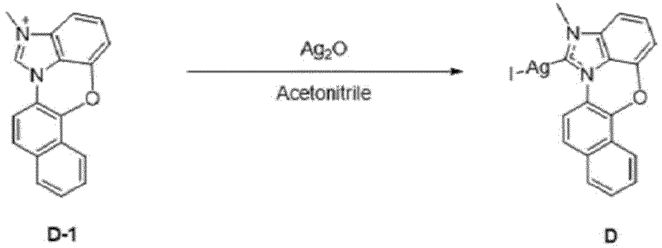

In a 500 mL round bottom flask and under a nitrogen atmosphere, the reactant D-1 (22.20 g, 0.05 mol) and silver oxide (5.80 g, 0.025 mol) were dissolved in 250 mL of acetonitrile and then a reaction solution was stirred at room temperature for 24 hours. When the reaction thereof was completed, the reaction solution was concentrated under reduced pressure to obtain the compound D (24.03 g, 95%), and further purification for a next reaction was not performed.

### <Preparation of ligand E>

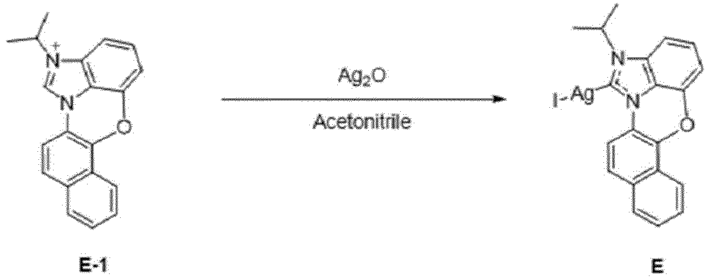

In a 500 mL round bottom flask and under a nitrogen atmosphere, the reactant E-1 (23.61 g, 0.05 mol) and silver oxide (5.80 g, 0.025 mol) were dissolved in 250 mL of acetonitrile and then a reaction solution was stirred at room temperature for 24 hours. When the reaction thereof was completed, the reaction solution was concentrated under reduced pressure to obtain the compound E (22.70 g, 85%), and further purification for a next reaction was not performed.

### <Preparation of ligand F>

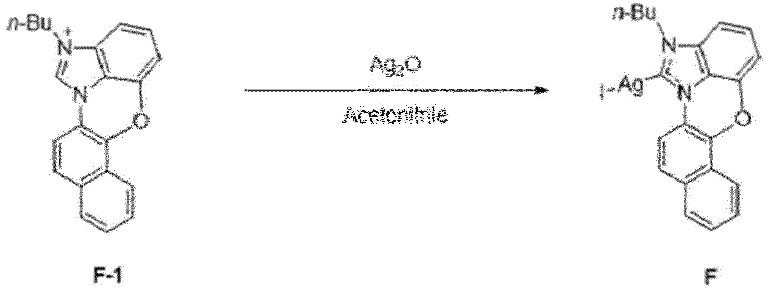

In a 500 mL round bottom flask and under a nitrogen atmosphere, the reactant F-1 (24.31 g, 0.05 mol) and silver oxide (5.80 g, 0.025 mol) were dissolved in 250 mL of acetonitrile and then a reaction solution was stirred at room temperature for 24 hours. Upon completion of the reaction thereof, the reaction solution was concentrated under reduced pressure to obtain the compound F (25.75 g, 94%), and further purification for a next reaction was not performed.

### <Preparation of ligand G>

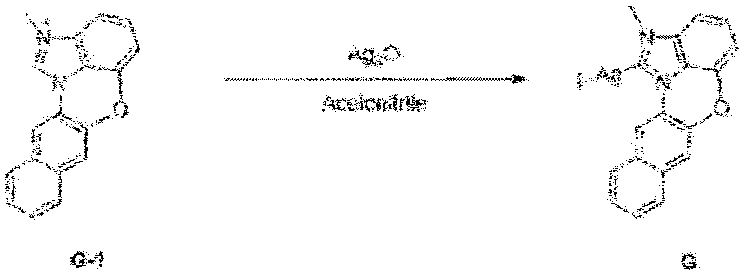

In a 500 mL round bottom flask and under a nitrogen atmosphere, the reactant G-1 (22.20 g, 0.05 mol) and silver oxide (5.80 g, 0.025 mol) were dissolved in 250 mL of acetonitrile and then a reaction solution was stirred at room temperature for 24 hours. When the reaction thereof was completed, the reaction solution was concentrated under reduced pressure to obtain the compound G (22.51 g, 89%), and further purification for a next reaction was not performed.

### <Preparation of ligand H>

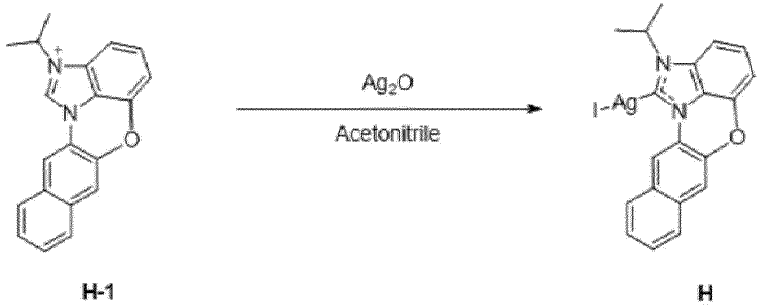

In a 500 mL round bottom flask and under a nitrogen atmosphere, the reactant H-1 (23.61 g, 0.05 mol) and silver oxide (5.80 g, 0.025 mol) were dissolved in 250 mL of acetonitrile and then a reaction solution was stirred at room temperature for 24 hours. When the reaction thereof was completed, the reaction solution was concentrated under reduced pressure to obtain the compound H (24.83 g, 93%), and further purification for a next reaction was not performed.

### <Preparation of ligand I>

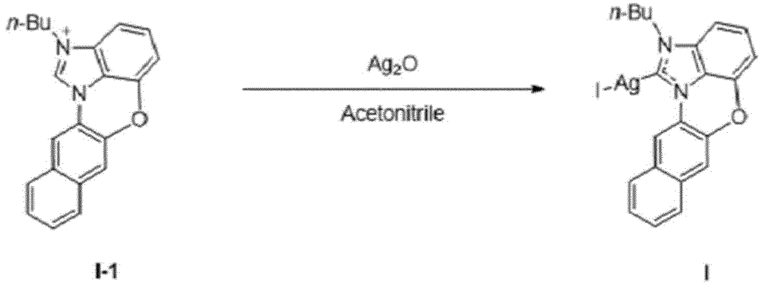

In a 500 mL round bottom flask and under a nitrogen atmosphere, the reactant I-1 (24.31 g, 0.05 mol) and silver oxide (5.80 g, 0.025 mol) were dissolved in 250 mL of acetonitrile and then a reaction solution was stirred at room temperature for 24 hours. Upon completion of the reaction thereof, the reaction solution was concentrated under reduced pressure to obtain the compound I (25.75 g, 94%), and further purification for a next reaction was not performed.

### Synthesis Example - Preparation of iridium compound

### <Preparation of iridium compound 1>

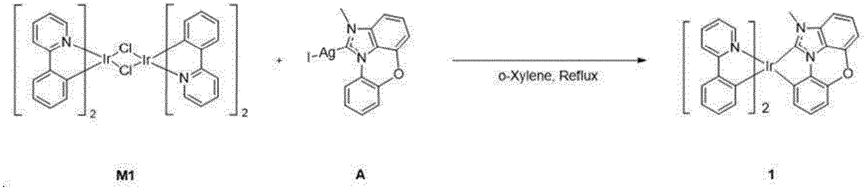

In a 150 mL round bottom flask and under a nitrogen atmosphere, iridium precursor M1 (1.61 g, 1.5 mmol) and the ligand A (1.37 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 1 (1.56 g, 72%).

### <Preparation of iridium compound 2>

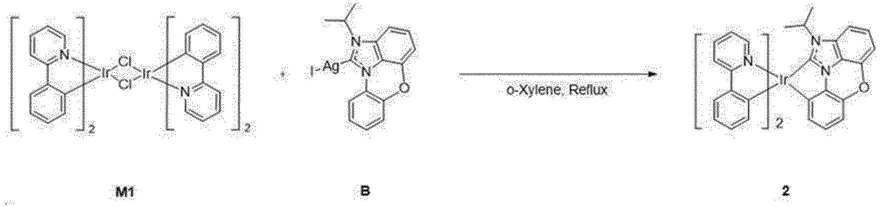

In a 150 mL round bottom flask and under a nitrogen atmosphere, iridium precursor M1 (1.61 g, 1.5 mmol) and the ligand B (1.45 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 2 (1.53 g, 68%).

### <Preparation of iridium compound 3>

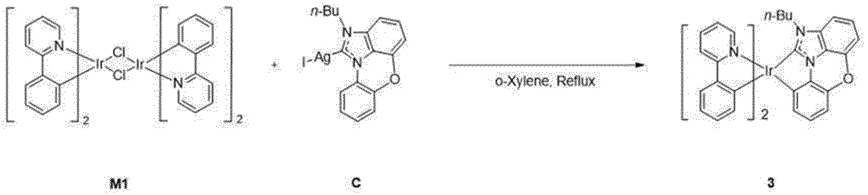

In a 150 mL round bottom flask and under a nitrogen atmosphere, iridium precursor M1 (1.61 g, 1.5 mmol) and the ligand C (1.50 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 3 (1.79 g, 78%).

### <Preparation of iridium compound 46>

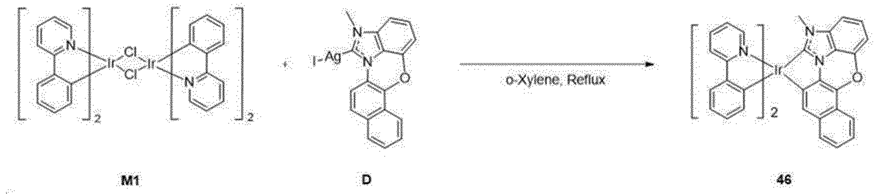

In a 150 mL round bottom flask and under a nitrogen atmosphere, iridium precursor M1 (1.61 g, 1.5 mmol) and the ligand D (1.52 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 46 (1.76 g, 76%).

### <Preparation of iridium compound 47>

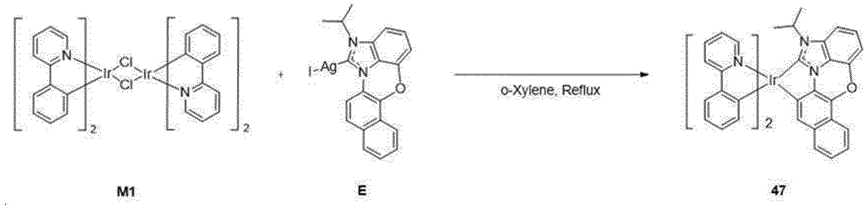

In a 150 mL round bottom flask and under a nitrogen atmosphere, iridium precursor M1 (1.61 g, 1.5 mmol) and the ligand E (1.60 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 47 (1.80 g, 75%).

### <Preparation of iridium compound 48>

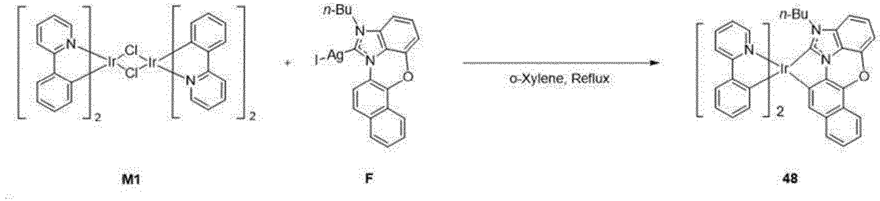

In a 150 mL round bottom flask and under a nitrogen atmosphere, iridium precursor M1 (1.61 g, 1.5 mmol) and the ligand F (1.64 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 48 (1.78 g, 73%).

### <Preparation of iridium compound 61>

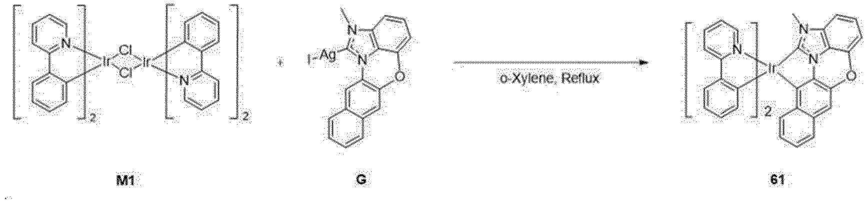

In a 150 mL round bottom flask and under a nitrogen atmosphere, iridium precursor M1 (1.61 g, 1.5 mmol) and the ligand G (1.51 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 61 (1.62 g, 70%).

### <Preparation of iridium compound 62>

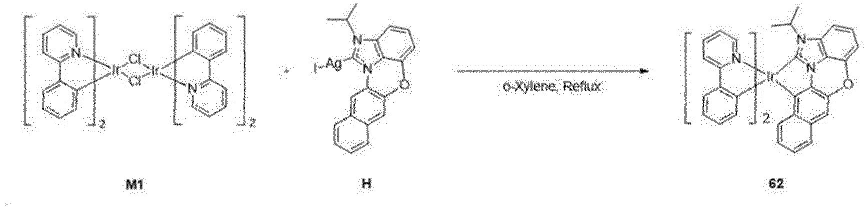

In a 150 mL round bottom flask and under a nitrogen atmosphere, iridium precursor M1 (1.61 g, 1.5 mmol) and the ligand H (1.60 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 62 (1.92 g, 80%).

### <Preparation of iridium compound 63>

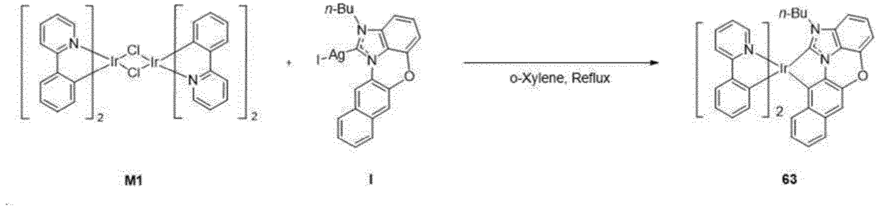

In a 150 mL round bottom flask and under a nitrogen atmosphere, iridium precursor M1 (1.61 g, 1.5 mmol) and the ligand I (1.64 g, 3 mmol) were dissolved in o-xylene (150 mL) and a reaction solution was stirred under reflux for 18 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of ethylacetate:hexane = 25:75 to obtain the above iridium compound 63 (2.00 g, 82%).

### <Preparation of iridium compound 331>

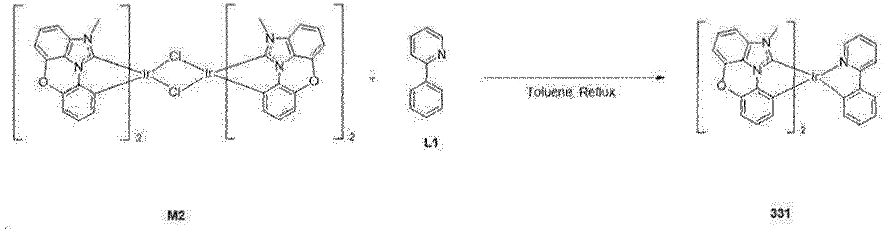

In a 250 mL round bottom flask and under a nitrogen atmosphere, iridium precursor M2 (2.01 g, 1.5 mmol) and the ligand L1 (0.47 g, 3 mmol) were dissolved in toluene (100 mL) and a reaction solution was stirred under reflux for 24 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of toluene:hexane = 1:1 to obtain the above iridium compound 331 (1.66 g, 70%).

### <Preparation of iridium compound 332>

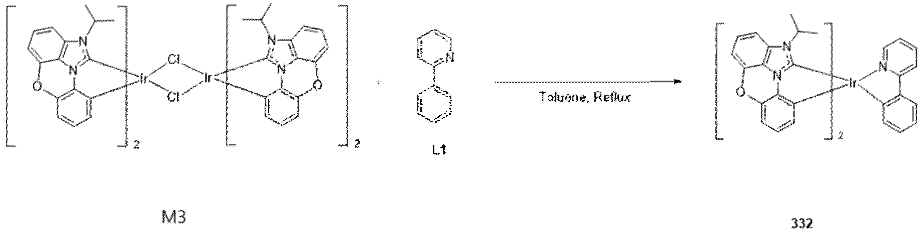

In a 250 mL round bottom flask and under a nitrogen atmosphere, iridium precursor M3 (2.18 g, 1.5 mmol) and the ligand L1 (0.47 g, 3 mmol) were dissolved in toluene (100 mL) and a reaction solution was stirred under reflux for 24 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of toluene:hexane = 1:1 to obtain the above iridium compound 332 (1.60 g, 63%).

### <Preparation of iridium compound 333>

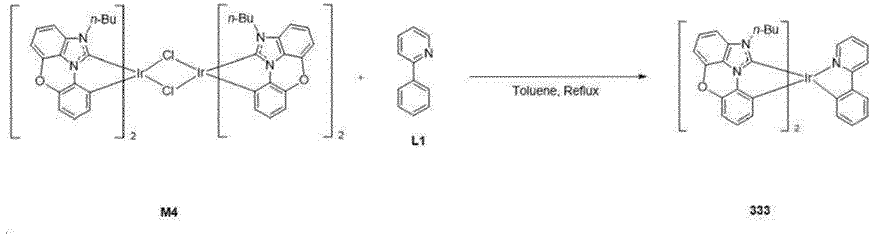

In a 250 mL round bottom flask and under a nitrogen atmosphere, iridium precursor M4 (2.26 g, 1.5 mmol) and the ligand L1 (0.47 g, 3 mmol) were dissolved in toluene (100 mL) and a reaction solution was stirred under reflux for 24 hours. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of toluene:hexane = 1:1 to obtain the above iridium compound 333 (1.78 g, 68%).

### <Preparation of iridium compound 351>

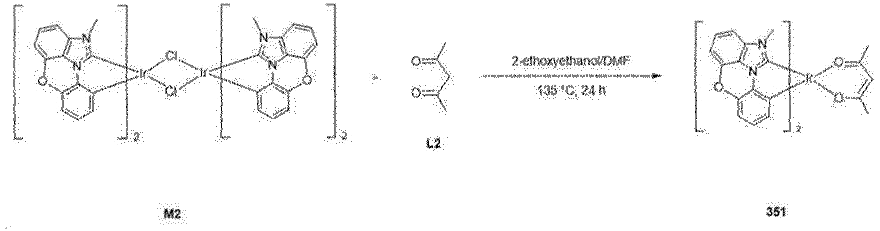

In a 150 mL round bottom flask and under a nitrogen atmosphere, iridium precursor M2 (2.01 g, 1.5 mmol) and the ligand L2 (0.30 g, 3 mmol) were dissolved in a mixed solvent (2-ethoxyethanol:DMF = 40mL:40mL) and a reaction solution was stirred under reflux for 24 hours at 135°C. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of toluene:hexane = 1:3 to obtain the above iridium compound 351 (1.41 g, 64%).

### <Preparation of iridium compound 352>

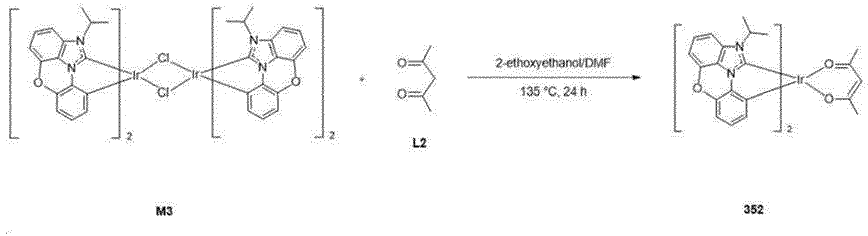

In a 150 mL round bottom flask and under a nitrogen atmosphere, iridium precursor M3 (2.18 g, 1.5 mmol) and the ligand L2 (0.30 g, 3 mmol) were dissolved in a mixed solvent (2-ethoxyethanol:DMF = 40mL:40mL) and a reaction solution was stirred under reflux for 24 hours at 135°C. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of toluene:hexane = 1:3 to obtain the above iridium compound 352 (1.73 g, 73%).

### <Preparation of iridium compound 353>

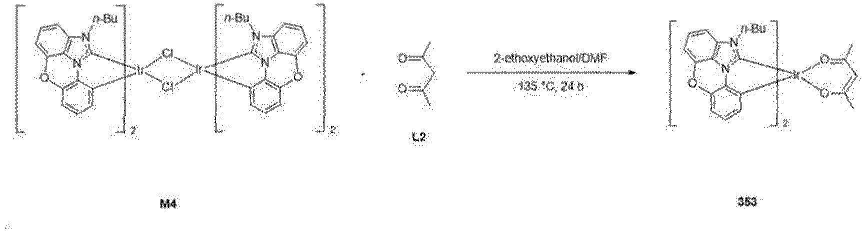

In a 150 mL round bottom flask and under a nitrogen atmosphere, iridium precursor M4 (2.26 g, 1.5 mmol) and the ligand L2 (0.30 g, 3 mmol) were dissolved in a mixed solvent (2-ethoxyethanol:DMF = 40mL:40mL) and a reaction solution was stirred under reflux for 24 hours at 135°C. When the reaction thereof was completed, a temperature was lowered to room temperature. Then, an organic layer was extracted therefrom using dichloromethane and distilled water, and moisture was removed therefrom by adding anhydrous magnesium sulfate thereto. A filtrate was obtained through filtration thereof and was depressurized to obtain a resulting crude product. The resulting crude product was purified using column chromatography under a condition of toluene:hexane = 1:3 to obtain the above iridium compound 353 (1.74 g, 71%).

### Present Examples

### <Present Example 1>

A glass substrate having a thin film made of ITO (indium tin oxide) of a thickness of 1,000 Å coated thereon was washed and was subjected to ultrasonic cleaning using acetone and was dried. HI-1 (N1,N1'-([1,1'-biphenyl]-4,4'-diyl)bis(N1,N4,N4-triphenylbenzene-1,4-diamine)) of a following structure as a hole injection material of a thickness of 60 nm was formed on the prepared ITO transparent electrode via thermal vacuum deposition. NPB as a hole transport material was thermally vacuum deposited to have a thickness of 80 nm on the hole injection layer. A light-emitting layer was thermally vacuum deposited on the hole transport material. In this regard, the light-emitting layer contains CBP of a following structure as a host material and the compound 1 as the dopant. A doping concentration was 5% and a thickness of the light emission layer was 30 nm. ET-1: Liq (1:1) (30 nm) as materials for the electron transport layer and the electron injection layer was thermally vacuum deposited on the light-emitting layer. Then, 100 nm thick aluminum was deposited thereon to form a negative electrode. Thus, an organic light-emitting diode was fabricated. The materials used in above Present Example 1 are as follows.

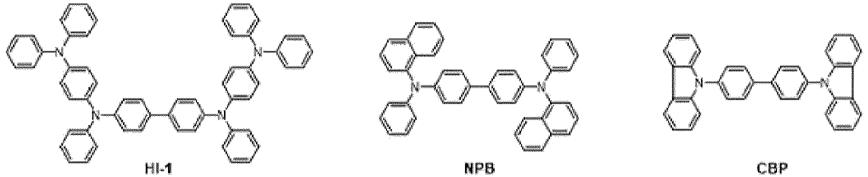

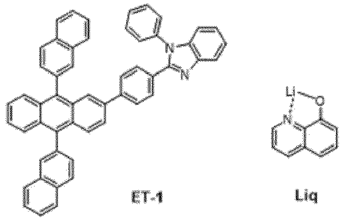

HI-1 means N1,N1'-([1,1'-biphenyl]-4,4'-diyl)bis(N1,N4,N4-triphenylbenzene-1,4-diamine).

ET-1 means 2-(4-(9,10-di(naphthalen-2-yl)anthracen-2-yl)phenyl)-1-phenyl-1H-benzo[d]imidazole.

### <Present Examples 2 to 9 and Comparative Examples 1 to 4 >

An organic light-emitting diode of each of Present Examples 2 to 9 and Comparative Examples 1 to 4 was manufactured in the same manner as in Present Example 1, except that each of compounds shown in a following Table 2 was used instead of the compound 1 as the dopant in Present Example 1.

**Table 2**

| Examples | Dopant | Operation voltage (V) | Maximum Luminous Quantum Efficiency (%, relative value) | EQE (%, relative value) | LT95 (%, relative value) |
|---|---|---|---|---|---|
| Comparative Example 1 | Ref-1 | 4.26 | 100 | 100 | 100 |
| Comparative Example 2 | Ref-2 | 4.25 | 108 | 106 | 104 |
| Comparative Example 3 | Ref-3 | 4.26 | 110 | 108 | 106 |
| Comparative Example 4 | Ref-4 | 4.27 | 112 | 109 | 108 |
| Present Example 1 | Compound 1 | 4.24 | 129 | 127 | 124 |
| Present Example 2 | Compound 2 | 4.23 | 130 | 129 | 127 |
| Present Example 3 | Compound 3 | 4.22 | 131 | 130 | 128 |
| Present Example 4 | Compound 46 | 4.21 | 130 | 128 | 126 |
| Present Example 5 | Compound 47 | 4.20 | 131 | 130 | 127 |
| Present Example 6 | Compound 48 | 4.23 | 135 | 132 | 130 |
| Present Example 7 | Compound 61 | 4.24 | 134 | 133 | 131 |
| Present Example 8 | Compound 62 | 4.23 | 132 | 131 | 130 |
| Present Example 9 | Compound 63 | 4.21 | 133 | 132 | 131 |

Structures of Ref-1 to Ref-4 as dopant materials of Comparative Examples 1 to 4 in Table 2 are as follows.

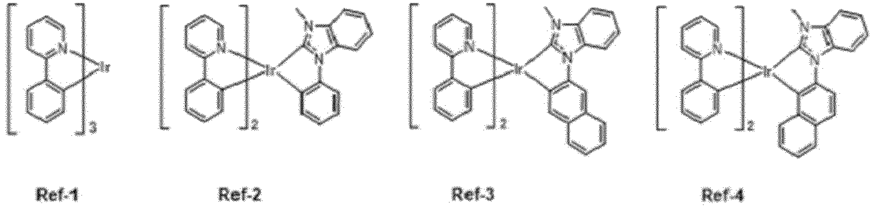

### <Present Examples 10 to 15 and Comparative Examples 5 to 7>

An organic light-emitting diode of each of Present Examples 10 to 15 and Comparative Examples 5 to 7 was manufactured in the same manner as in Present Example 1, except that each of compounds shown in a following Table 3 was used instead of the compound 1 as the dopant in Present Example 1.

**Table 3**

| Examples | Dopant | Operation voltage (V) | Maximum Luminous Quantum Efficiency (%, relative value) | EQE (%, relative value) | LT95 (%, relative value) |
|---|---|---|---|---|---|
| Comparative Example 5 | Ref-5 | 4.24 | 100 | 100 | 100 |
| Comparative Example 6 | Ref-6 | 4.25 | 110 | 107 | 109 |
| Comparative Example 7 | Ref-7 | 4.26 | 109 | 108 | 110 |
| Present Example 10 | Compound 331 | 4.25 | 125 | 124 | 125 |
| Present Example 11 | Compound 332 | 4.26 | 123 | 121 | 121 |
| Present Example 12 | Compound 333 | 4.23 | 121 | 120 | 119 |
| Present Example 13 | Compound 351 | 4.21 | 124 | 122 | 126 |
| Present Example 14 | Compound 352 | 4.23 | 126 | 125 | 128 |
| Present Example 15 | Compound 353 | 4.22 | 124 | 121 | 125 |

Structures of Ref-5 to Ref-7 as dopant materials of Comparative Examples 5 to 7 in Table 3 are as follows.

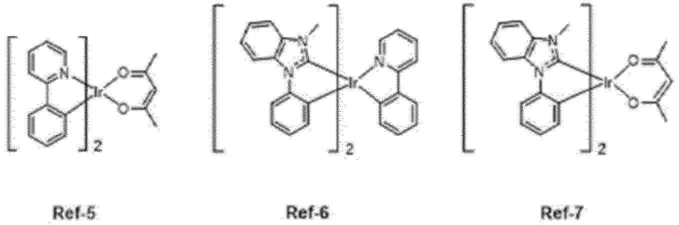

### <Present Examples 16 to 20 >

An organic light-emitting diode of each of Present Examples 16 to 20 was manufactured in the same manner as in Present Example 1 except that each of compounds shown in a following Table 4 was used instead of CBP as the host in Present Example 1.

**Table 4**

| Examples | Dopant | Host | Operation voltage (V) | Maximum Luminous Quantum Efficiency (%, relative value) | EQE (%, relative value) | LT95 (%, relative value) |
|---|---|---|---|---|---|---|
| Present Example 16 | Compound 1 | GH1 | 4.21 | 131 | 129 | 125 |
| Present Example 17 | Compound 1 | GH2 | 4.20 | 132 | 130 | 127 |
| Present Example 18 | Compound 1 | GH3 | 4.22 | 130 | 128 | 125 |
| Present Example 19 | Compound 1 | GH4 | 4.23 | 131 | 128 | 126 |
| Present Example 20 | Compound 1 | GH5 | 4.22 | 129 | 127 | 124 |

Structures of GH1 to GH5 as host materials of Present Examples 16 to 20 of the Table 4 are as follows, and compound names thereof are described in the above Table 1.

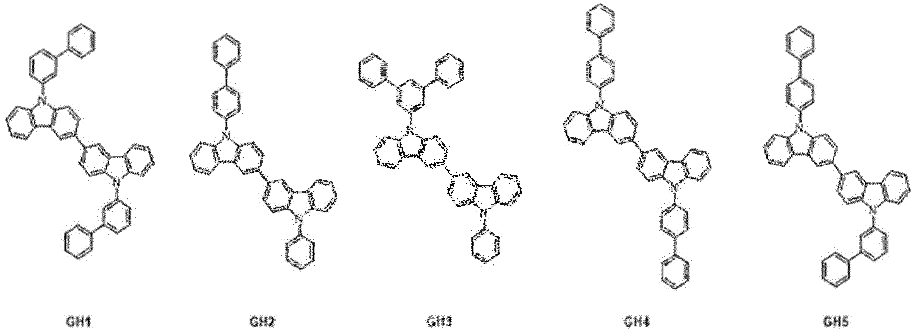

### <Present Examples 21 to 25>

An organic light-emitting diode of each of Present Examples 21 to 25 was manufactured in the same manner as in Present Example 4 except that each of compounds shown in a following Table 5 was used instead of CBP as the host in Present Example 4. The structures of the host materials GH1 to GH5 are the same as those described above with reference to Present Examples 16 to 20.

**Table 5**

| Examples | Dopant | Host | Operation voltage (V) | Maximum Luminous Quantum Efficiency (%, relative value) | EQE (%, relative value) | LT95 (%, relative value) |
|---|---|---|---|---|---|---|
| Present Example 21 | Compound 46 | GH1 | 4.20 | 132 | 130 | 127 |
| Present Example 22 | Compound 46 | GH2 | 4.19 | 133 | 131 | 128 |
| Present Example 23 | Compound 46 | GH3 | 4.20 | 131 | 129 | 126 |
| Present Example 24 | Compound 46 | GH4 | 4.21 | 132 | 128 | 128 |
| Present Example 25 | Compound 46 | GH5 | 4.20 | 130 | 128 | 127 |

It may be identified from the results of the above Table 2 and Table 3 that in the organic light-emitting diode in which the organometallic compound of each of Present Examples 1 to 15 which satisfies the Chemical Formula 1 according to the present disclosure is used as the dopant of the light-emitting layer of the diode, the operation voltage of the diode is lowered, the maximum luminous quantum efficiency, external quantum efficiency (EQE) and lifetime (LT95) of the diode are improved, compared to those in each of Comparative Examples 1 to 7.

## Claims

1. An organometallic compound represented by a following Chemical Formula 1:
[Chemical Formula 1] Ir(L_{A})ₘ(L_{B})ₙ
where in the Chemical Formula 1, L_{A} represents a main ligand, and is one selected from a group consisting of following Chemical Formula 2-1, Chemical Formula 2-2, and Chemical Formula 2-3,
L_{B} denotes an ancillary ligand represented by a following Chemical Formula 3,
each of m and n denotes a number of the ligands bound to Ir (iridium), and m is 1, 2 or 3, and n is 0, 1 or 2, and a sum of m and n is 3, 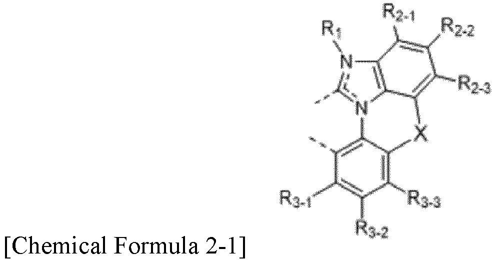 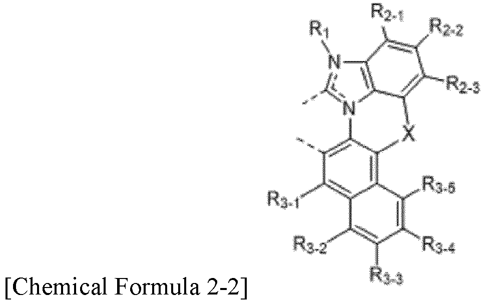 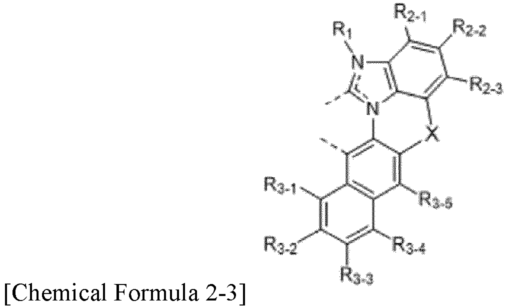 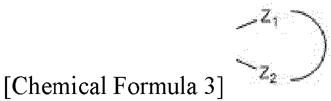
wherein in each of the Chemical Formulas 2-1 to 2-3, X independently represents one selected from a group consisting of oxygen, sulfur, C(R)₂ and NR,
each of R, R₁, R₂₋₁, R₂₋₂, R₂₋₃, R₃₋₁, R₃₋₂, R₃₋₃, R₃₋₄ and R₃₋₅ independently represents one selected from a group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, and phosphino,
in each of the Chemical Formulas 2-1 to 2-3, two functional groups adjacent to each other among R₂₋₁, R₂₋₂ and R₂₋₃ may be combined with each other to form a ring structure, and two functional groups adjacent to each other among R₃₋₁, R₃₋₂, R₃₋₃, R₃₋₄ and R₃₋₅ may be combined with each other to form a ring structure,
wherein the ancillary ligand represented by the Chemical Formula 3 is a bidentate ligand, and the bidentate ligand is represented by a following Chemical Formula 4 or a following Chemical Formula 5: 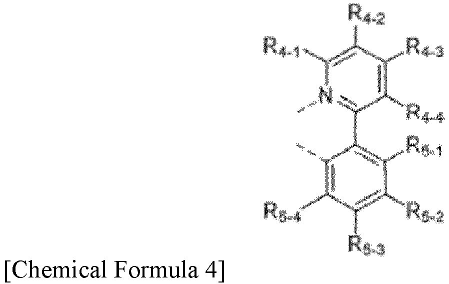 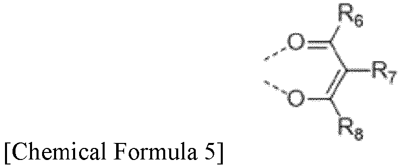
wherein in the Chemical Formula 4, each of R₄₋₁, R₄₋₂, R₄₋₃, R₄₋₄, R₅₋₁, R₅₋₂, R₅₋₃ and R₅₋₄ independently represents one selected from a group consisting of hydrogen, deuterium, a C1 to C5 linear alkyl group, and C1 to C5 branched alkyl group, wherein the C1 to C5 linear alkyl group or the C1 to C5 branched alkyl group may be substituted with at least one selected from deuterium and a halogen element,
two functional groups adjacent to each other among R₄₋₁, R₄₋₂, R₄₋₃ and R₄₋₄ may be combined with each other to form a ring structure, and two functional groups adjacent to each other among R₅₋₁, R₅₋₂, R₅₋₃ and R₅₋₄ may be combined with each other to form a ring structure,
wherein in the Chemical Formula 5, each of R₆, R₇ and R₈ independently represents one selected from a group consisting of hydrogen, deuterium, C1 to C5 linear alkyl group and C1 to C5 branched alkyl group, wherein the C1 to C5 linear alkyl group or the C1 to C5 branched alkyl group may be substituted with at least one selected from deuterium and a halogen element,
two functional groups adjacent to each other among R₆, R₇ and R₈ may combine with each other to form a ring structure,
wherein the compound represented by the Chemical Formula 1 includes one selected from a group consisting of following compounds 1 to 370:

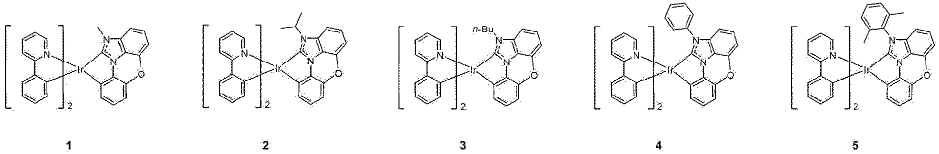

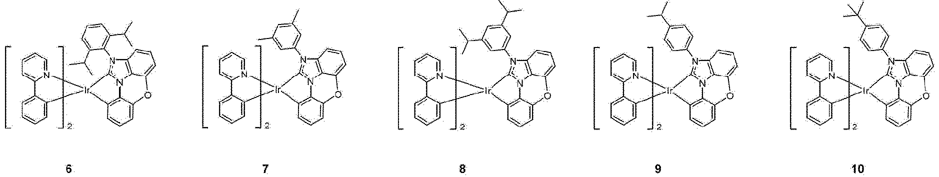

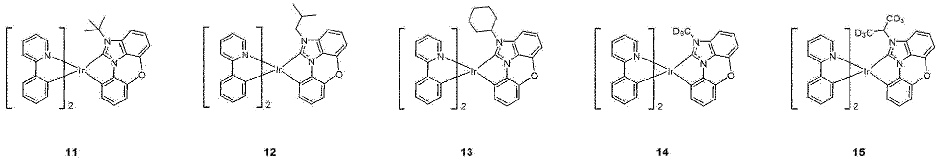

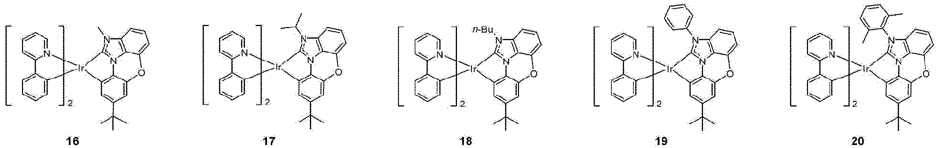

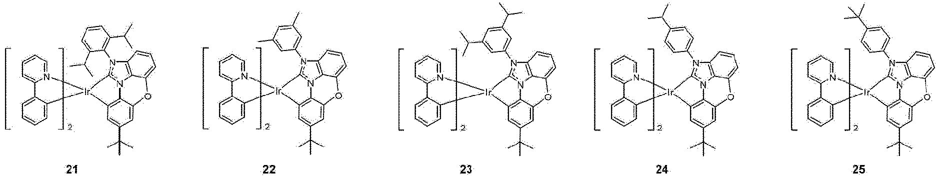

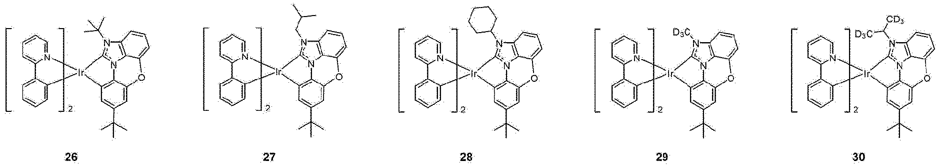

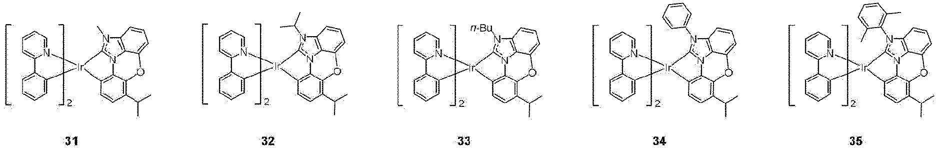

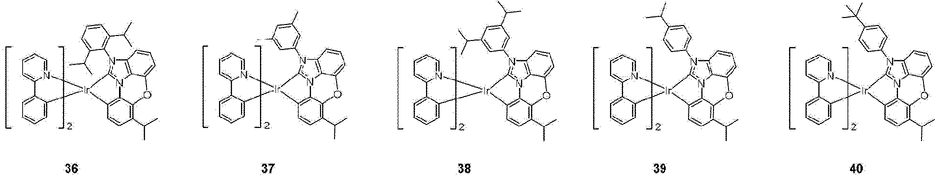

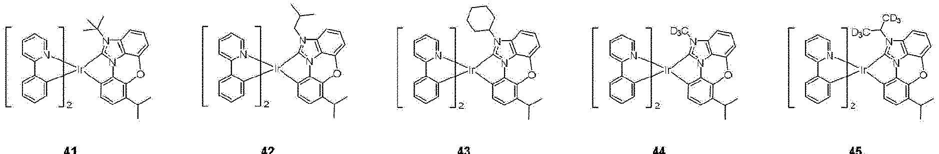

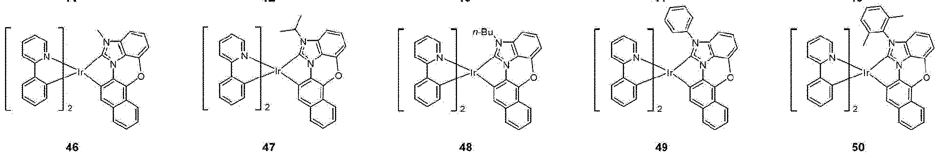

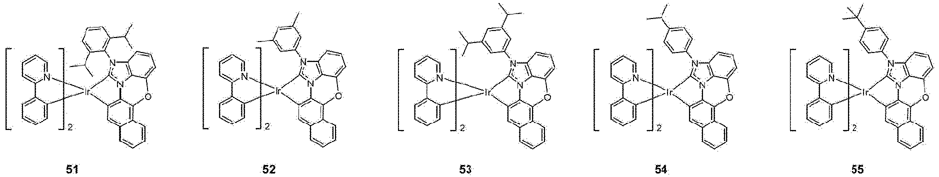

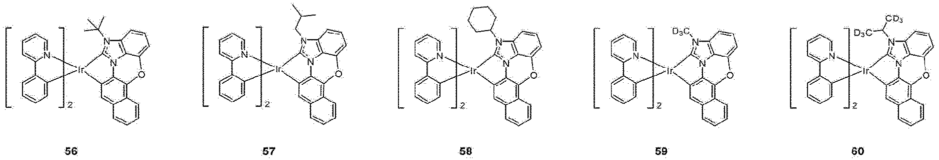

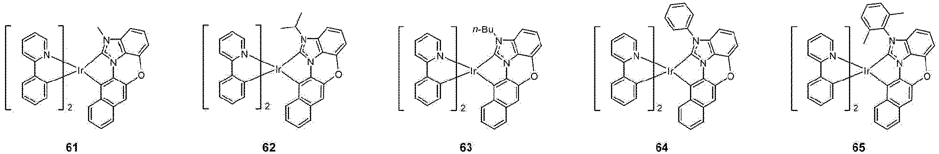

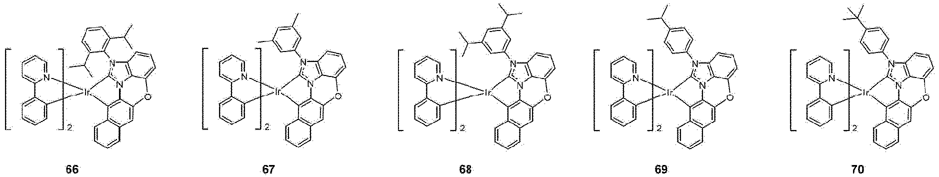

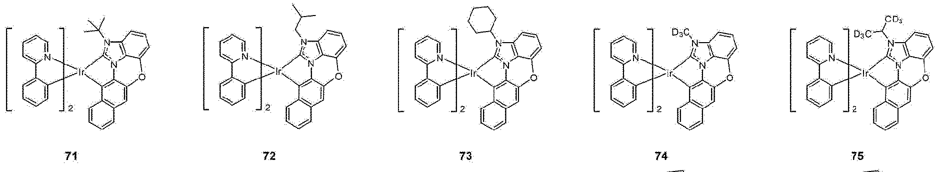

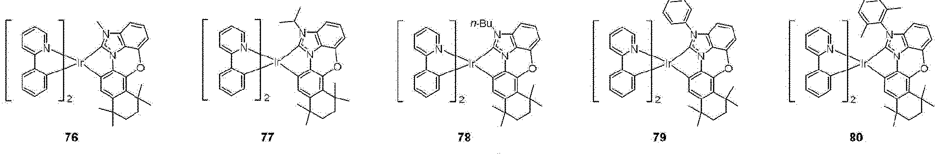

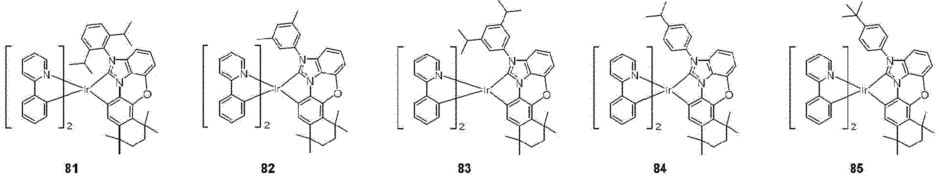

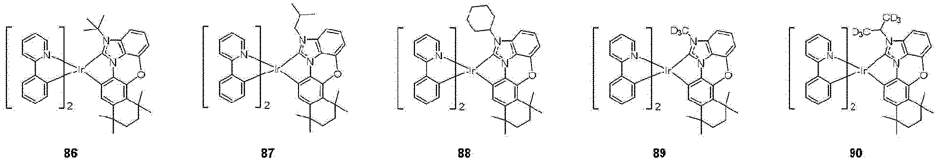

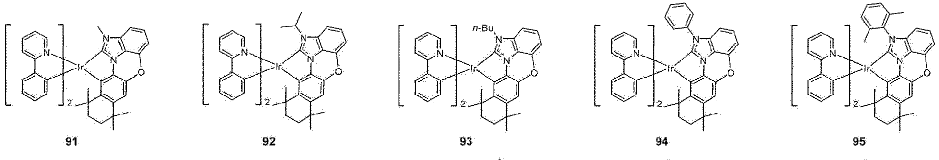

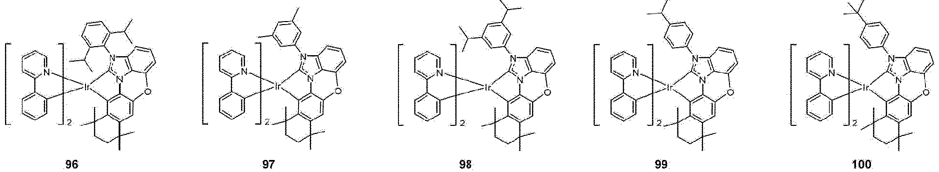

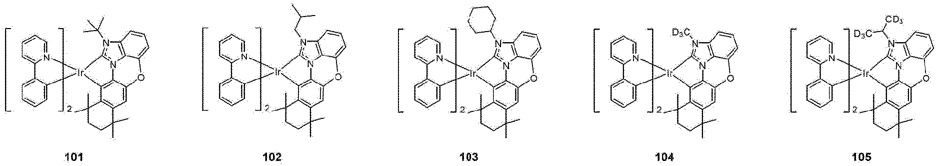

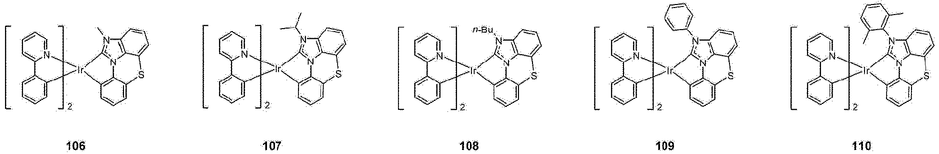

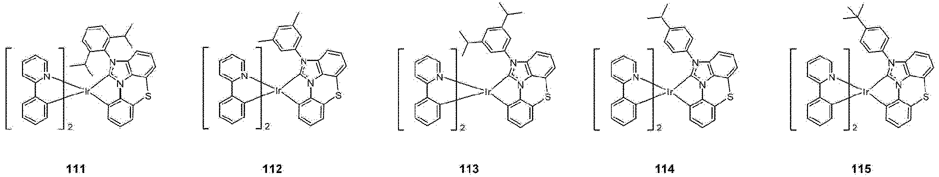

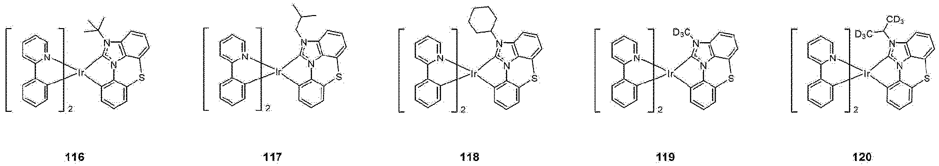

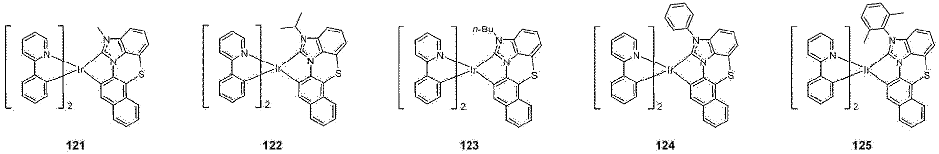

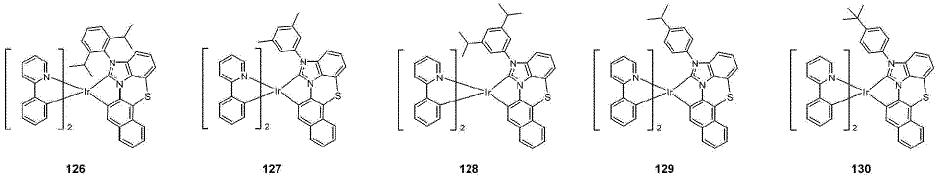

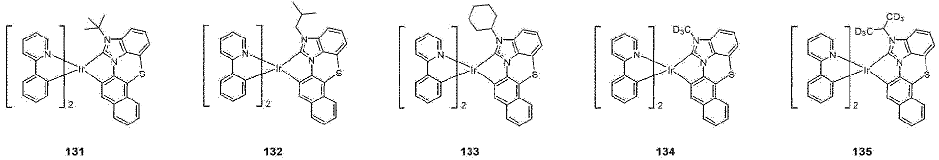

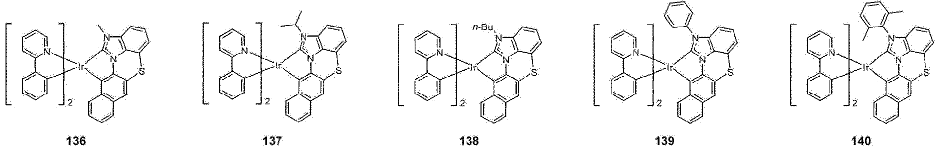

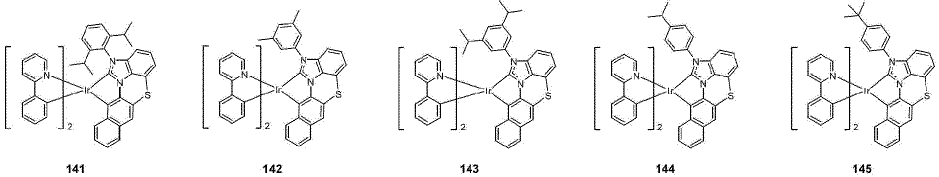

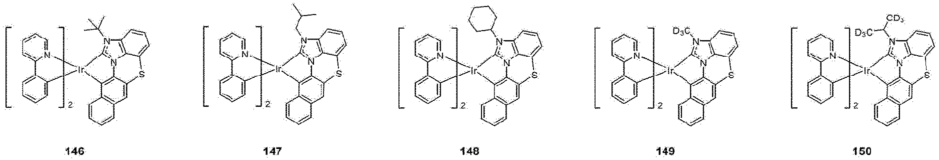

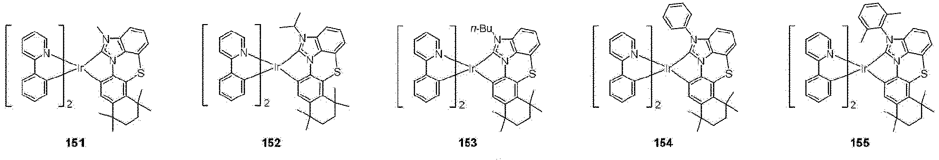

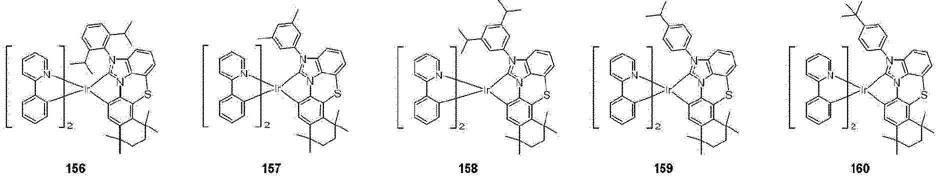

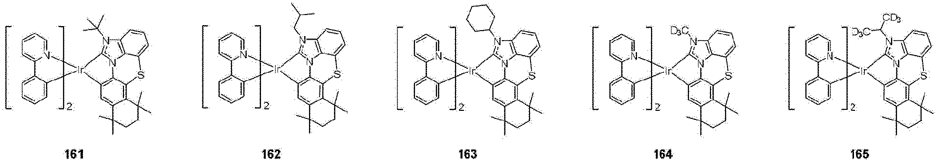

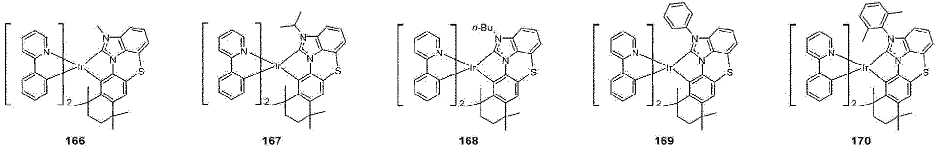

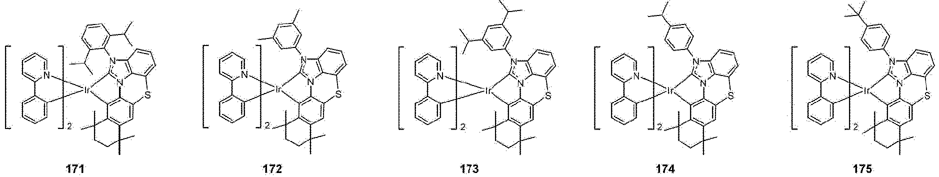

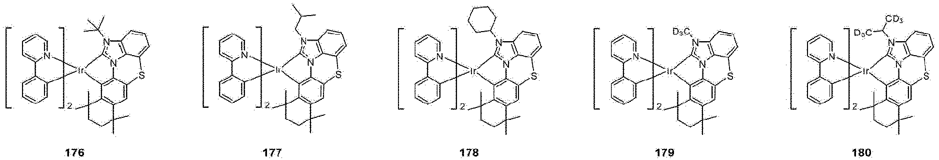

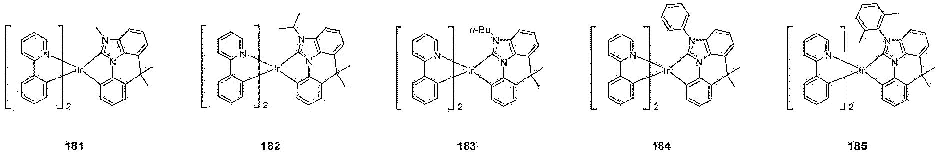

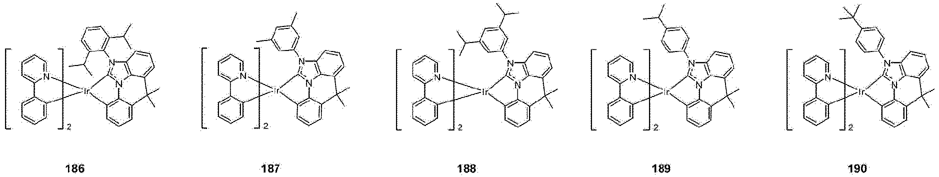

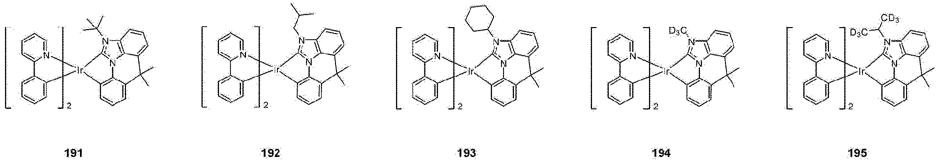

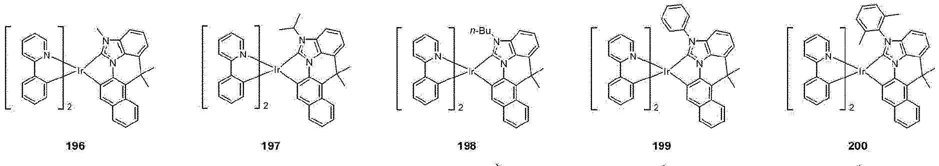

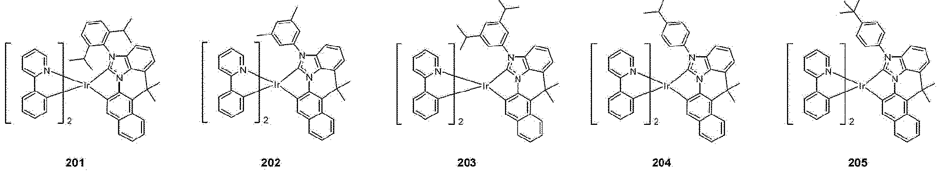

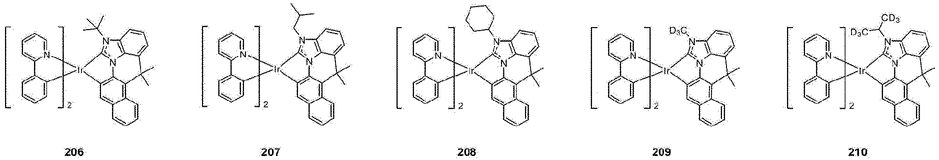

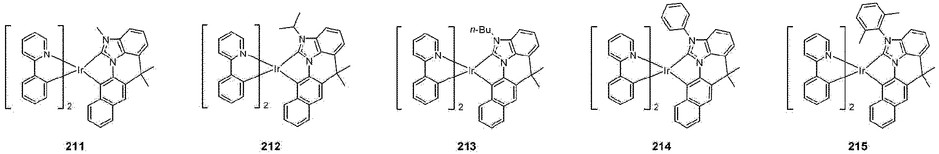

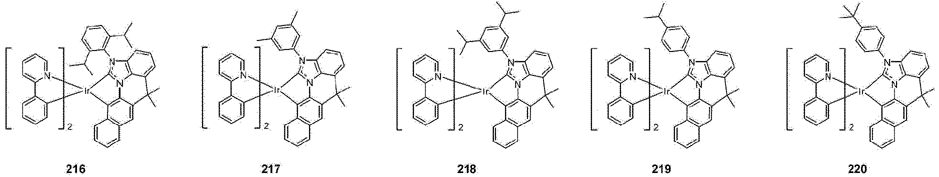

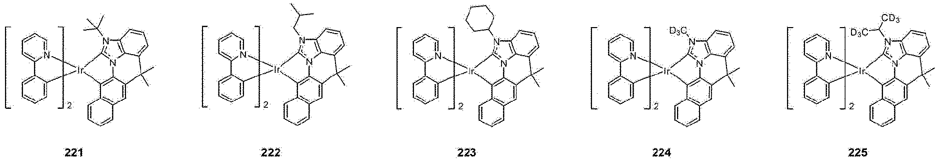

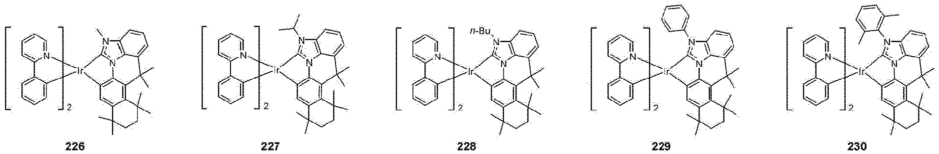

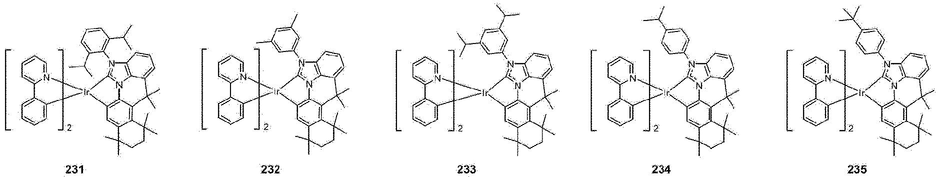

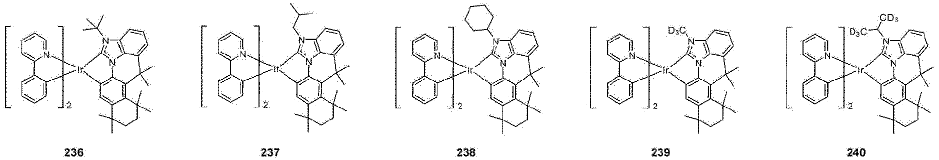

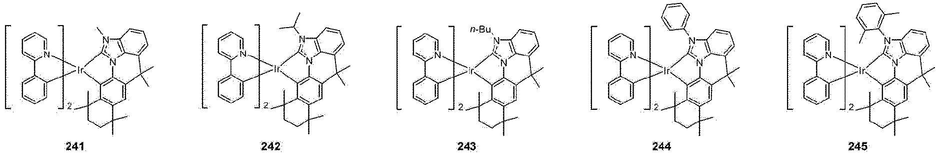

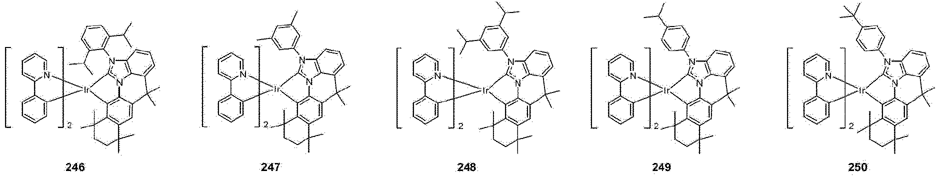

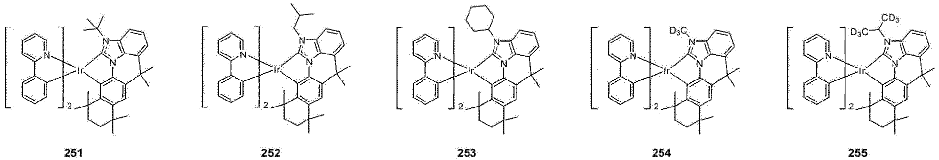

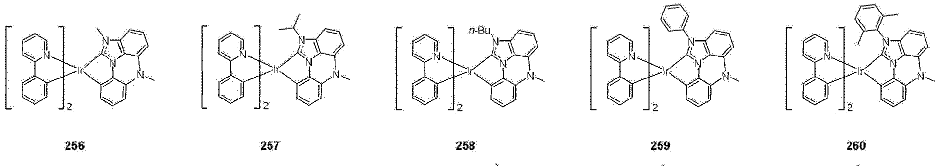

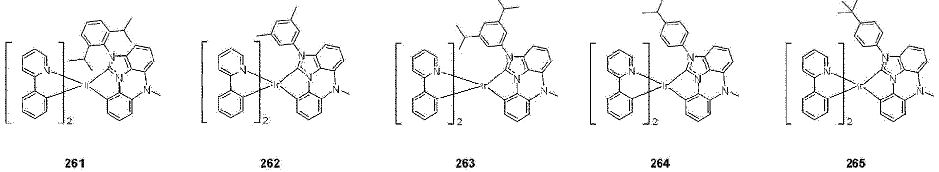

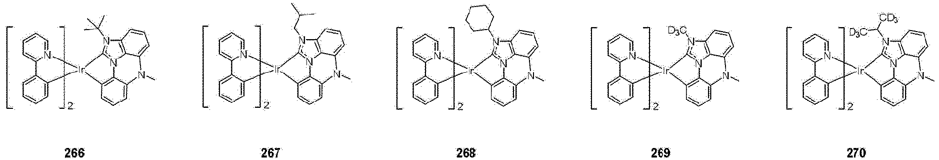

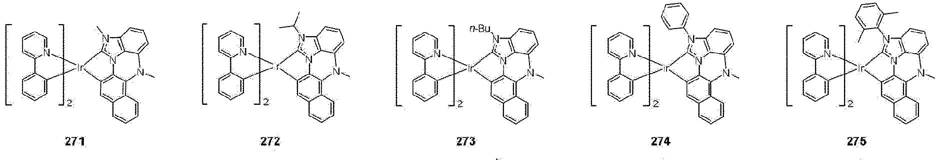

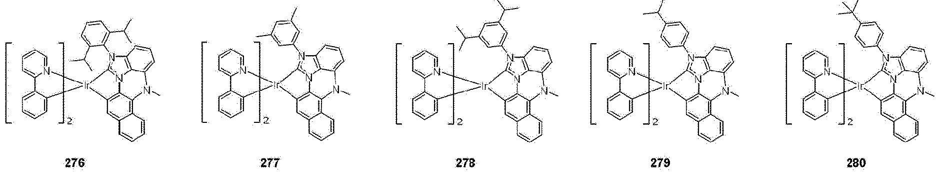

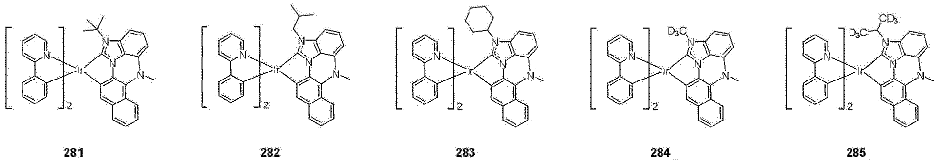

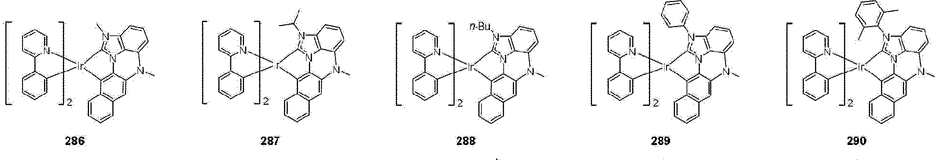

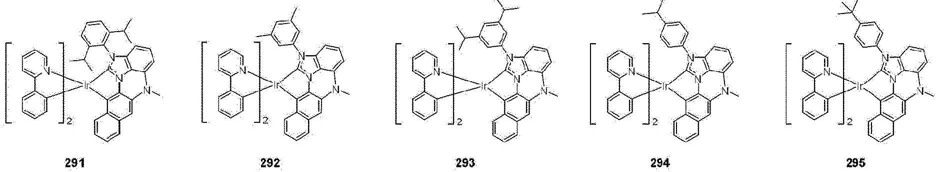

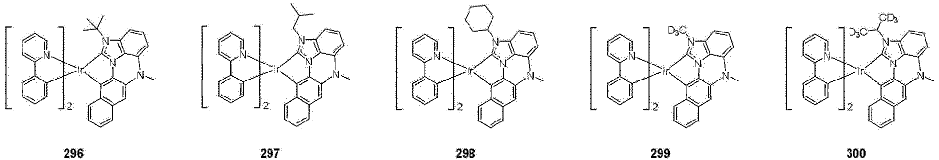

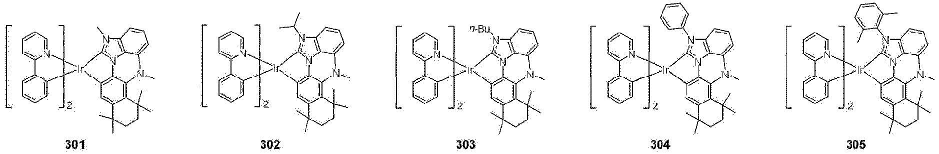

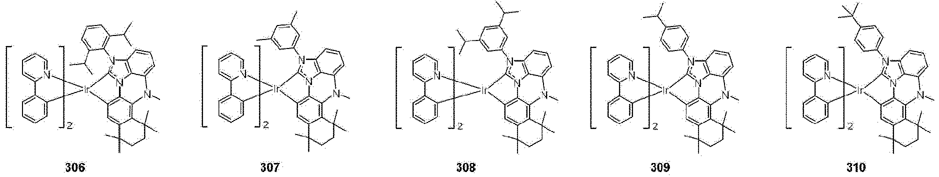

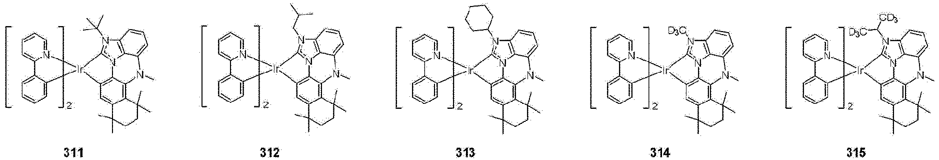

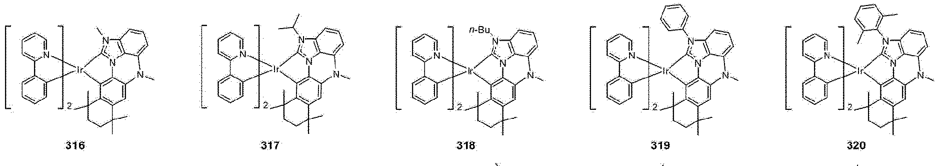

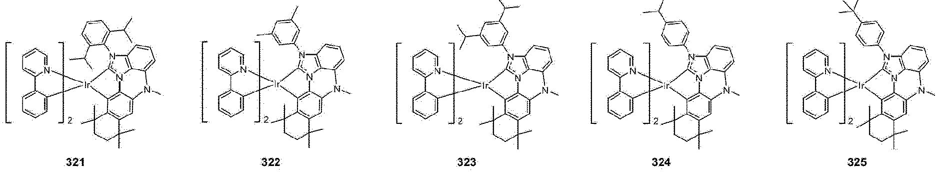

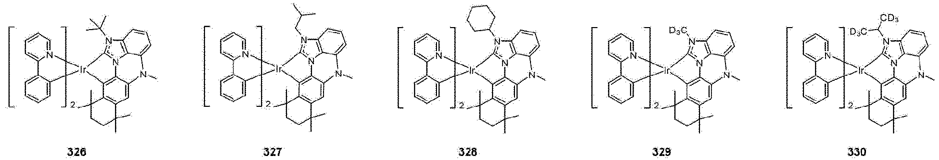

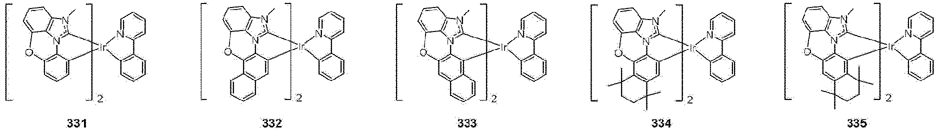

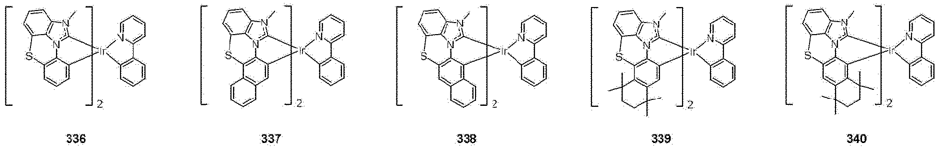

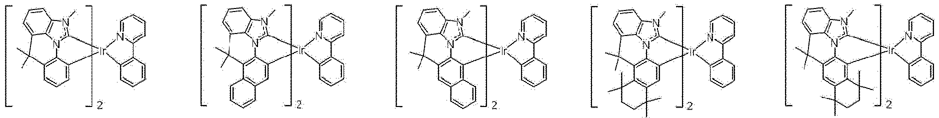

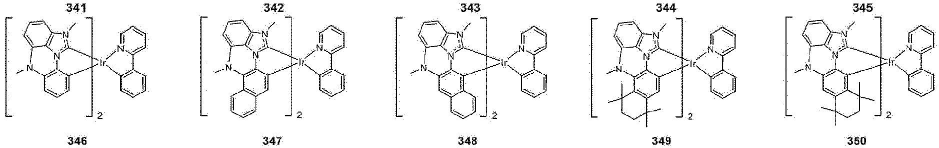

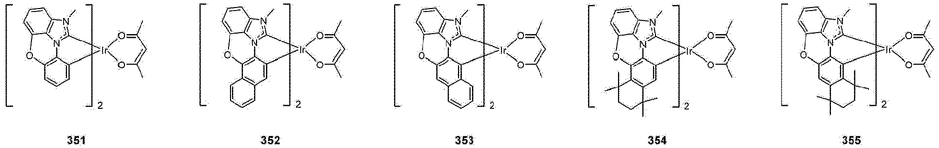

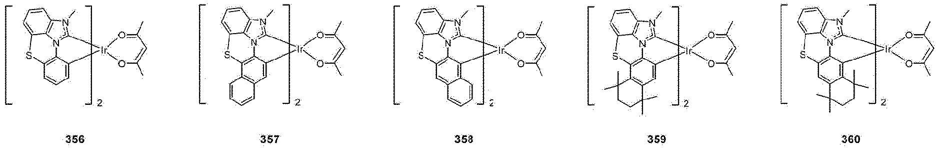

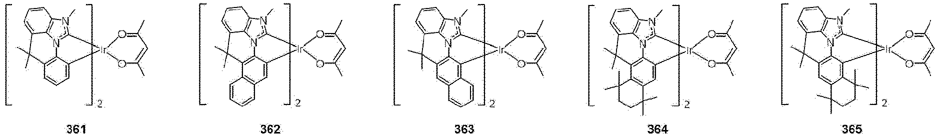

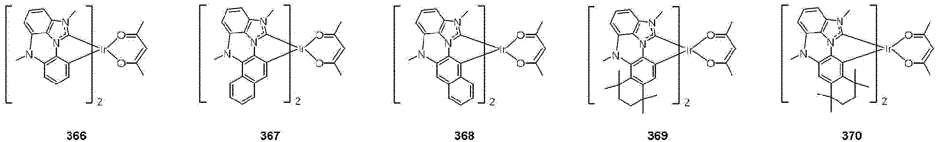

2. The organometallic compound of claim 1, wherein the compound represented by the Chemical Formula 1 is used as a green phosphorescent material.

3. An organic light-emitting diode comprising:
a first electrode;
a second electrode facing the first electrode; and
an organic layer disposed between the first electrode and the second electrode;
wherein the organic layer includes a light-emitting layer,
wherein the light-emitting layer contains the organometallic compound according to claim 1 or 2.

4. The organic light-emitting diode of claim 3, wherein the organometallic compound is used as dopant of the light-emitting layer.

5. The organic light-emitting diode of claim 3 or 4, wherein a host material of the light-emitting layer includes a compound containing a carbazole group.

6. The organic light-emitting diode of claim 5, wherein the compound containing the carbazole group includes at least one selected from compounds of following structures:

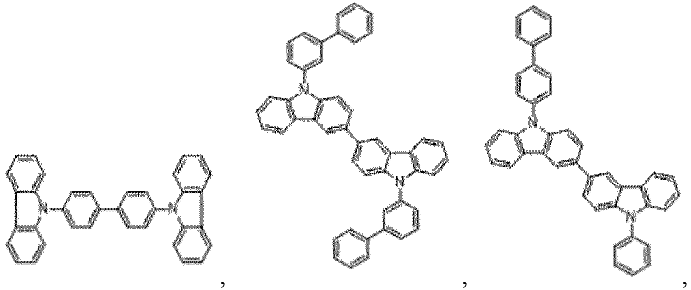

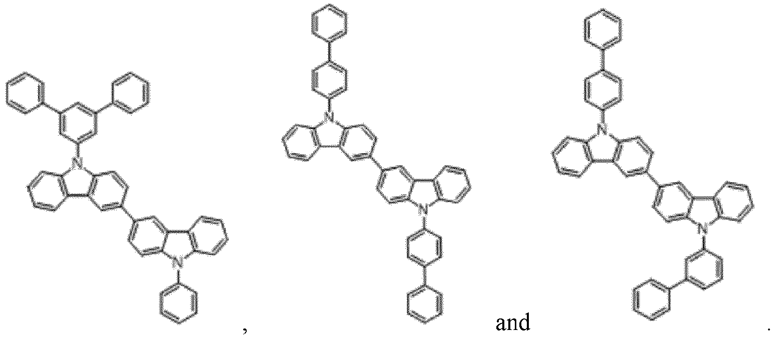

7. The organic light-emitting diode of any one of claims 3 to 6, wherein the organic layer further includes at least one selected from a group consisting of a hole injection layer, a hole transport layer, an electron transport layer and an electron injection layer.

8. An organic light-emitting display device comprising:
a substrate;
a driving element positioned on the substrate; and
an organic light-emitting element disposed on the substrate and connected to the driving element, wherein the organic light-emitting element includes the organic light-emitting diode according to any one of claims 3 to 7.

## Patentansprüche

1. Organometallische Verbindung, die durch eine folgende chemische Formel 1 dargestellt ist:
[Chemische Formel 1] Ir(L_{A})ₘ(L_{B})ₙ,
wobei in der chemischen Formel 1 L_{A} einen Hauptliganden darstellt und einer ist, der aus einer Gruppe ausgewählt ist, die aus der folgenden chemischen Formel 2-1, chemischen Formel 2-2 und chemischen Formel 2-3 besteht,
L_{B} einen Hilfsliganden bezeichnet, der durch eine folgende chemische Formel 3 dargestellt ist,
jedes von m und n eine Anzahl der Liganden bezeichnet, die an Ir (Iridium) gebunden sind, und m 1, 2 oder 3 ist, und n 0, 1 oder 2 ist, und eine Summe von m und n 3 ist, 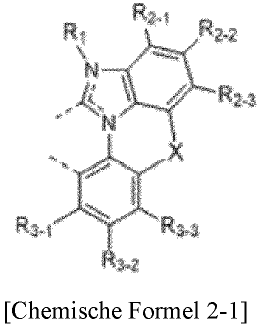 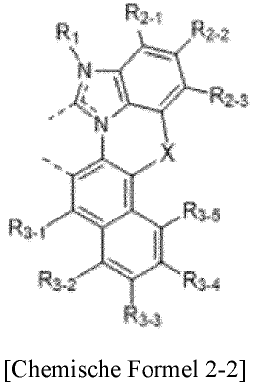 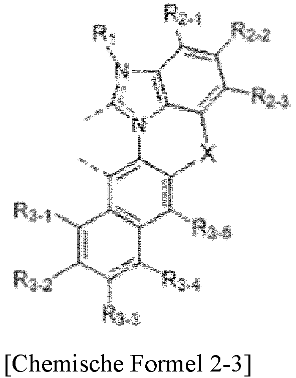 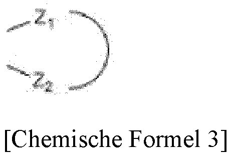
wobei in jeder der chemischen Formeln 2-1 bis 2-3 X unabhängig eines darstellt, das aus einer Gruppe ausgewählt ist, die aus Sauerstoff, Schwefel, C(R)₂ und NR besteht,
jedes von R, R₁, R₂₋₁, R₂₋₂, R₂₋₃, R₃₋₁, R₃₋₂, R₃₋₃, R₃₋₄ und R₃₋₅ unabhängig eines darstellt, das aus einer Gruppe ausgewählt ist, die aus Wasserstoff, Deuterium, Halogenid, Alkyl, Cycloalkyl, Heteroalkyl, Arylalkyl, Alkoxy, Aryloxy, Amino, Silyl, Alkenyl, Cycloalkenyl, Heteroalkenyl, Alkynyl, Aryl, Heteroaryl, Acyl, Carbonyl, Carbonsäure, Ester, Nitril, Isonitril, Sulfanyl, Sulfinyl, Sulfonyl und Phosphino besteht,
in jeder der chemischen Formeln 2-1 bis 2-3 zwei funktionale Gruppen, die zueinander benachbart sind, unter R₂₋₁, R₂₋₂ und R₂₋₃ miteinander kombiniert werden können, um eine Ringstruktur zu bilden, und zwei funktionale Gruppen, die zueinander benachbart sind, unter R₃₋₁, R₃₋₂, R₃₋₃, R₃₋₄ und R₃₋₅ miteinander kombiniert werden können, um eine Ringstruktur zu bilden,
wobei der durch die chemische Formel 3 dargestellte Hilfsligand ein zweizähniger Ligand ist und der zweizähnige Ligand durch eine folgende chemische Formel 4 oder eine folgende chemische Formel 5 dargestellt ist: 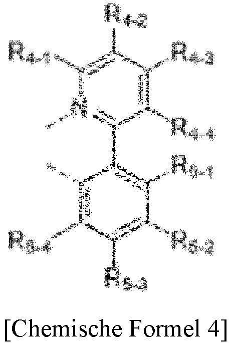 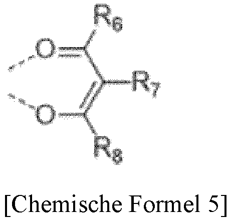 wobei in der chemischen Formel 4 jedes von R₄₋₁, R₄₋₂, R₄₋₃, R₄₋₄, R₅₋₁, R₅₋₂, R₅₋₃ und R₅₋₄ unabhängig eines darstellt, das aus einer Gruppe ausgewählt ist, die aus Wasserstoff, Deuterium, einer linearen C1- bis C5-Alkylgruppe und einer verzweigten C1-bis C5-Alkylgruppe besteht, wobei die lineare C1- bis C5-Alkylgruppe oder die verzweigte C1- bis C5-Alkylgruppe mit mindestens einem substituiert sein kann, das aus Deuterium und einem Halogenelement ausgewählt ist,
zwei funktionale Gruppen, die zueinander benachbart sind, unter R₄₋₁, R₄₋₂, R₄₋₃ und R₄₋₄ miteinander kombiniert werden können, um eine Ringstruktur zu bilden, und zwei funktionale Gruppen, die zueinander benachbart sind, unter R₅₋₁, R₅₋₂, R₅₋₃ und R₅₋₄ miteinander kombiniert werden können, um eine Ringstruktur zu bilden,
wobei in der chemischen Formel 5 jedes von R₆, R₇ und R₈ unabhängig eines darstellt, das aus einer Gruppe ausgewählt ist, die aus Wasserstoff, Deuterium, einer linearen C1- bis C5-Alkylgruppe und einer verzweigten C1- bis C5-Alkylgruppe besteht, wobei die lineare C1- bis C5-Alkylgruppe oder die verzweigte C1- bis C5-Alkylgruppe mit mindestens einem substituiert sein kann, das aus Deuterium und einem Halogenelement ausgewählt ist,
zwei funktionale Gruppen, die zueinander benachbart sind, unter R₆, R₇ und R₈ miteinander kombinieren können, um eine Ringstruktur zu bilden,
wobei die durch die chemische Formel 1 dargestellte Verbindung eine Verbindung umfasst, die aus einer Gruppe ausgewählt ist, die aus den folgenden Verbindungen 1 bis 370 besteht:

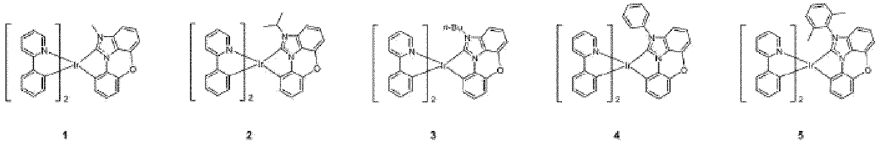

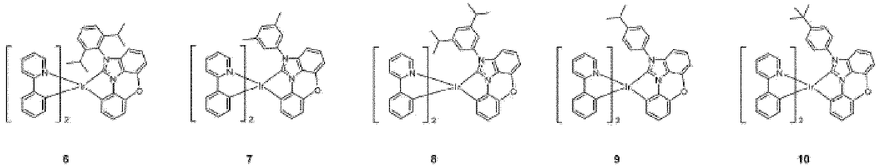

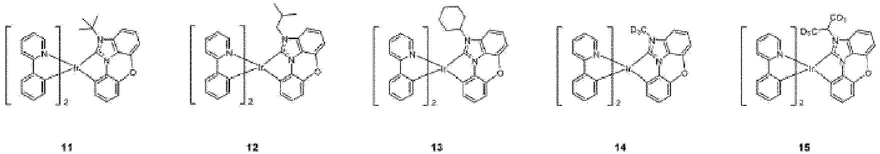

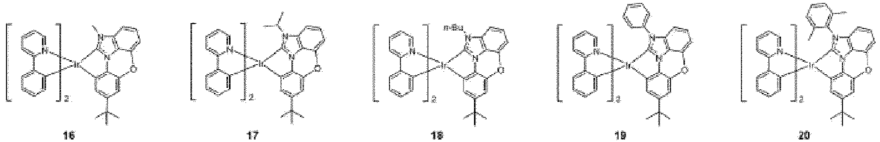

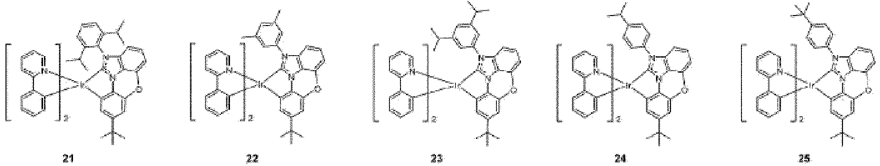

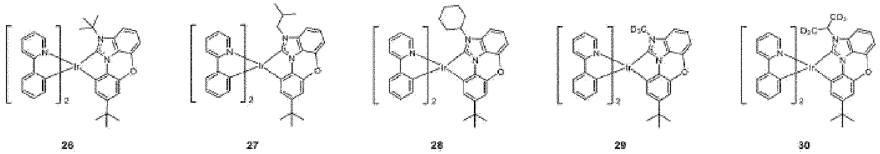

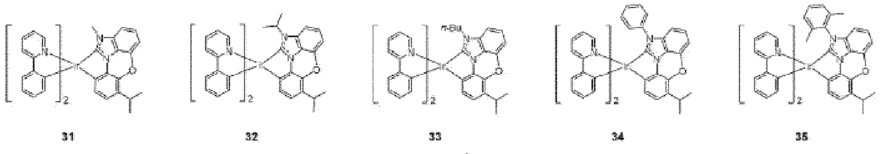

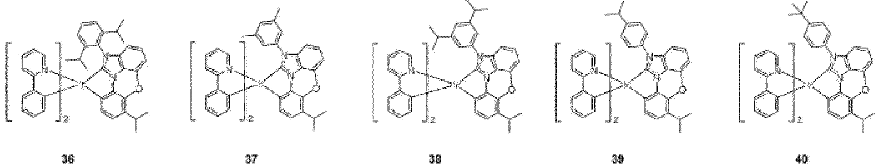

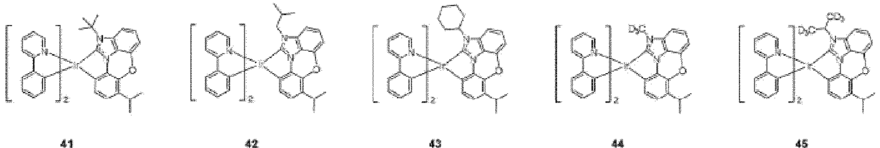

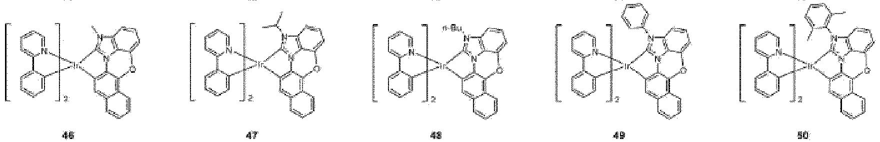

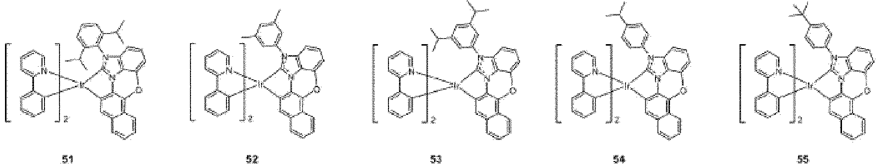

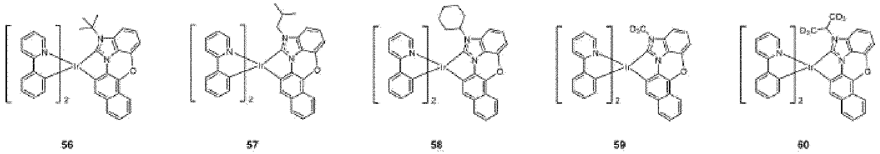

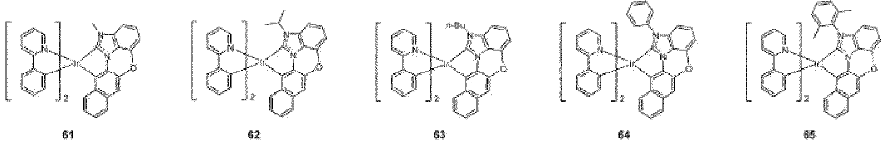

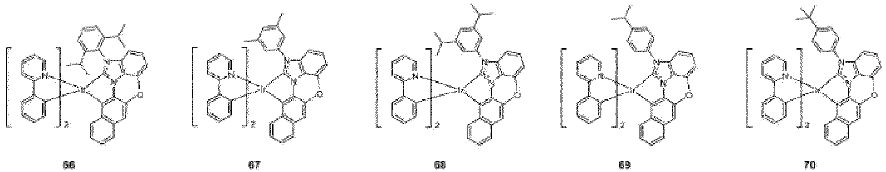

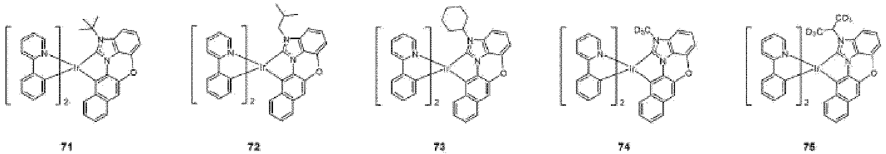

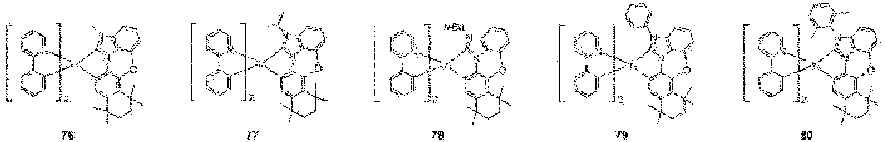

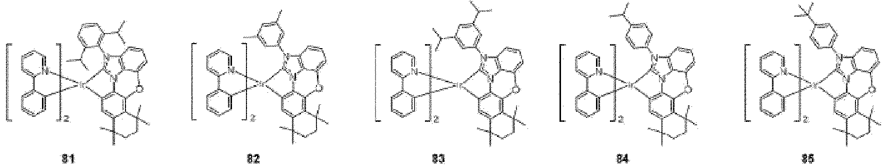

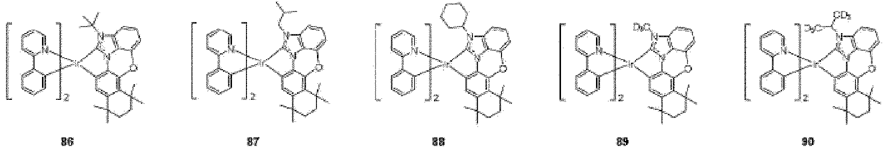

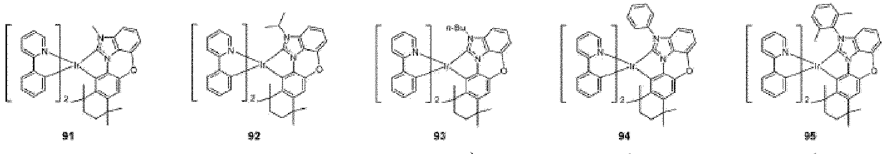

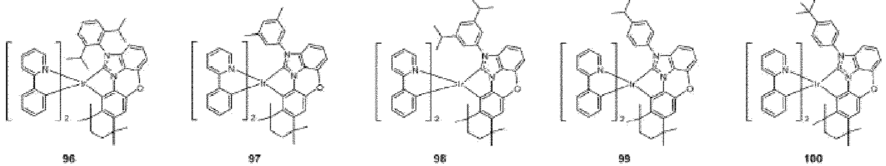

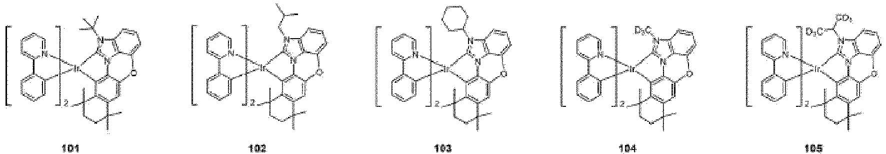

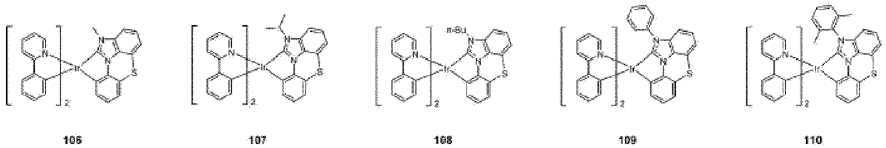

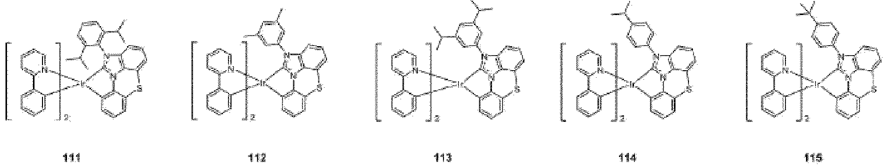

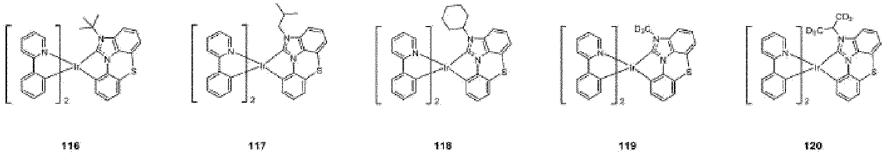

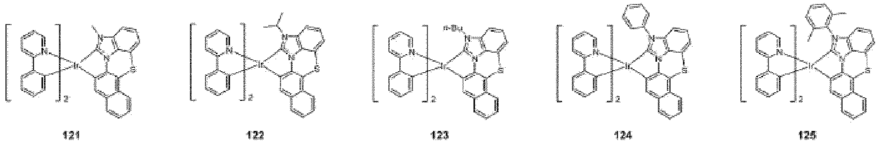

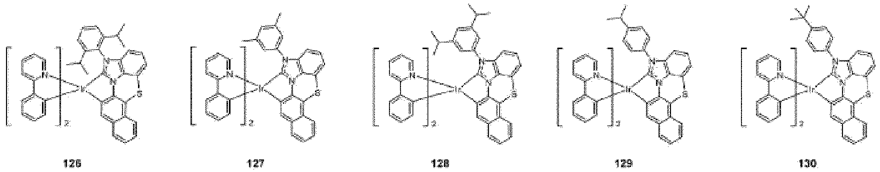

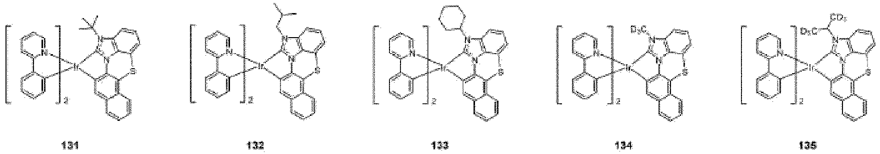

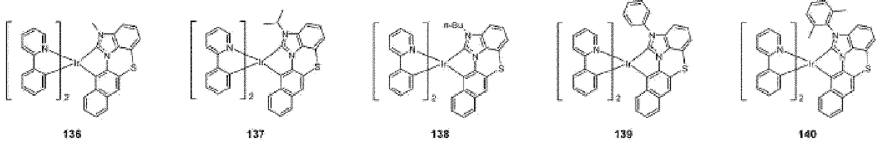

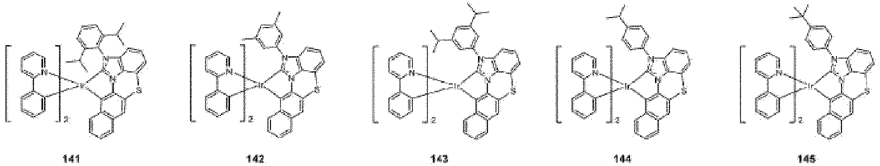

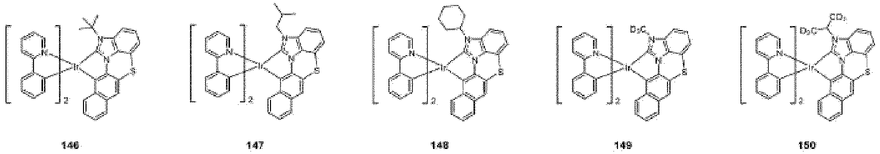

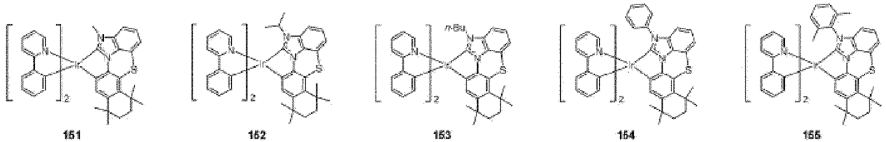

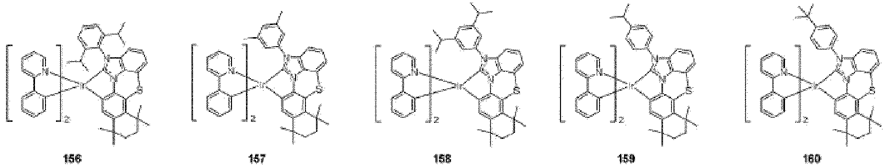

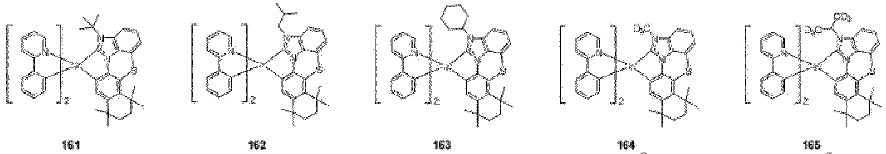

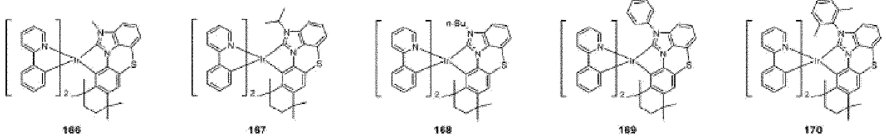

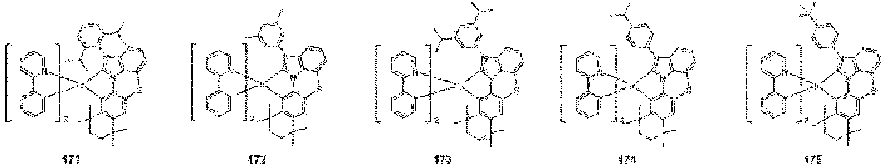

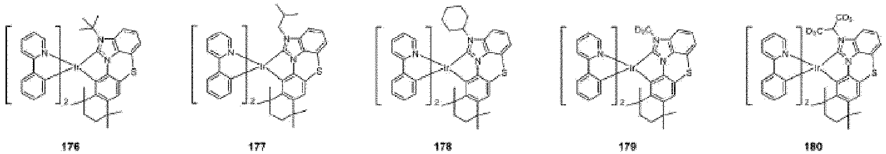

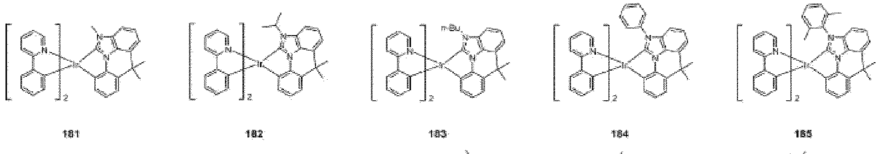

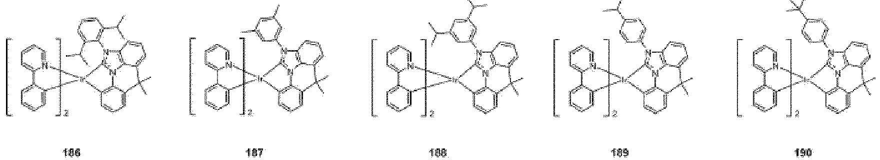

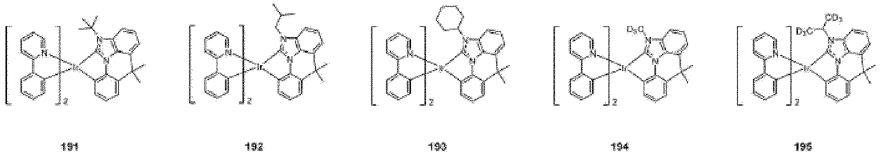

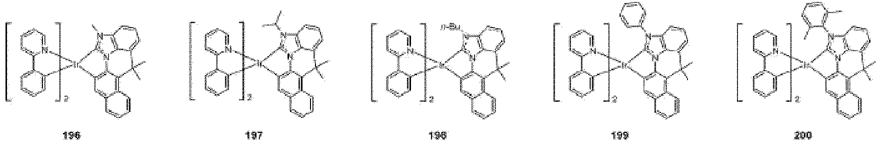

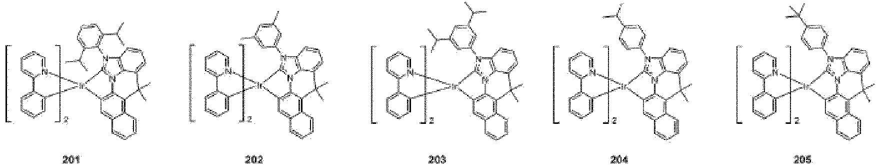

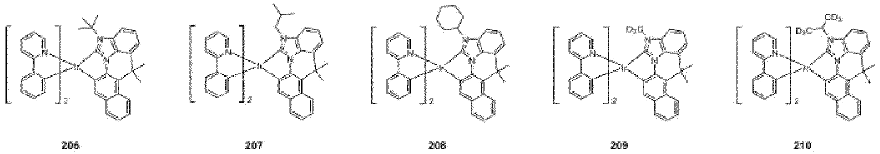

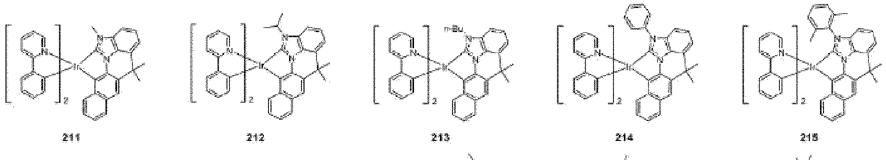

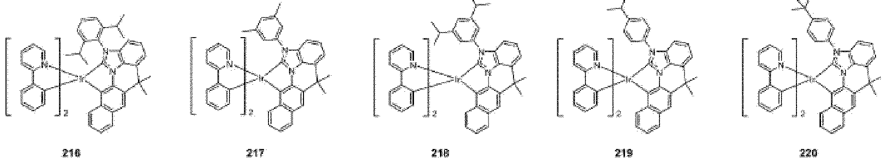

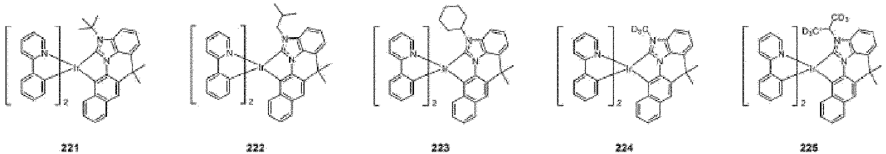

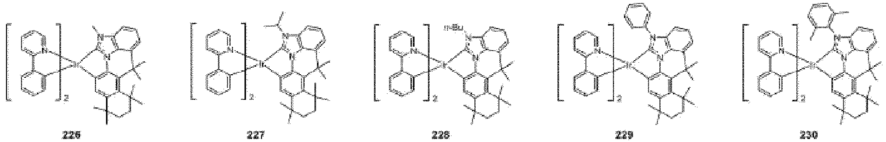

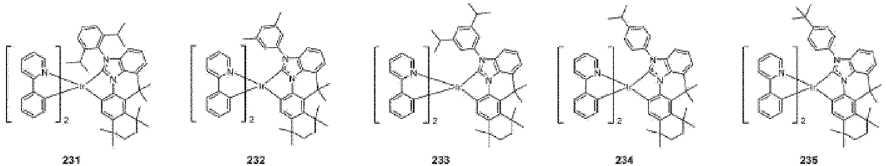

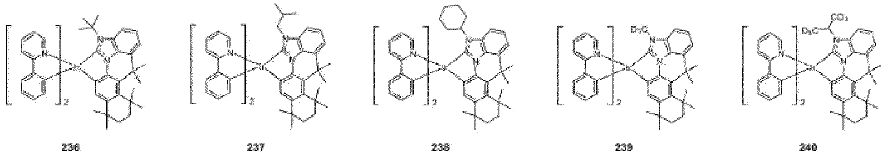

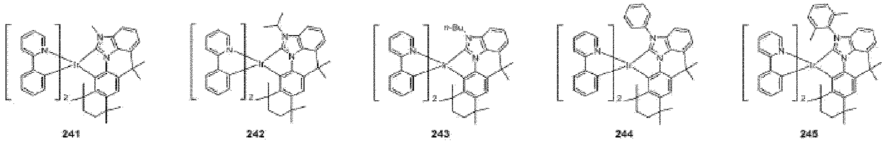

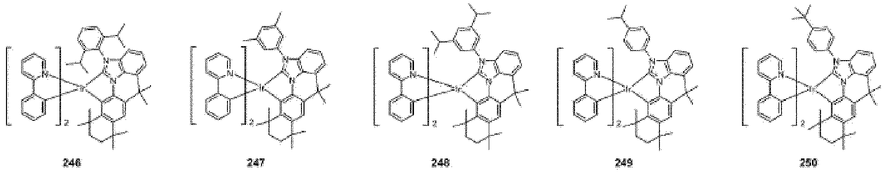

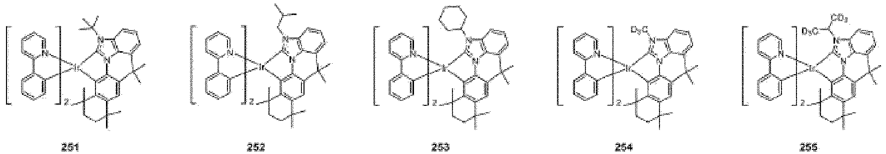

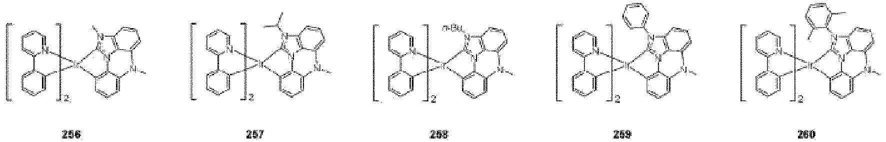

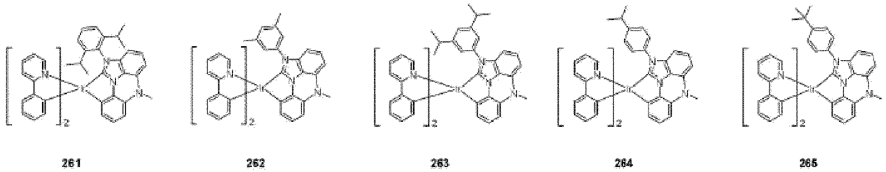

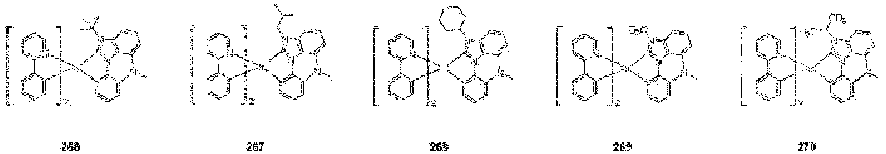

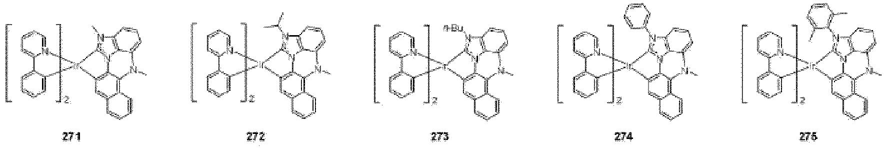

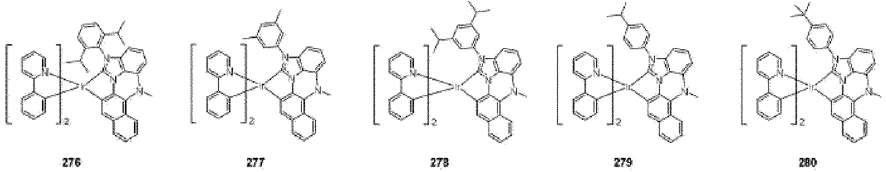

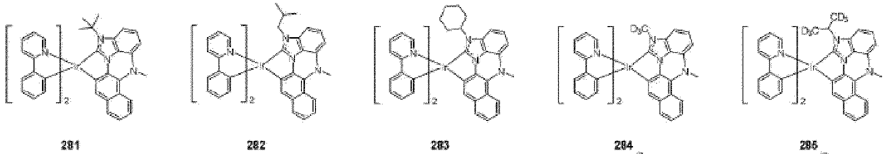

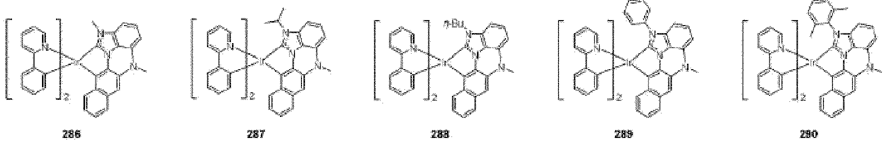

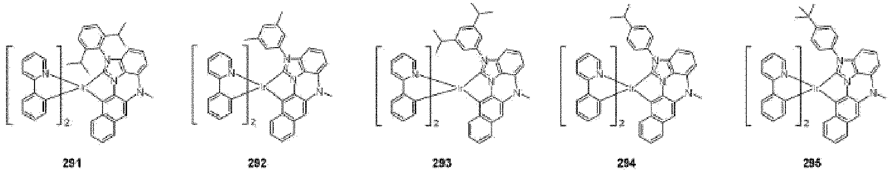

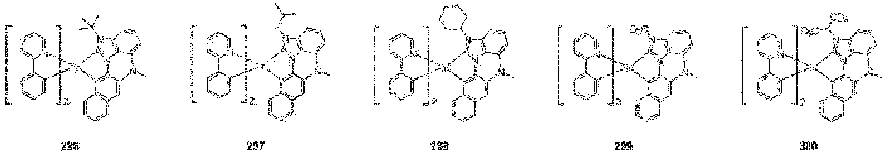

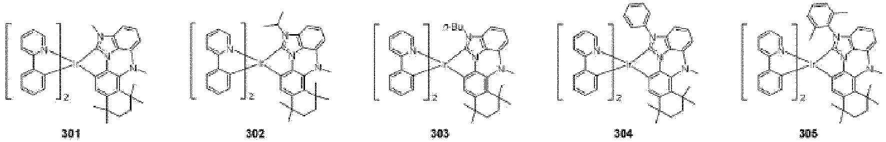

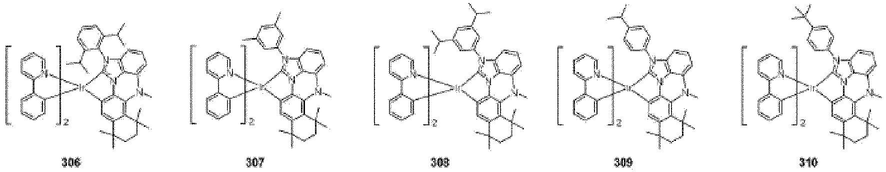

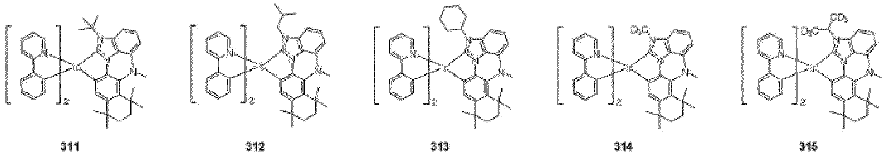

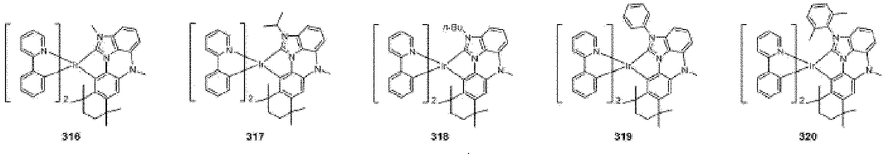

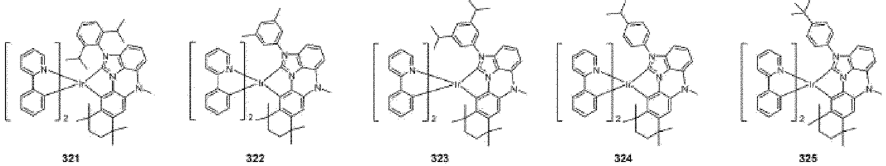

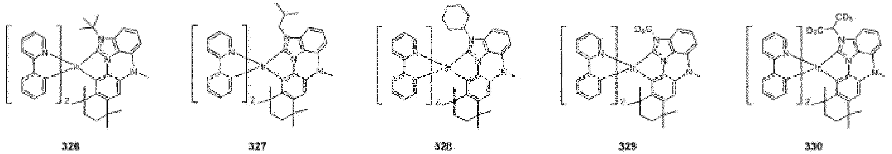

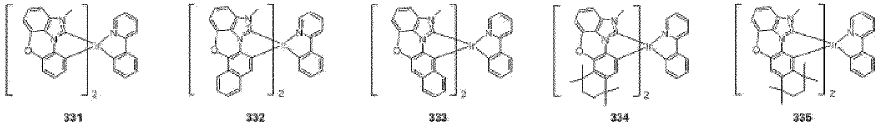

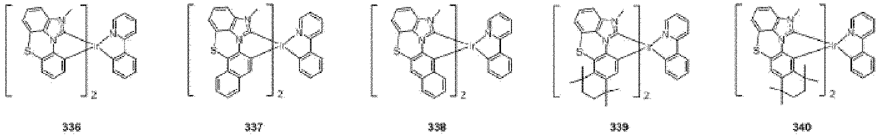

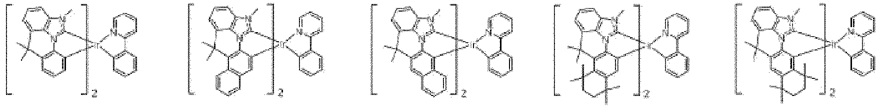

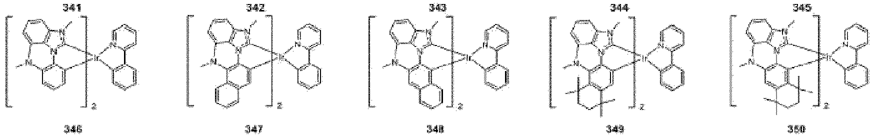

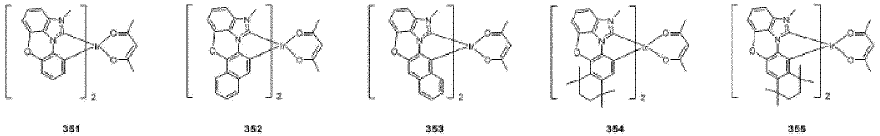

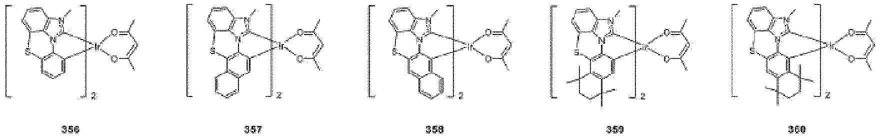

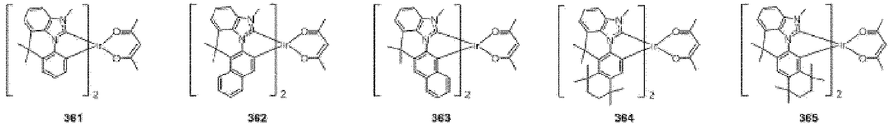

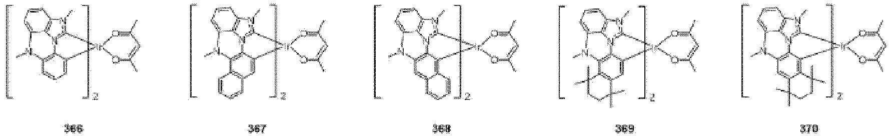

2. Organometallische Verbindung nach Anspruch 1, wobei die durch die chemische Formel 1 dargestellte Verbindung als grünes Phosphoreszenzmaterial verwendet wird.

3. Organische Leuchtdiode, die umfasst:
eine erste Elektrode;
eine zweite Elektrode, die der ersten Elektrode zugewandt ist; und
eine organische Schicht, die zwischen der ersten Elektrode und der zweiten Elektrode angeordnet ist;
wobei die organische Schicht eine Lichtemissionsschicht umfasst,
wobei die Lichtemissionsschicht die organometallische Verbindung nach Anspruch 1 oder 2 enthält.

4. Organische Leuchtdiode nach Anspruch 3, wobei die organometallische Verbindung als Dotierungsmaterial der Lichtemissionsschicht verwendet wird.

5. Organische Leuchtdiode nach Anspruch 3 oder 4, wobei ein Wirtsmaterial der Lichtemissionsschicht eine Verbindung umfasst, die eine Carbazolgruppe enthält.

6. Organische Leuchtdiode nach Anspruch 5, wobei die Verbindung, die die Carbazolgruppe enthält, mindestens eine umfasst, die aus Verbindungen der folgenden Strukturen ausgewählt ist:

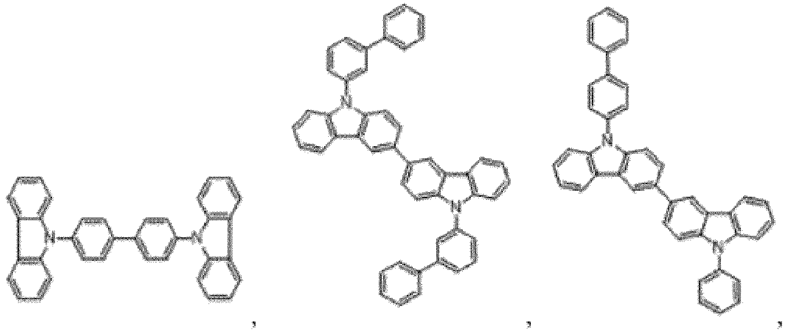

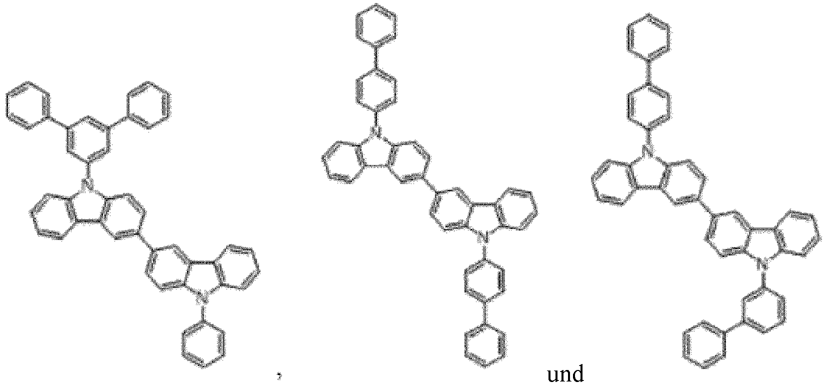

7. Organische Leuchtdiode nach einem der Ansprüche 3 bis 6, wobei die organische Schicht ferner mindestens eine umfasst, die aus einer Gruppe ausgewählt ist, die aus einer Lochinjektionsschicht, einer Lochtransportschicht, einer Elektronentransportschicht und einer Elektroneninjektionsschicht besteht.

8. Organische Lichtemissionsanzeigevorrichtung, die umfasst:
ein Substrat;
ein Ansteuerelement, das auf dem Substrat positioniert ist; und
ein organisches Lichtemissionselement, das auf dem Substrat angeordnet ist und mit dem Ansteuerelement verbunden ist, wobei das organische Lichtemissionselement die organische Leuchtdiode nach einem der Ansprüche 3 bis 7 umfasst.

## Revendications

1. Composé organométallique représenté par une Formule chimique 1 suivante :
[Formule chimique 1] Ir(L_{A})ₘ(L_{B})ₙ
où, dans la Formule chimique 1, L_{A} représente un ligand principal et est un élément choisi parmi un groupe constitué de la Formule chimique 2-1, de la Formule chimique 2-2 et de la Formule chimique 2-3 suivantes,
L_{B} désigne un ligand auxiliaire représenté par une Formule chimique 3 suivante,
chaque élément parmi m et n désigne un nombre des ligands liés à Ir (iridium), et m vaut 1, 2 ou 3, et n vaut 0, 1 ou 2, et une somme de m et n vaut 3, 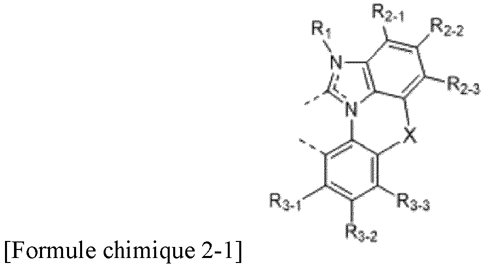 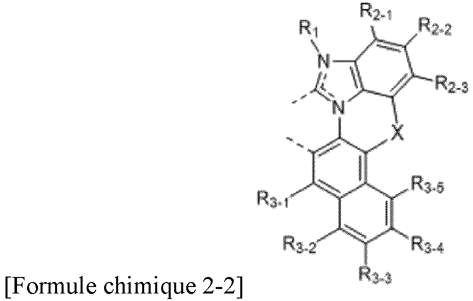 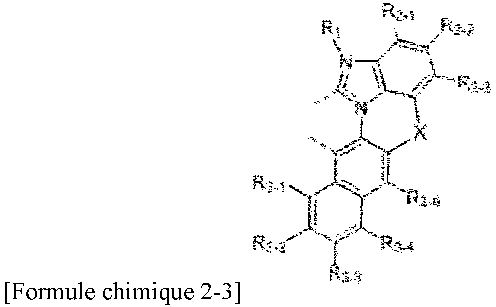 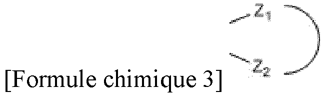
dans lesquelles, dans chacune des Formules chimiques 2-1 à 2-3, X représentent indépendamment un élément choisi parmi un groupe constitué de l'oxygène, du soufre, de C(R)₂ et de NR,
chaque élément parmi R, R₁, R₂₋₁, R₂₋₂, R₂₋₃, R₃₋₁, R₃₋₂, R₃₋₃, R₃₋₄ et R₃₋₅ représente indépendamment un élément choisi parmi un groupe constitué de l'hydrogène, du deutérium, d'un halogénure, d'un alkyle, d'un cycloalkyle, d'un hétéroalkyle, d'un arylalkyle, d'un alcoxy, d'un aryloxy, d'un amino, d'un silyle, d'un alcényle, d'un cycloalcényle, d'un hétéroalcényle, d'un alcynyle, d'un aryle, d'un hétéroaryle, d'un acyle, d'un carbonyle, d'un acide carboxylique, d'un ester, d'un nitrile, d'un isonitrile, d'un sulfanyle, d'un sulfinyle, d'un sulfonyle et d'un phosphino,
dans chacune des Formules chimiques 2-1 à 2-3, deux groupes fonctionnels adjacents l'un à l'autre parmi R₂₋₁, R₂₋₂ et R₂₋₃ peuvent être combinés l'un avec l'autre pour former une structure cyclique, et deux groupes fonctionnels adjacents l'un à l'autre parmi R₃₋₁, R₃₋₂, R₃₋₃, R₃₋₄ et R₃₋₅ peuvent être combinés l'un avec l'autre pour former une structure cyclique,
dans lequel le ligand auxiliaire représenté par la Formule chimique 3 est un ligand bidentate, et le ligand bidentate est représenté par une Formule chimique 4 suivante ou une Formule chimique 5 suivante : 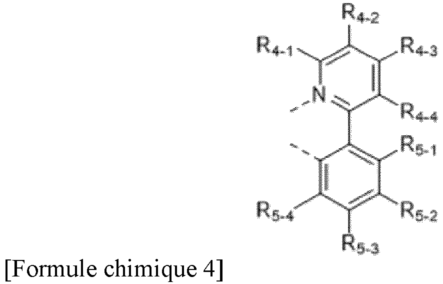 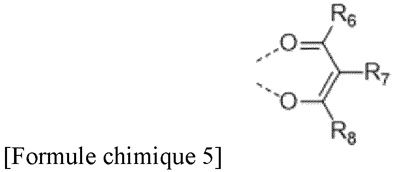
dans lequel, dans la Formule chimique 4, chaque élément parmi R₄₋₁, R₄₋₂, R₄₋₃, R₄₋₄, R₅₋₁, R₅₋₂, R₅₋₃ et R₅₋₄ représente indépendamment un élément choisi parmi un groupe constitué de l'hydrogène, du deutérium, d'un groupe alkyle linéaire en C1 à C5 et d'un groupe alkyle ramifié en C1 à C5, dans lequel le groupe alkyle linéaire en C1 à C5 ou le groupe alkyle ramifié en C1 à C5 peut être substitué par au moins un élément choisi parmi le deutérium et un élément halogène,
deux groupes fonctionnels adjacents l'un à l'autre parmi R₄₋₁, R₄₋₂, R₄₋₃ et R₄₋₄ peuvent être combinés l'un avec l'autre pour former une structure cyclique, et deux groupes fonctionnels adjacents l'un à l'autre parmi R₅₋₁, R₅₋₂, R₅₋₃ et R₅₋₄ peuvent être combinés l'un avec l'autre pour former une structure cyclique,
dans lequel, dans la Formule chimique 5, chaque élément parmi R₆, R₇ et R₈ représente indépendamment un élément choisi parmi un groupe constitué de l'hydrogène, du deutérium, d'un groupe alkyle linéaire en C1 à C5 et d'un groupe alkyle ramifié en C1 à C5, dans lequel le groupe alkyle linéaire en C1 à C5 ou le groupe alkyle ramifié en C1 à C5 peut être substitué par au moins un élément choisi parmi le deutérium et un élément halogène,
deux groupes fonctionnels adjacents l'un à l'autre parmi R₆, R₇ et R₈ peuvent être combinés l'un avec l'autre pour former une structure cyclique,
dans lequel le composé représenté par la Formule chimique 1 inclut un élément choisi parmi un groupe constitué des composés 1 à 370 suivants :

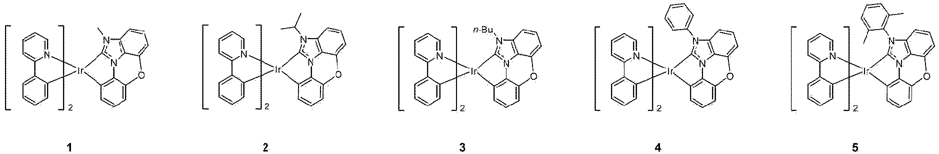

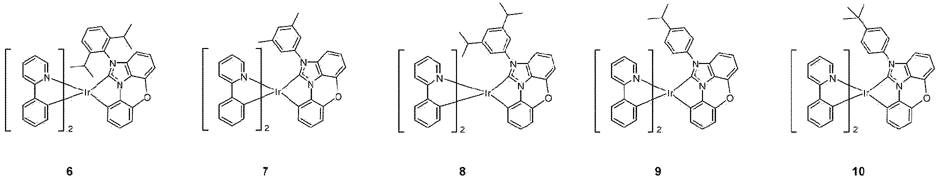

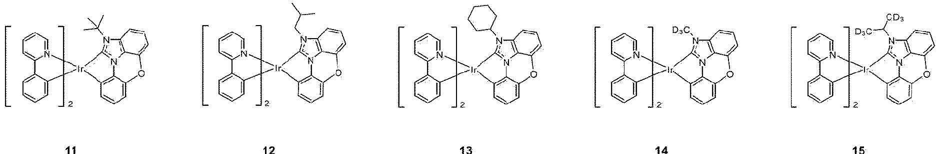

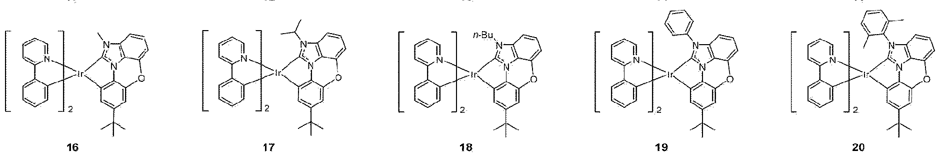

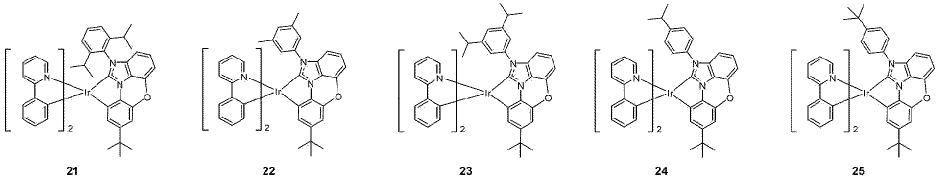

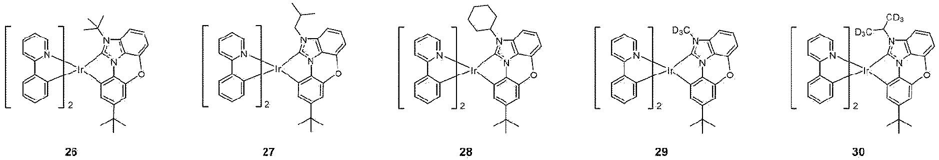

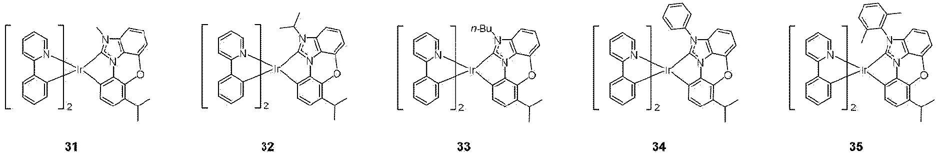

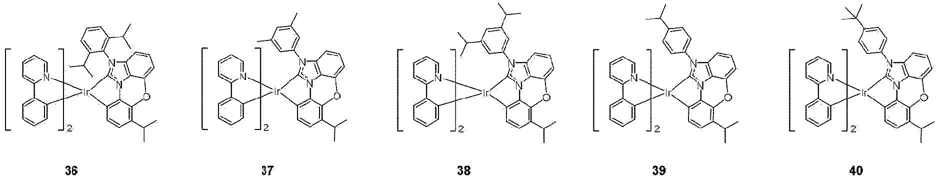

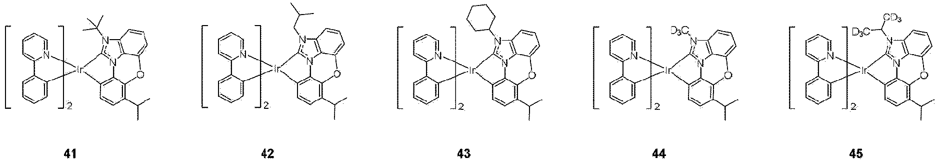

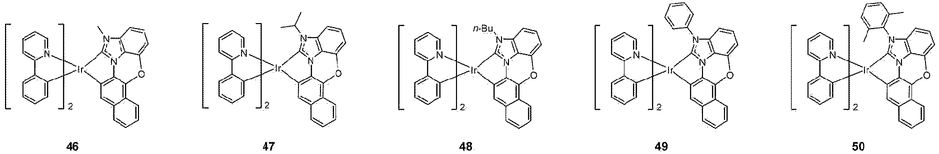

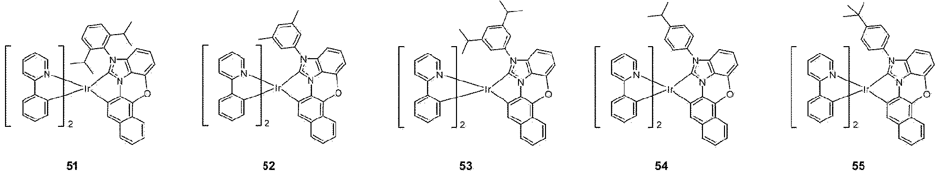

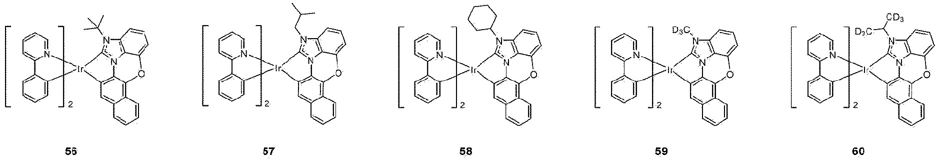

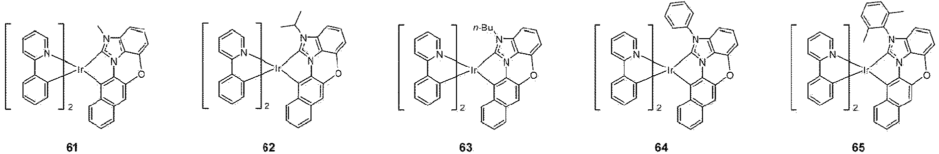

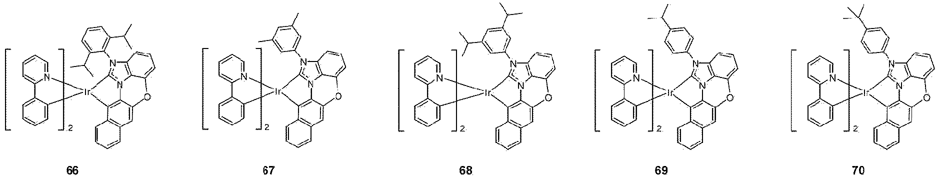

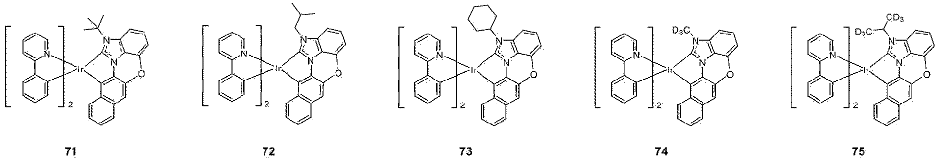

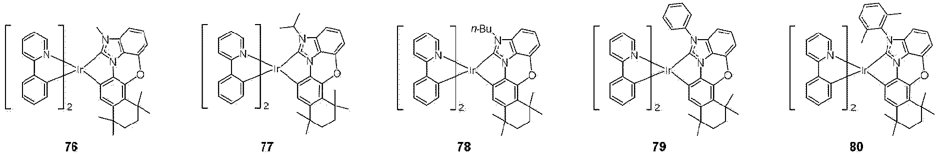

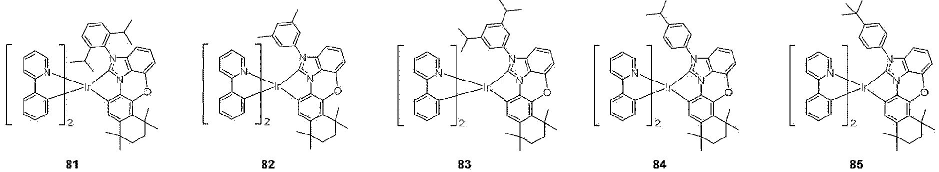

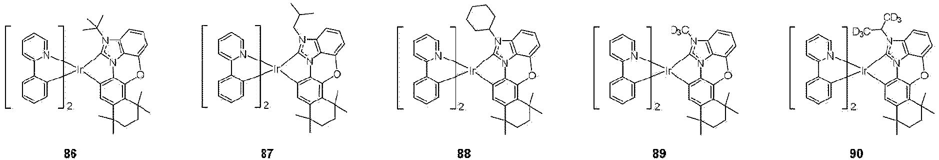

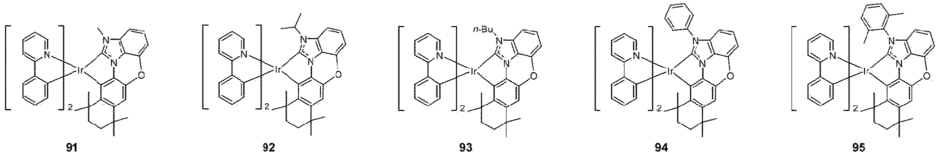

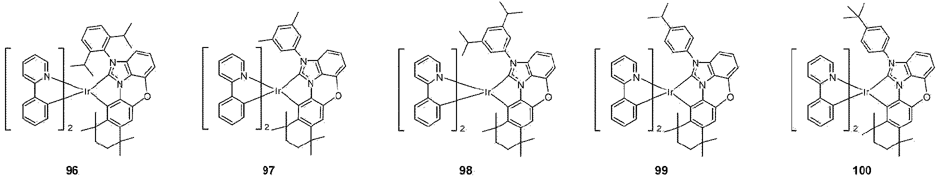

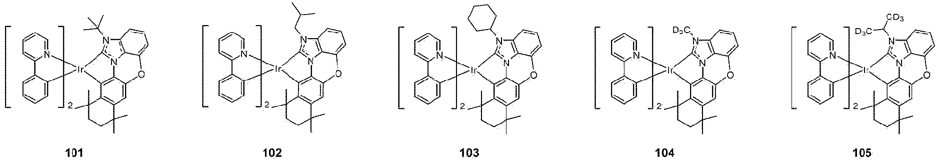

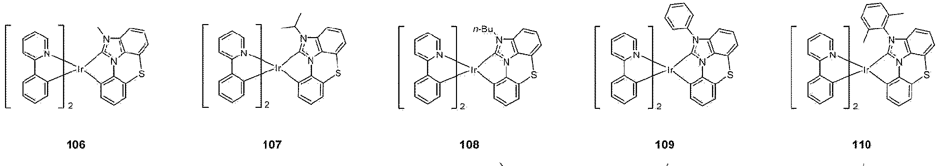

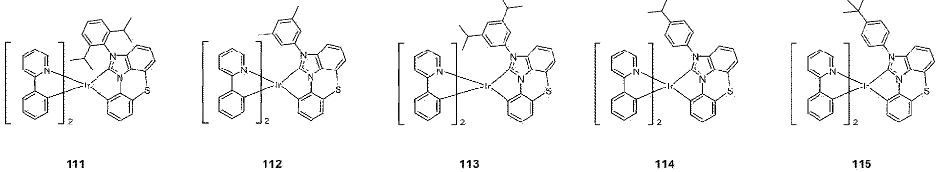

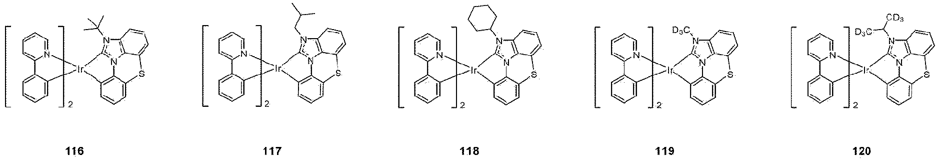

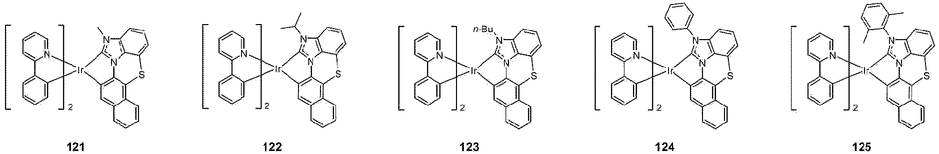

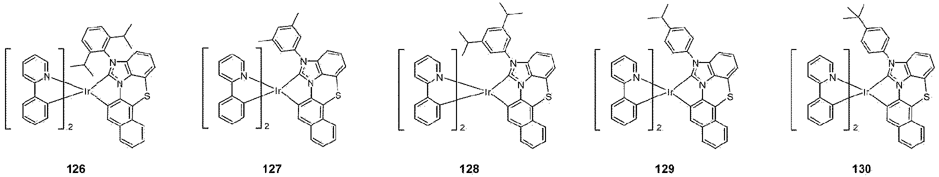

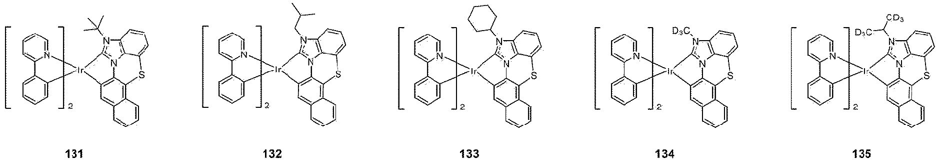

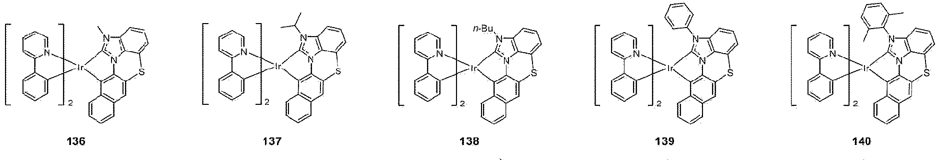

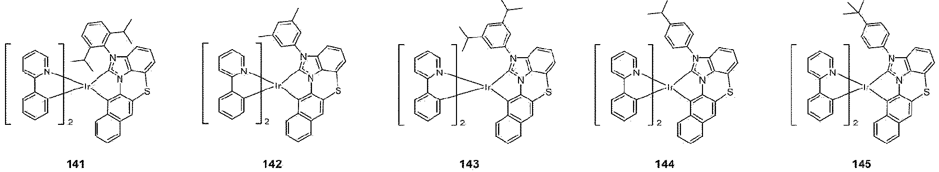

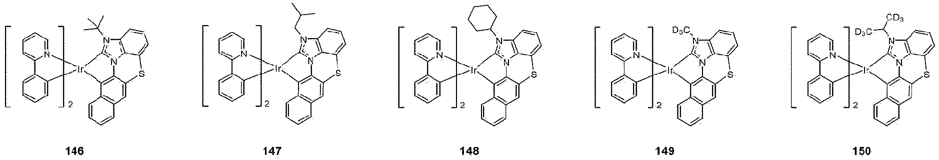

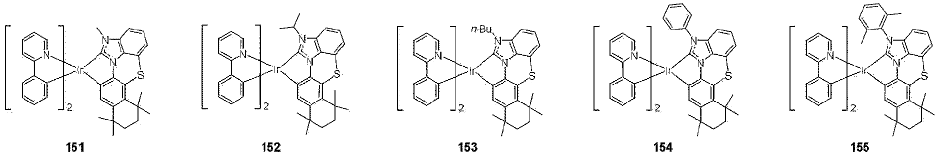

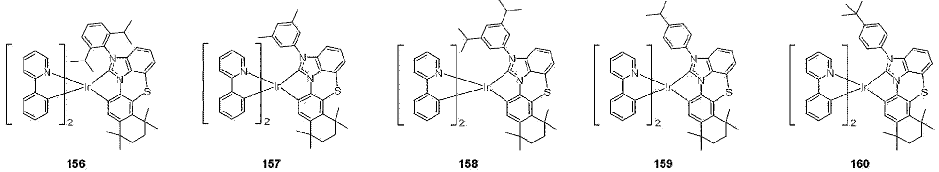

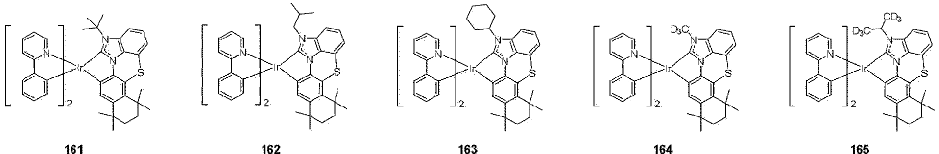

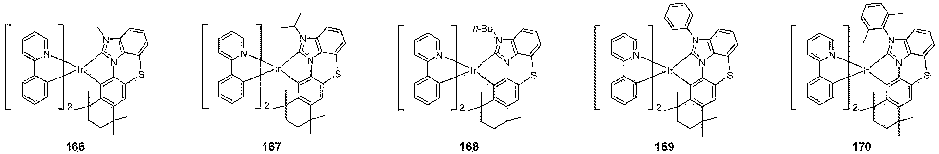

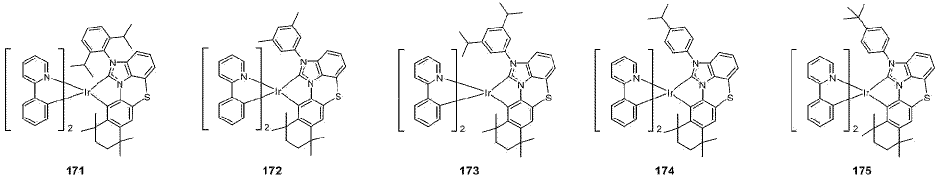

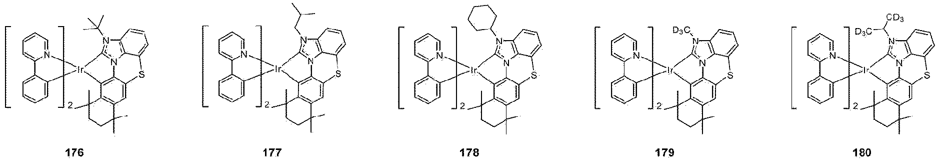

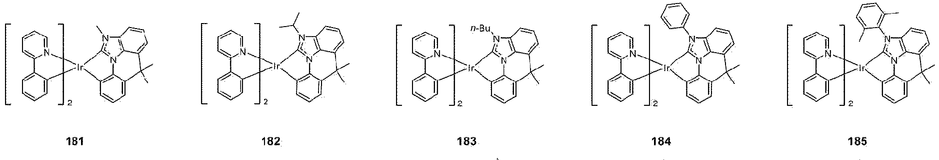

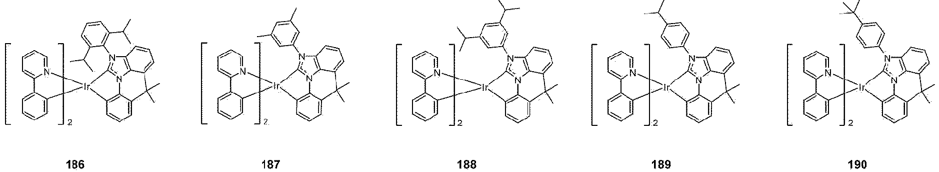

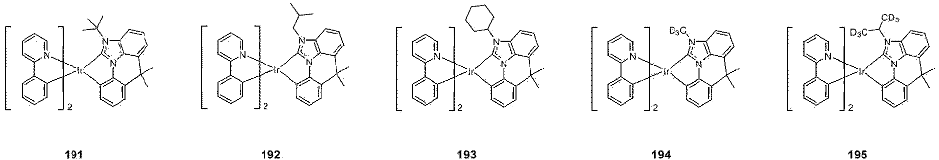

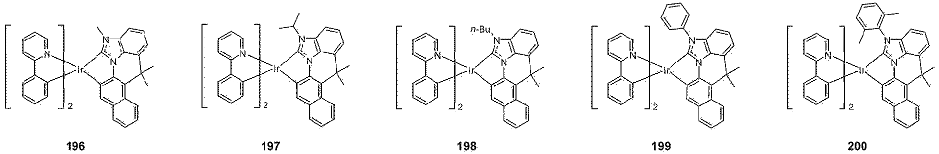

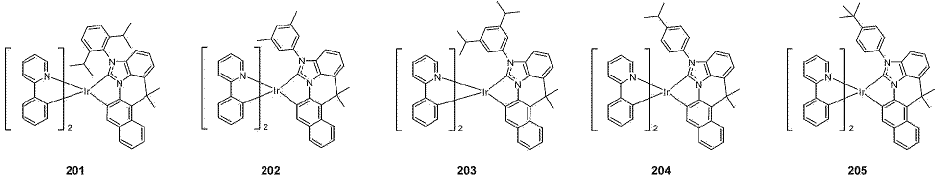

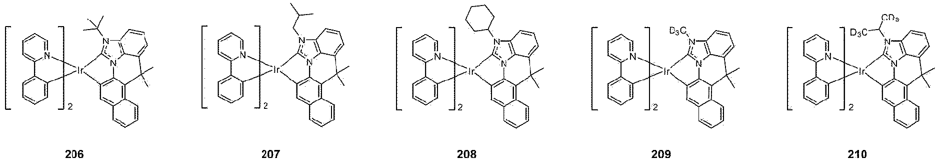

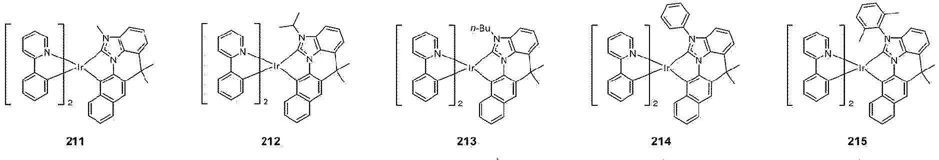

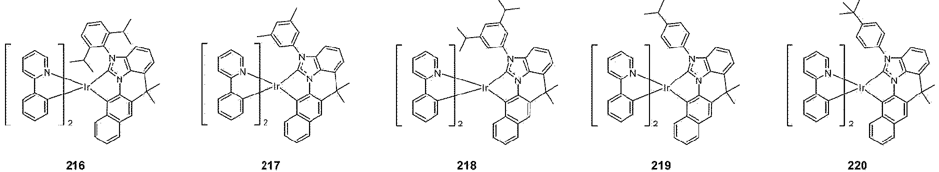

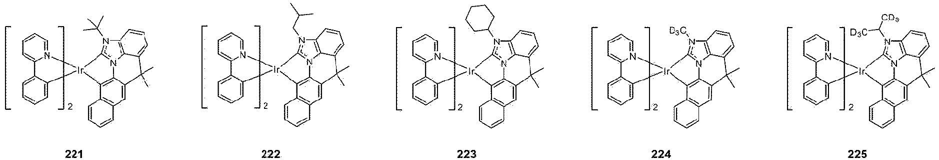

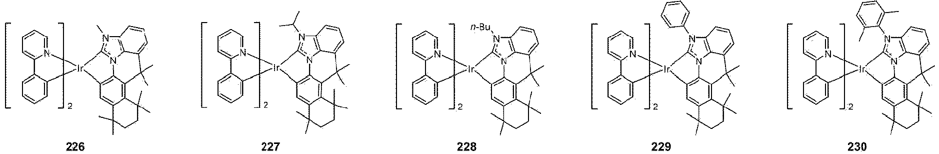

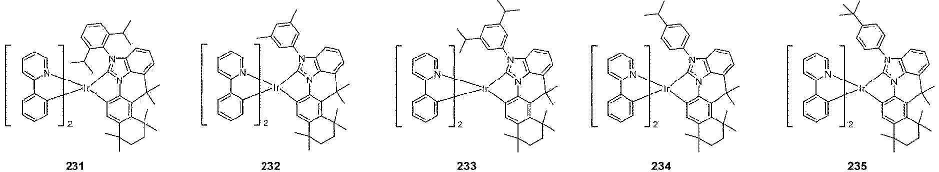

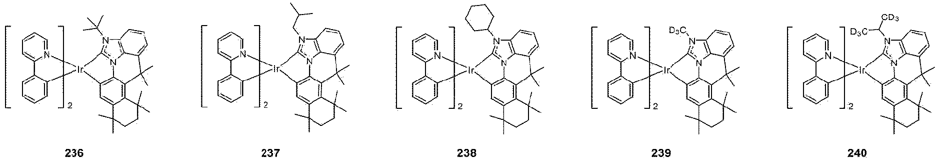

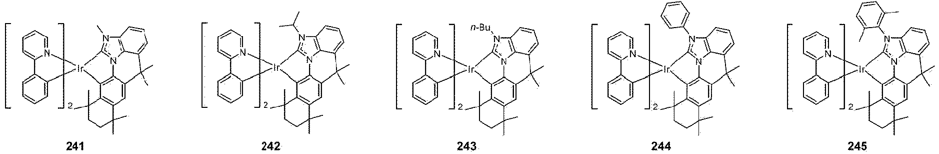

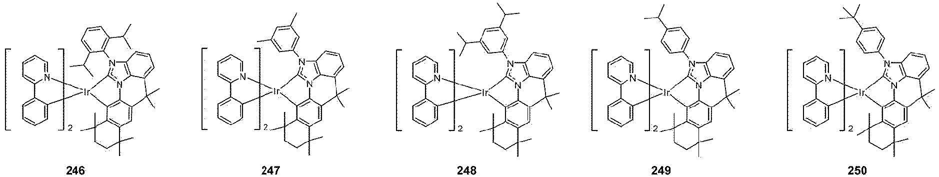

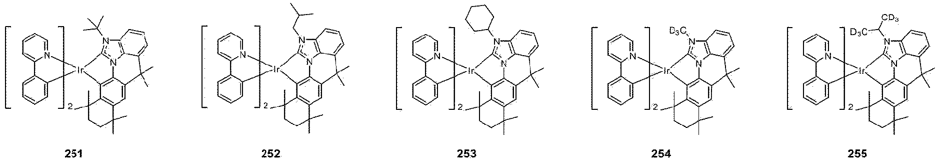

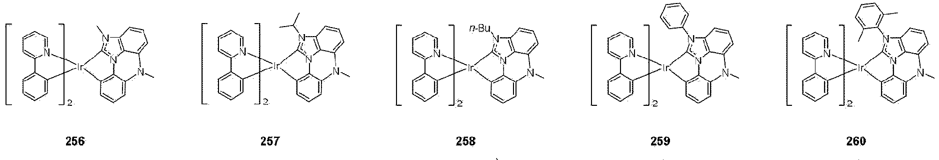

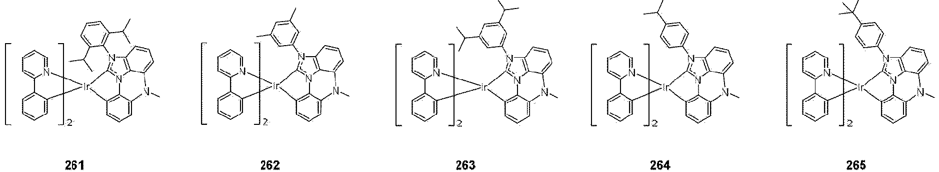

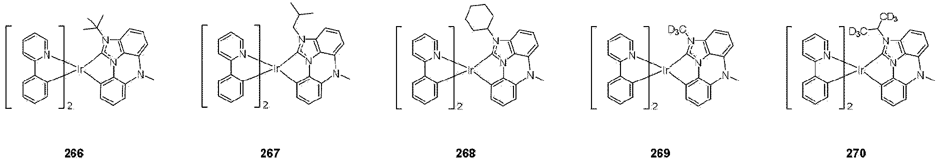

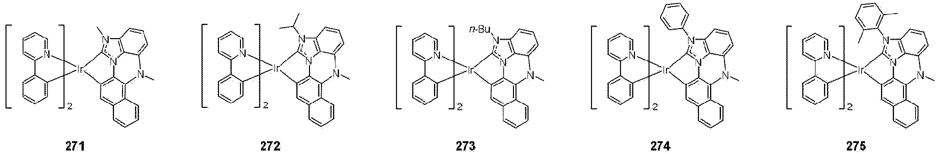

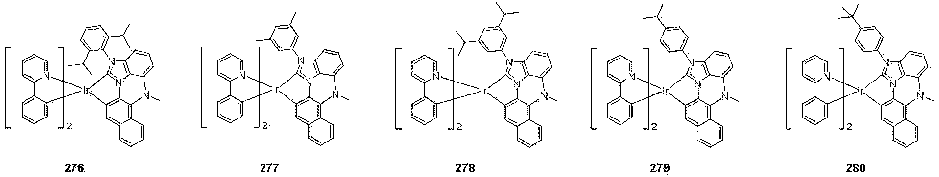

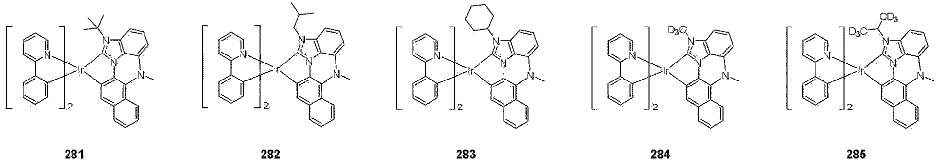

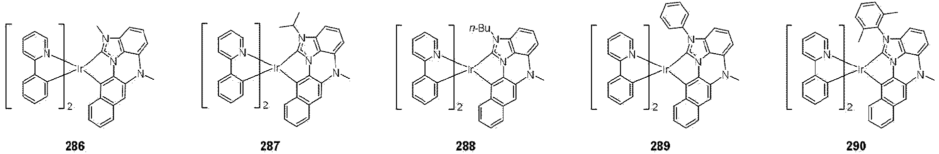

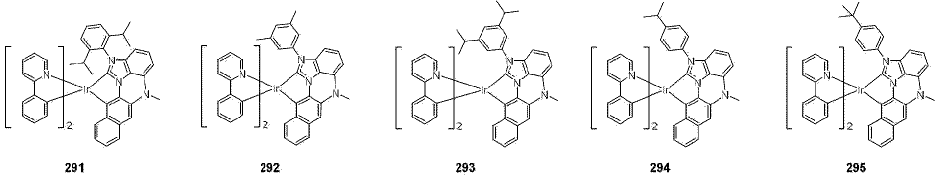

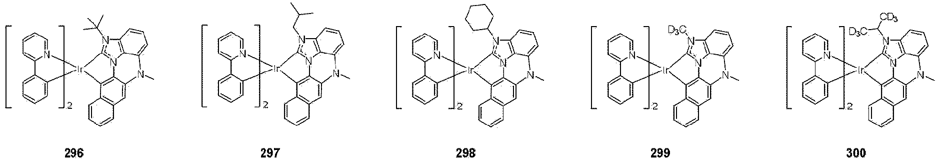

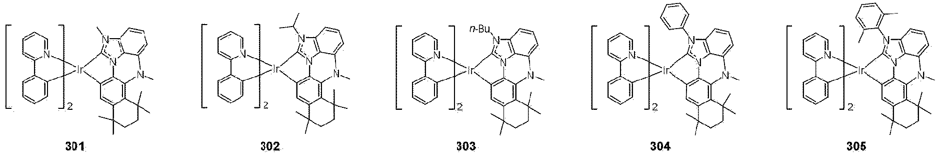

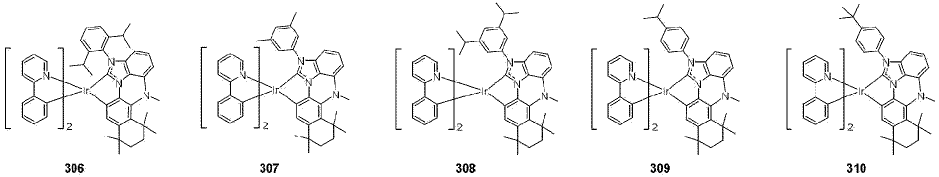

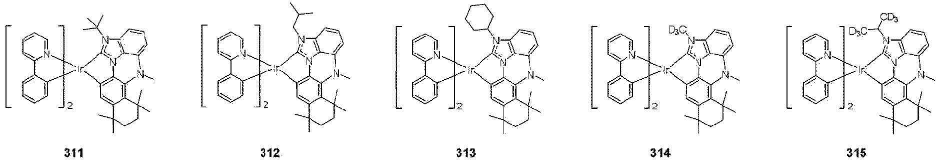

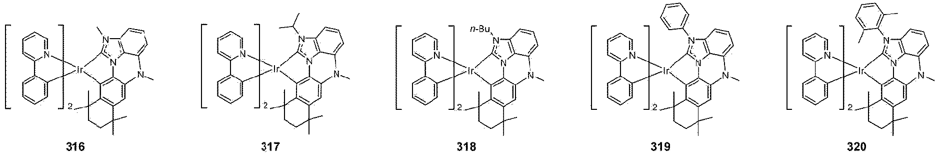

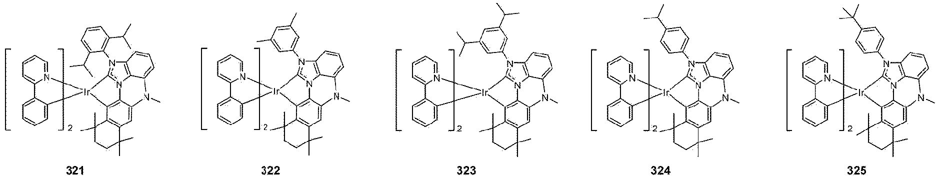

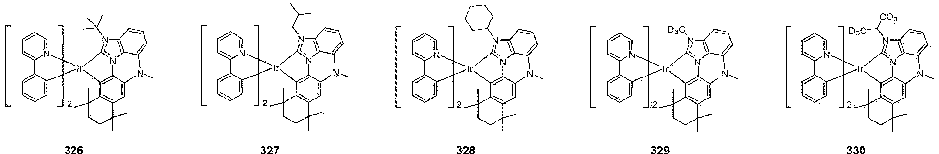

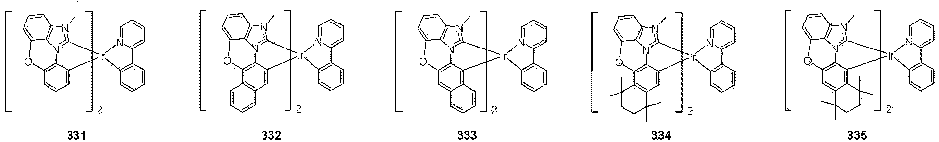

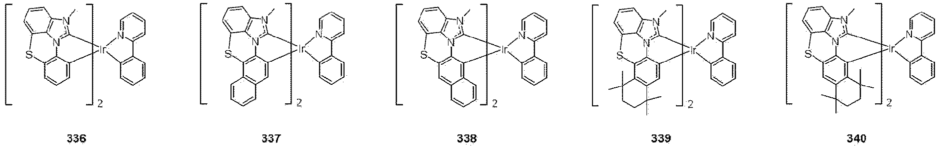

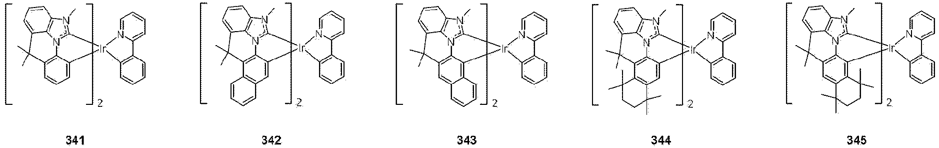

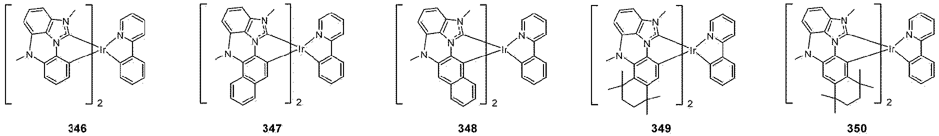

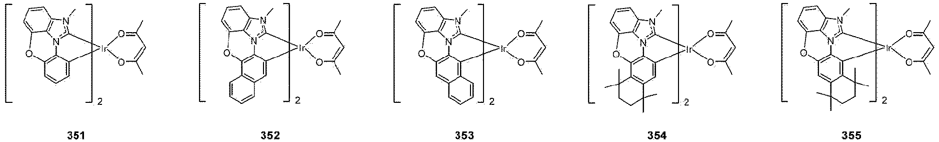

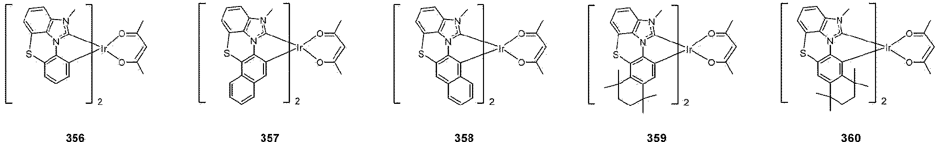

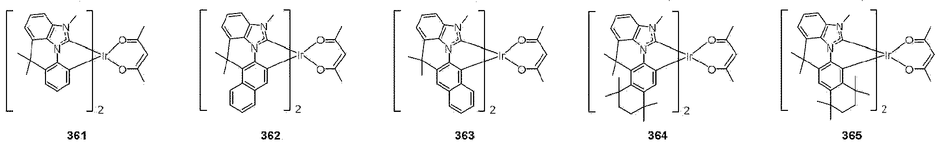

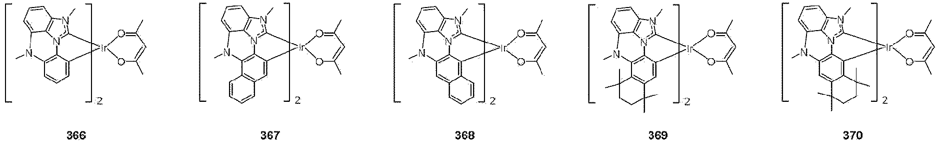

2. Composé organométallique selon la revendication 1, dans lequel le composé représenté par la Formule chimique 1 est utilisé comme un matériau phosphorescent vert.

3. Diode électroluminescente organique comportant :
une première électrode ;
une seconde électrode faisant face à la première électrode ; et
une couche organique disposée entre la première électrode et la seconde électrode ;
dans laquelle la couche organique inclut une couche électroluminescente,
dans laquelle la couche électroluminescente contient le composé organométallique selon la revendication 1 ou 2.

4. Diode électroluminescente organique selon la revendication 3, dans laquelle le composé organométallique est utilisé comme dopant de la couche électroluminescente.

5. Diode électroluminescente organique selon la revendication 3 ou 4, dans laquelle un matériau hôte de la couche électroluminescente inclut un composé contenant un groupe carbazole.

6. Diode électroluminescente organique selon la revendication 5, dans laquelle le composé contenant le groupe carbazole inclut au moins un élément choisi parmi des composés ayant les structures suivantes:

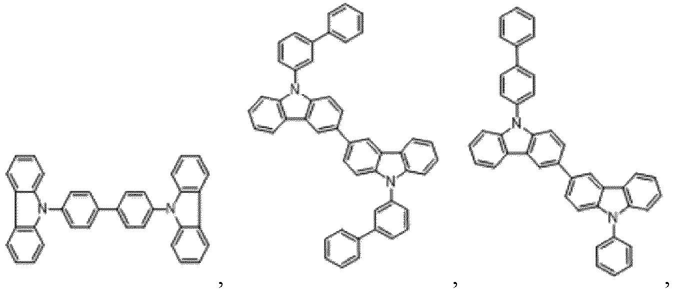

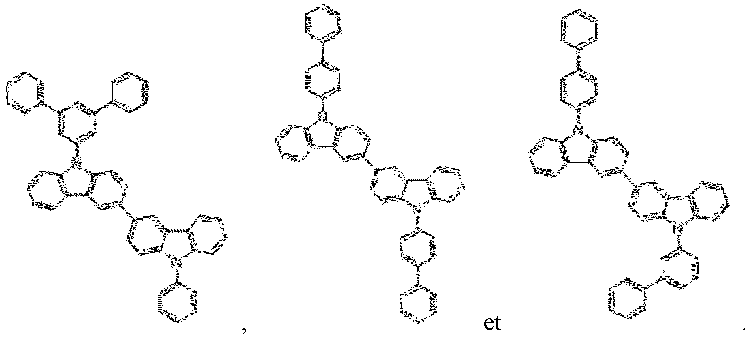

7. Diode électroluminescente organique selon l'une quelconque des revendications 3 à 6, dans laquelle la couche organique inclut en outre au moins un élément choisi parmi un groupe constitué d'une couche d'injection de trous, d'une couche de transport de trous, d'une couche de transport d'électrons et d'une couche d'injection d'électrons.

8. Dispositif d'affichage électroluminescent organique comportant :
un substrat ;
un élément d'attaque positionné sur le substrat ; et
un élément électroluminescent organique disposé sur le substrat et connecté à l'élément d'attaque, dans lequel l'élément électroluminescent organique inclut la diode électroluminescente organique selon l'une quelconque des revendications 3 à 7.
